(19) Europäisches Patentamt
European Patent Office
Office européen des brevets

(11) EP 4 742 868 A1

(12) EUROPEAN PATENT APPLICATION
published in accordance with Art. 153(4) EPC

(43) Date of publication:
13.05.2026 Bulletin 2026/20

(51) International Patent Classification (IPC):
H10K 59/12 (2023.01)

(21) Application number: 24948945.1

(22) Date of filing: 25.09.2024

(86) International application number:
PCT/CN2024/120943

(87) International publication number:
WO 2026/051131 (12.03.2026 Gazette 2026/11)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 09.09.2024 CN 202411259179

(71) Applicants:
• Wuhan Tianma Microelectronics Co., Ltd.
Wuhan, Hubei 430205 (CN)
• Xiamen Tianma Display Technology Co., Ltd.
Xiamen, Fujian 361101 (CN)

(72) Inventors:
• DAI, Hao
Wuhan, Hubei 430205 (CN)
• MA, Yangzhao
Wuhan, Hubei 430205 (CN)
• ZHANG, Dian
Wuhan, Hubei 430205 (CN)
• DUN, Dongliang
Wuhan, Hubei 430205 (CN)
• LIN, Yuancheng
Wuhan, Hubei 430205 (CN)
• HUA, Huomei
Wuhan, Hubei 430205 (CN)

(74) Representative: Germain Maureau
12, rue Boileau
69006 Lyon (FR)

(54) DISPLAY PANEL AND DISPLAY APPARATUS

(57) Embodiments of the present disclosure provides a display panel and a display device, the display panel comprising a first type of pixel and a second type of pixel, The first type of pixel comprises a first sub-pixel of a first color, and the second type of pixel comprises a second sub-pixel of the first color. The display panel further comprises a base plate, a device layer, and a light modulation layer. The device layer is disposed on a side of the substrate, and the light modulation layer is located on a side of the device layer away from the substrate. The light modulation layer comprises a plurality of light modulation portions. The first sub-pixel has a first orthographic projection on the base plate, and the second sub-pixel has a second orthographic projection on the base plate. The orthographic projection of the light modulation portion on the base plate at least partially overlaps with the first orthographic projection. A ratio of a perimeter to an area corresponding to the first orthographic projection is greater than a ratio of a perimeter to an area corresponding to the second orthographic projection. In the embodiments of the present disclosure, the anti-peeping effect corresponding to the first sub-pixel can be improved.

Fig. 3

# Description

## CROSS-REFERENCE TO RELATED APPLICATION

The present application claims priority to Chinese Patent Application No. 202411259179.2 filed on September 9, 2024, and titled "DISPLAY PANEL AND DISPLAY DEVICE", which is incorporated herein by reference in its entirety.

## TECHNICAL FIELD

The present disclosure relates to the technical field of display technology, and in particular to a display panel and a display device.

## BACKGROUND

In order to improve the display effect of the display panel, in the related art, there is a situation where sub-pixels of different colors receive data signals transmitted via a same data signal line. In such configuration, the power consumption of the display panel is increased.

## SUMMARY

The present disclosure provides a display panel and a display device, so as to reduce the power consumption of the display panel while ensuring the display effect.

According to an aspect of the present disclosure, a display panel is provided, comprising a display region, the display region comprises a plurality of pixel circuits arranged in an array, the plurality of pixel circuits comprising a first pixel circuit, a second pixel circuit and a third pixel circuit.

The first pixel circuit, the second pixel circuit and the third pixel circuit are respectively connected to light-emitting elements of different colors.

The display panel further comprises a plurality of data signal lines, the plurality of data signal lines comprises a first data signal line, a second data signal line and a third data signal line.

The first data signal line is electrically connected to the first pixel circuit, the second data signal line is electrically connected to the second pixel circuit, and the third data signal line is electrically connected to the third pixel circuit.

According to another aspect of the present disclosure, a display device is provided, comprising the display panel according to the first aspect.

In the display panel and the display device provided by embodiments of the present disclosure, one data signal line is connected only to sub-pixels emitting light of a same color, so that one data signal line only need to transmit a data signal corresponding to the sub-pixels of one color, thereby reducing the switch frequency and switch amplitude of the data signal on a single data signal line, and reducing the power consumption of the integrated circuit (IC) providing the data signal, which is beneficial to reducing the overall power consumption of the display panel.

It should be understood that the contents described here are not intended to identify the key or important features of the embodiments of the present disclosure, nor are they intended to limit the scope of the present disclosure. Other features of the present disclosure will become easily understood through the following description.

## BRIEF DESCRIPTION OF THE DRAWINGS

In order to more clearly illustrate the technical solutions in the embodiments of the present disclosure, the drawings required for use in the description of the embodiments will be briefly introduced below. Obviously, the drawings described below are only some embodiments of the present disclosure. For those skilled in the art, other drawings can be obtained based on these drawings without creative work.

Fig. 1 is a schematic structural diagram of a display panel in the related art;
Fig. 2 is a timing diagram of a data signal on a data signal line in the display panel shown in Fig. 1;
Fig. 3 is a schematic structural diagram of a display panel provided by an embodiment of the present disclosure;
Fig. 4 is a schematic structural diagram of a pixel circuit provided by an embodiment of the present disclosure;
Fig. 5 is a cross-sectional diagram of a sub-pixel provided by an embodiment of the present disclosure;
Fig. 6 is a timing diagram of a data signal on a data signal line provided by an embodiment of the present disclosure;
Fig. 7 is a schematic structural diagram of a display panel provided by another embodiment of the present disclosure;
Fig. 8 is a schematic structural diagram of a display panel provided by yet another embodiment of the present disclosure;

Fig. 9 is a schematic structural diagram of a display panel provided by yet another embodiment of the present disclosure;

Fig. 10 is a partial cross-sectional diagram of a display panel provided in an embodiment of the present disclosure;

Fig. 11 is a schematic structural diagram of a display panel provided by another embodiment of the present disclosure;

Fig. 12 is a schematic structural diagram of a display panel provided by yet another embodiment of the present disclosure;

Fig. 13 is a partial cross-sectional diagram of a display panel provided by yet another embodiment of the present disclosure;

Fig. 14 is a partial cross-sectional diagram of a display panel provided by yet another embodiment of the present disclosure;

Fig. 15 is a schematic structural diagram of a display panel provided by yet another embodiment of the present disclosure;

Fig. 16 is a schematic structural diagram of a display panel provided by yet another embodiment of the present disclosure;

Fig. 17 is a schematic structural diagram of a display panel provided by yet another embodiment of the present disclosure;

Fig. 18 is a schematic structural diagram of a display panel provided by yet another embodiment of the present disclosure;

Fig. 19 is a schematic structural diagram of a display panel provided by yet another embodiment of the present disclosure;

Fig. 20 is a schematic structural diagram of a display panel provided by yet another embodiment of the present disclosure;

Fig. 21 is a schematic structural diagram of a display panel provided by yet another embodiment of the present disclosure;

Fig. 22 is a schematic structural diagram of a display panel provided by yet another embodiment of the present disclosure;

Fig. 23 is a timing diagram of signals provided to the pixel circuit shown in Fig. 4 within a driving cycle provided by an embodiment of the present disclosure;

Fig. 24 is a schematic structural diagram of film layers of a display panel provided in an embodiment of the present disclosure;

Fig. 25 is a schematic structural diagram of a first semiconductor layer in the display panel shown in Fig. 24;

Fig. 26 is a schematic structural diagram of a first metal layer in the display panel shown in Fig. 24;

Fig. 27 is a schematic structural diagram of a second metal layer in the display panel shown in Fig. 24;

Fig. 28 is a schematic structural diagram of a second semiconductor layer in the display panel shown in Fig. 24;

Fig. 29 is a schematic structural diagram of a third metal layer in the display panel shown in Fig. 24;

Fig. 30 is a schematic structural diagram of a fourth metal layer in the display panel shown in Fig. 24;

Fig. 31 is a schematic structural diagram of a fifth metal layer in the display panel shown in Fig. 24;

Fig. 32 is a schematic structural diagram of a sixth metal layer in the display panel shown in Fig. 24;

Fig. 33 is a schematic structural diagram of an anode layer in the display panel shown in Fig. 24;

Fig. 34 is a schematic diagram of a stacked structure of part of film layers in the display panel shown in Fig. 24;

Fig. 35 is a schematic diagram of a stacked structure of all film layers in the display panel shown in Fig. 24;

Fig. 36 is a schematic structural diagram of film layers of a pixel circuit in the display panel shown in Fig. 24;

Fig. 37 is a schematic structural diagram of part of film layers of a pixel circuit in the display panel shown in Fig. 24;

Fig. 38 is a schematic structural diagram of a display panel provided by yet another embodiment of the present disclosure;

Fig. 39 is a schematic structural diagram of a display panel provided by yet another embodiment of the present disclosure;

Fig. 40 is a schematic structural diagram of a display panel provided by yet another embodiment of the present disclosure;

Fig. 41 is a schematic structural diagram of a display panel provided by yet another embodiment of the present disclosure;

Fig. 42 is a schematic structural diagram of a display panel provided by yet another embodiment of the present disclosure;

Fig. 43 is a schematic structural diagram of a display panel provided by yet another embodiment of the present disclosure;

Fig. 44 is a schematic structural diagram of a display panel provided by yet another embodiment of the present disclosure;

Fig. 45 is another schematic diagram of a stacked structure of part of film layers in the display panel shown in Fig. 24;

Fig. 46 is a schematic structural diagram of a display panel provided by yet another embodiment of the present disclosure;

Fig. 47 is a schematic structural diagram of a display panel provided by yet another embodiment of the present disclosure;

Fig. 48 is a partial cross-sectional diagram of a display panel provided by yet another embodiment of the present disclosure;

Fig. 49 is a partial cross-sectional diagram of a display panel provided by yet another embodiment of the present disclosure;

Fig. 50 is a schematic structural diagram of a display panel provided by yet another embodiment of the present disclosure;

Fig. 51 is a schematic structural diagram of a display panel provided by yet another embodiment of the present disclosure;

Fig. 52 is a schematic structural diagram of a display panel provided by yet another embodiment of the present disclosure;

Fig. 53 is a schematic structural diagram of a display panel provided by yet another embodiment of the present disclosure;

Fig. 54 is a schematic structural diagram of a display panel provided by yet another embodiment of the present disclosure;

Fig. 55 is a schematic structural diagram of a display panel provided by yet another embodiment of the present disclosure;

Fig. 56 is a partial cross-sectional diagram of a display panel provided by yet another embodiment of the present disclosure;

Fig. 57 is a schematic structural diagram of a display panel provided by yet another embodiment of the present disclosure;

Fig. 58 is a schematic structural diagram of a display panel provided by yet another embodiment of the present disclosure;

Fig. 59 is a schematic structural diagram of a pixel circuit provided by another embodiment of the present disclosure;

Fig. 60 is a timing diagram of signals provided to the pixel circuit shown in Fig. 59 within a driving cycle provided by an embodiment of the present disclosure;

Fig. 61 is a schematic structural diagram of film layers of a display panel provided in another embodiment of the present disclosure;

Fig. 62 is a schematic structural diagram of a first semiconductor layer in the display panel shown in Fig. 61;

Fig. 63 is a schematic structural diagram of a first metal layer in the display panel shown in Fig. 61;

Fig. 64 is a schematic structural diagram of a second metal layer in the display panel shown in Fig. 61;

Fig. 65 is a schematic structural diagram of a fourth metal layer in the display panel shown in Fig. 61;

Fig. 66 is a schematic structural diagram of a fifth metal layer in the display panel shown in Fig. 61;

Fig. 67 is a schematic structural diagram of a sixth metal layer in the display panel shown in Fig. 61;

Fig. 68 is a schematic structural diagram of an anode layer in the display panel shown in Fig. 61;

Fig. 69 is a schematic diagram of a stacked structure of all film layers in the display panel shown in Fig. 61;

Fig. 70 is a schematic structural diagram of film layers of a pixel circuit in the display panel shown in Fig. 61;

Fig. 71 is a schematic structural diagram of part of film layers in a pixel circuit in the display panel shown in Fig. 61;

Fig. 72 is a schematic structural diagram of film layers of a pixel circuit provided by an embodiment of the present disclosure;

Fig. 73 is a schematic structural diagram of film layers of a pixel circuit provided by another embodiment of the present disclosure;

Fig. 74 is a schematic structural diagram of a display panel provided by yet another embodiment of the present disclosure;

Fig. 75 is a schematic structural diagram of a display panel provided by yet another embodiment of the present disclosure;

Fig. 76 is a schematic structural diagram of film layers of a pixel circuit provided by another embodiment of the present disclosure;

Fig. 77 is a schematic structural diagram of a display panel provided by yet another embodiment of the present disclosure;

Fig. 78 is a schematic structural diagram of film layers of a pixel circuit provided by another embodiment of the present disclosure;

Fig. 79 is a schematic diagram of a stacked structure of part of film layers in the display panel shown in Fig. 24;

Fig. 80 is a schematic diagram of a stacked structure of part of film layers in the display panel shown in Fig. 61;

Fig. 81 is a schematic diagram of an overlapping relationship between a third power signal line and a green light-emitting element provided in an embodiment of the present disclosure;

Fig. 82 is a schematic diagram of an overlapping relationship between a first power signal line and a green light-emitting element provided in an embodiment of the present disclosure;

Fig. 83 is a schematic diagram of an overlapping relationship between a first power signal line and a green light-emitting element provided in another embodiment of the present disclosure; and

Fig. 84 is a schematic structural diagram of a display device provided in an embodiment of the present disclosure.

## DETAILED DESCRIPTION

In order to enable those skilled in the art to better understand the scheme of the present disclosure, the technical scheme in the embodiments of the present disclosure will be clearly and completely described below in conjunction with the drawings in the embodiments of the present disclosure. Obviously, the described embodiments are only a part of embodiments of the present disclosure, not all embodiments. Based on the embodiments of the present disclosure, all other embodiments obtained by ordinary skilled in the art without creative work should fall within the scope of protection of the present disclosure.

It should be noted that the terms "first", "second", etc. in the specification and claims of the present disclosure and the above-mentioned drawings are used to distinguish similar objects, and are not necessarily used to describe a specific order or sequence. It should be understood that the data used in this way can be interchanged where appropriate, so that the embodiments of the present disclosure described herein can be implemented in an order other than those illustrated or described herein. In addition, the terms "comprising" and "having" and any variations thereof are intended to cover non-exclusive inclusions, for example, a process, method, system, product or device that comprises a series of steps or units is not necessarily limited to those steps or units that are clearly listed, but may comprise other steps or units that are not clearly listed or inherent to these processes, methods, products or devices.

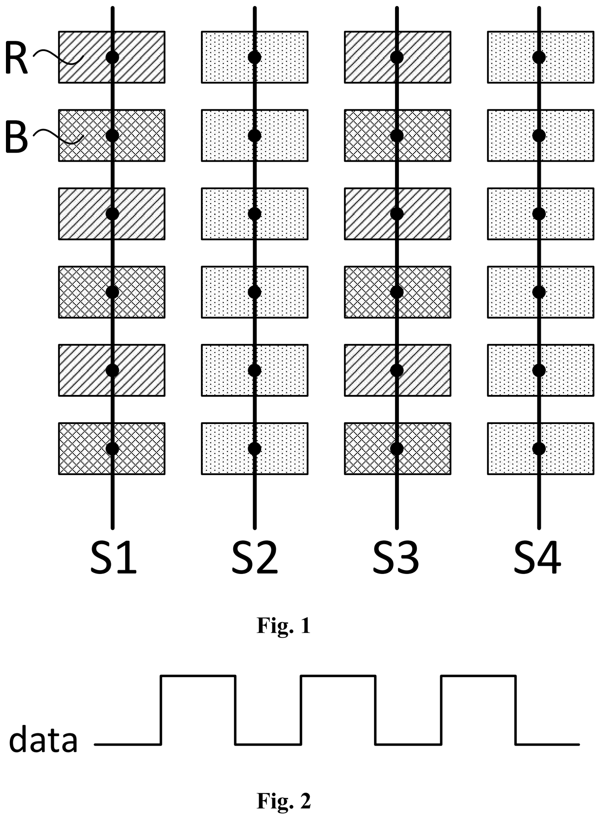

Fig. 1 is a schematic structural diagram of a display panel in the related art provided by an embodiment of the present disclosure, and Fig. 2 is a data signal timing diagram of a data signal line in the display panel shown in Fig. 1. As shown in Figs. 1 and 2, in order to improve the display effect of the display panel, there is a situation where sub-pixels of different colors are located in a same pixel column. In the related technology, sub-pixels of different colors in one column will be connected to a same data signal line and receive data signals transmitted by the same data signal line, so that there is a situation where sub-pixels of different colors share the same data signal line.

Exemplarily, as shown in Fig. 1, four columns of sub-pixels are respectively connected to four data signal lines, which are S1, S2, S3 and S4, respectively. Among them, the first and third columns of sub-pixels comprise red sub-pixels R and blue sub-pixels B, thus the red sub-pixels R and blue sub-pixels B in the first and third columns of sub-pixel columns are connected to the same data signal line.

Fig. 2 exemplarily shows a timing diagram of the data signal indicated as "data" on the data signal line S1. As shown in Figs. 1 and 2, the inventor has discovered through research that when the display panel is displaying, the data signal line S1 needs to provide corresponding data signals data to the red sub-pixel R and the blue sub-pixel B respectively. Since the data signals data corresponding to the red sub-pixel R and the blue sub-pixel B are usually different from each other, the data signal data on the data signal line S1 will switch between the data signal data corresponding to the red sub-pixel R and the data signal data corresponding to the blue sub-pixel B.

For example, taking an example that a red image is displayed, when the first row of sub-pixels is scanned, the data signal line S1 provides a high-level data signal data to the red sub-pixels R, and when the second row of sub-pixels is scanned, the data signal line S1 provides a low-level data signal data to the blue sub-pixels B, and so on. In this way, the data signal data on the data signal line S1 will switch between different levels.

Among them, each switch of the data signal on the data signal line will cause the load capacitor on the data signal line to be charged or discharged, resulting in power consumption, which in turn causes the integrated circuit (IC) that provides the data signal to the data signal line to provide a large amount of current in a short period of time to charge or discharge the load capacitor on the data signal line, greatly increasing the power consumption of the IC.

Furthermore, the power consumption power1 increased on the IC may satisfy the following formula:

$$power1 = Vdd^2 * Cloading * f;$$

where Vdd is a voltage variation range on the data signal line, Cloading is the load capacitor of the data signal line, and f is the frequency at which the rising edge or falling edge of the data signal occurs.

It can be seen from the above formula that the voltage switch on the data signal line will increase the power consumption of the IC, and the more frequent the switch occurs and the greater the switch amplitude, the higher the increased power consumption of the IC.

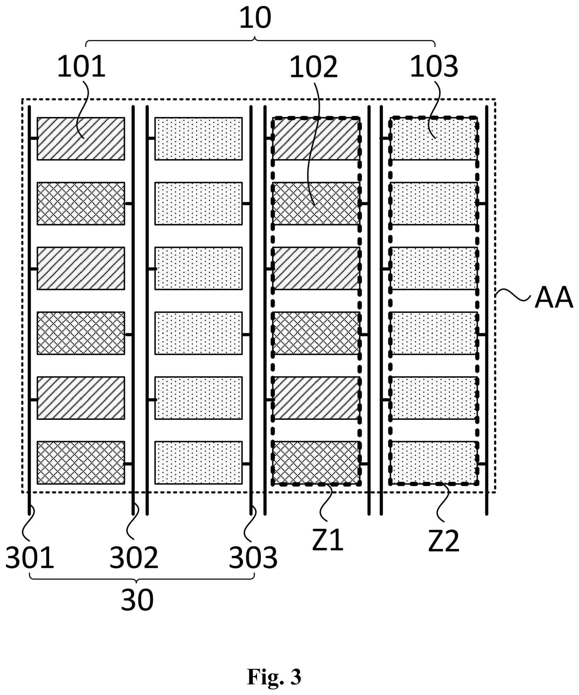

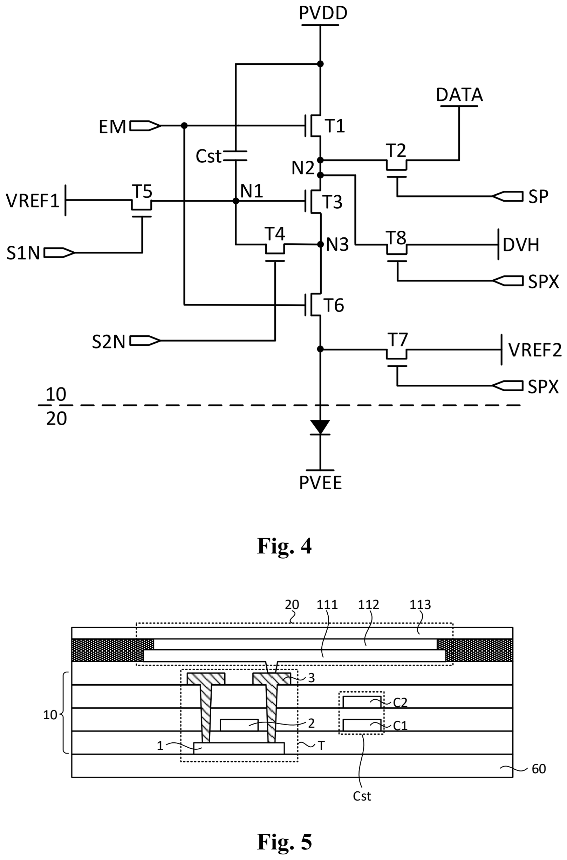

Based on the above technical problems, Fig. 3 is a schematic structural diagram of a display panel provided by an embodiment of the present disclosure, and Fig. 4 is a schematic structural diagram of a pixel circuit provided by an embodiment of the present disclosure. As shown in Figs. 3 and 4, the display panel provided by the embodiments of the present disclosure comprises a display region AA, and the display region AA comprises a plurality of pixel circuits 10 arranged in an array. The plurality of pixel circuits 10 comprise a first pixel circuit 101, a second pixel circuit 102, and a third pixel circuit 103 respectively connected to light-emitting elements 20 of different colors. The display panel further comprises a plurality of data signal lines 30 comprising a first data signal line 301, a second data signal line 302, and a third data signal line 303. The first data signal line 301 is electrically connected to the first pixel circuit 101, the second data signal line 302 is electrically connected to the second pixel circuit 102, and the third data signal line 303 is electrically connected to the third pixel circuit 103.

Specifically, the display region AA is provided with a plurality of pixel circuits 10 arranged in an array and a plurality of light-emitting elements 20 arranged in an array, and the plurality of pixel circuits 10 are electrically connected correspondingly to the plurality of light-emitting elements 20. The pixel circuit 10 is configured to transmit a driving current to the light-emitting element 20 under the action of a signal on a driving signal line (such as a scanning signal line, a data signal line, a power signal line, etc.) in the display panel, so as to drive the light-emitting element 20 to emit light. Herein, the light-emitting element 20 and the pixel circuit 10 electrically connected thereto together constitute the sub-pixels of the display panel. Arranging the plurality of sub-pixels according to a certain rule and accurately controlling the brightness of different sub-pixels, can realize the display of a complete image.

It should be noted that the arrangement of the plurality of pixel circuits 10 and the plurality of light-emitting elements 20 may be set according to actual needs, which are not specifically limited in the embodiments of the present disclosure.

Fig. 5 is a cross-sectional diagram of a sub-pixel provided in an embodiment of the present disclosure. As shown in Fig. 5, in an embodiment, the pixel circuit 10 may comprise at least one thin film transistor T, the thin film transistor T may comprise an active layer 1, a gate 2, and a source-drain electrode 3 that are stacked.

The light-emitting element 20 may comprise an organic light-emitting diode (OLED), a micro light-emitting diode (such as Micro-LED, Mini-LED) or other types of light-emitting devices, which are not specifically limited in the embodiments of the present disclosure.

Continue referring to Fig. 5, in an embodiment, taking an example that the light-emitting element 20 is an organic light-emitting diode, the light-emitting element 20 may comprise a anode 111, a light-emitting layer 112 and a cathode 113 that are stacked. When the pixel circuit 10 provides a driving current to the light-emitting element 20, electrons are injected into the light-emitting layer 112 via the cathode 113, and holes are injected into the light-emitting layer 112 via the anode 111. The electrons and holes recombine in the light-emitting layer 112 to release energy, thereby causing the light-emitting layer 112 to emit visible light.

By setting different materials of the light-emitting layer 112, visible light of different colors can be emitted.

For example, the light-emitting elements 20 may comprise a red light-emitting element that emits red light, a blue light-emitting element that emits blue light, and a green light-emitting element that emits green light to achieve colorful display. The present disclosure is not limited to this. In some embodiments, the light-emitting elements 20 may further comprise a white light-emitting element that emits white light, which are not specifically limited in the embodiments of the present disclosure.

Furthermore, the pixel circuit 10 comprises a first pixel circuit 101, a second pixel circuit 102 and a third pixel circuit 103 respectively connected to light-emitting elements 20 of different colors to form sub-pixels emitting light of different colors.

Continue referring to Figs. 3 and 4, the display panel is further provided with a plurality of data signal lines 30 configured to provide data signals for the pixel circuits 10.

Continuing referring to Fig. 4, illustratively, the pixel circuit 10 comprises a driving transistor T3 that provides a driving current to the light-emitting element 20, the driving transistor T3 and the light-emitting element 20 are connected in series between a first power signal line and a second power signal line. The first power signal line and the second power signal line are both configured to transmit a power voltage, and the power voltage on the first power signal line can be greater than the power voltage on the second power signal line, a driving current is generated by the potential difference between the first power signal line and the second power signal line, thereby driving the light-emitting element 20 to emit light.

Herein, the working process of the pixel circuit 10 may comprise a data writing stage. In the data writing stage, the data signal line 30 writes a data signal to the gate of the driving transistor T3, and the driving transistor T3 is turned on in response to the voltage of the data signal written to its gate. The driving current formed by the turning on of the driving transistor T3 is used to drive the light-emitting element 20 to emit light.

It can be understood that the gate potential of the driving transistor T3 will determine the magnitude of the driving current formed by its turning on, and the magnitude of the driving current can determine the brightness of the light-emitting element 20. Therefore, the gate potential of the driving transistor T3 can be controlled by the data signal to adjust the brightness of the light-emitting element 20, thereby controlling the display grey level of the sub-pixel.

Furthermore, the data signal line 30 comprises a first data signal line 301, a second data signal line 302 and a third data signal line 303. The first data signal line 301 is electrically connected to the first pixel circuit 101, the second data signal line 302 is electrically connected to the second pixel circuit 102, and the third data signal line 303 is electrically connected to the third pixel circuit 103. One data signal line is only connected to the pixel circuit 10 in the sub-pixel emitting the same color light, therefore, one data signal line only needs to transmit the data signal corresponding to the sub-pixel of one color, thus, the frequency and amplitude of the switching of the data signal on a single data signal line can be reduced, thereby reducing the power consumption of the integrated circuit (IC) providing the data signal, and further helping to reduce the overall power consumption of the display panel.

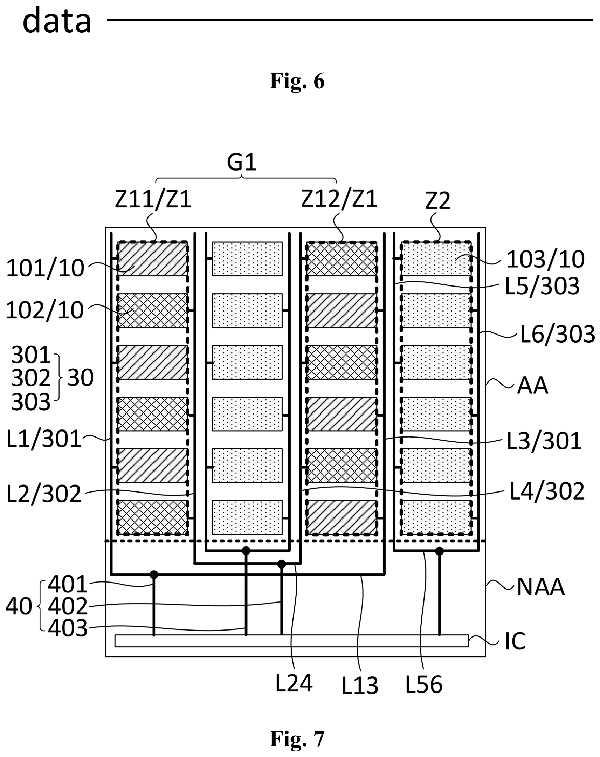

Exemplarily, Fig. 6 is a timing diagram of a data signal on a data signal line provided in an embodiment of the present disclosure. Fig. 6 exemplarily shows a timing diagram of a data signal data on a first data signal line 301. As shown in Fig. 6, taking an example that the first data signal line 301 provides a data signal to the red sub-pixel, when the display panel displays a red image, the first data signal line 301 only needs to provide a high-level data signal data to the red sub-pixel. In this way, the data signal data on the first data signal line 301 only needs to be maintained at the same potential without switching, thereby reducing the switching frequency and switching amplitude of the data signal data on the first data signal line 301, and reducing the power consumption of the integrated circuit (IC) providing the data signal.

Similarly, the second data signal line 302 and the third data signal line 303 provide data signals for sub-pixels of other colors except the red sub-pixel. Therefore, when the display panel displays a red image, the second data signal line 302 and the third data signal line 303 only need to provide low-level data signals. In this way, the second data signal line 302 and the third data signal line 303 each only need to remain at a same potential without switching, thereby reducing the switching frequency and switching amplitude of the data signals on the second data signal line 302 and the third data signal line 303, and further reducing the power consumption of the IC providing the data signal.

According to test results, Table 1 exemplarily shows the reduction in the power consumption of the integrated circuit (IC) when the display panel displays different images after adopting the solution provided by the embodiments of the application.

Table 1 shows the reduction in the power consumption of the display panel when different images are displayed

| Image | reduction in power consumption (%) |
|---|---|
| White image | 14% |
| Red image | 37% |
| Blue image | 43% |
| Smiley face image | 11% |

As shown in Table 1, by adopting the solution provided by the embodiments of the application, when the display panel displays different images, the comprehensive power consumption of the integrated circuit (IC) can be reduced by about 25%.

As discussed above, in the display panel provided by the embodiments of the present disclosure, one data signal line is set to be connected only to sub-pixels emitting light of the same color, so that one data signal line only needs to transmit the data signal corresponding to sub-pixels of one color, thereby reducing the switch frequency and switch amplitude of the data signal on the single data signal line, and reducing the power consumption of the integrated circuit (IC) providing the data signal, which is beneficial to reducing the overall power consumption of the display panel.

Continue referring to Fig. 3, in an embodiment, a plurality of pixel circuits 10 form a plurality of first pixel circuit columns Z1, the first pixel circuit column Z1 comprises first pixel circuits 101 and second pixel circuits 102 arranged alternately along the column direction. A plurality of pixel circuits 10 form a plurality of second pixel circuit columns Z2, the second pixel circuit column Z2 comprises third pixel circuits 103 arranged along the column direction, and the first pixel circuit column Z1 and the second pixel circuit column Z2 are arranged alternately along the row direction. A plurality of data signal lines 30 extend along the column direction and are arranged along the row direction. The first data signal line 301 is electrically connected to the first pixel circuits 101 in the same first pixel circuit column Z1, the second data signal line 302 is electrically connected to the second pixel circuits 102 in the same first pixel circuit column Z1, and the third data signal line 303 is electrically connected to the third pixel circuits 103 in the same second pixel circuit column Z2.

Specifically, as shown in Fig. 3, the display region AA is provided with first pixel circuit columns Z1 and second pixel circuit columns Z2 arranged alternately along the row direction. In the first pixel circuit column Z1, the first pixel circuits 101 and the second pixel circuits 102 are arranged alternately in the column direction; in the second pixel circuit column Z2, a plurality of third pixel circuits 103 are arranged sequentially in the column direction.

With the above arrangement, each pixel unit may not be composed of all of a red sub-pixel, a green sub-pixel, and a blue sub-pixel, but may be composed of two sub-pixels of different colors. For example, adjacent red sub-pixel and green sub-pixel form one pixel unit, or adjacent blue sub-pixel and green sub-pixel form one pixel unit. With this arrangement, each pixel unit comprises only two sub-pixels instead of three sub-pixels, so that more pixel units can be placed in the same area, achieving a higher pixel density, which is conducive to improving resolution and making the displaying more delicate.

Further, as shown in Fig. 3, the data signal lines 30 extend in the column direction and are arranged in the row direction, and the data signal lines 30 and the pixel circuit columns are arranged correspondingly, each data signal line 30 may be connected to at least part of the pixel circuits in only one pixel circuit column.

Specifically, as shown in Fig. 3, the first data signal line 301 is electrically connected to the first pixel circuits 101 in the same first pixel circuit column Z1, and the first data signal line 301 only needs to provide a data signal to the first pixel circuits 101 in the same first pixel circuit column Z1; the second data signal line 302 is electrically connected to the second pixel circuits 102 in the same first pixel circuit column Z1, and the second data signal line 302 only needs to provide a data signal to the second pixel circuits 102 in the same first pixel circuit column Z1; the third data signal line 303 is electrically connected to the third pixel circuits 103 in the same second pixel circuit column Z2, and the third data signal line 303 only needs to provide a data signal to the third pixel circuits 103 in the same second pixel circuit column Z2. In this way, one data signal line only transmits a data signal corresponding to sub-pixels of one color, thereby reducing the switching frequency and switching amplitude of the data signal on a single data signal line, and reducing the power consumption of the integrated circuit (IC) providing the data signal.

Fig. 7 is a schematic structural diagram of a display panel provided by another embodiment of the present disclosure. As shown in Fig. 7, in an embodiment, a plurality of first pixel circuit columns Z1 are divided into a plurality of first pixel circuit column groups G1, the first pixel circuit column group G1 comprises two first pixel circuit columns Z1 which are a first intra-group pixel circuit column Z11 and a second intra-group pixel circuit column Z12. The first data signal line 301 connected to the first pixel circuits 101 in the first intra-group pixel circuit column Z11 is referred to as first intra-group data signal line L1, the second data signal line 302 connected to the second pixel circuits 102 in the first intra-group pixel circuit column Z11 is referred to as second intra-group data signal line L2, the first data signal line 301 connected to the first pixel circuits 101 in the second intra-group pixel circuit column Z12 is referred to as third intra-group data signal line L3, and the second data signal line 302 connected to the second pixel circuits 102 in the second intra-group pixel circuit column Z12 is referred to as fourth intra-group data signal line L4. In the first pixel circuit column group G1, the first intra-group data signal line L1 is electrically connected to the third intra-group data signal line L3, and the second intra-group data signal line L2 is electrically connected to the fourth intra-group data signal line L4. The first pixel circuit 101 connected to the first intra-group data signal line L1 and the first pixel circuit 101 connected to the third intra-group data signal line L3 are located in different pixel circuit rows, and the second pixel circuit 102 connected to the second intra-group data signal line L2 and the second pixel circuit 102 connected to the fourth intra-group data signal line L4 are located in different pixel circuit rows.

Specifically, as shown in Fig. 7, in the display region AA, a plurality of first pixel circuit column groups G1 are arranged along the row direction, the first pixel circuit column group G1 comprises a first intra-group pixel circuit column Z11 and a second intra-group pixel circuit column Z12, the first intra-group pixel circuit column Z11 comprises first pixel circuits 101 and second pixel circuits 102 alternately arranged along the column direction, and the second intra-group pixel circuit column Z12 comprises first pixel circuits 101 and second pixel circuits 102 alternately arranged along the column direction.

In this embodiment, the first pixel circuits 101 in the first intra-group pixel circuit column Z11 are all connected to the first intra-group data signal line L1, and the first pixel circuits 101 in the second intra-group pixel circuit column Z12 are connected to the third intra-group data signal line L3, the first intra-group data signal line L1 and the third intra-group data signal line L3 in the first pixel circuit column group G1 are electrically connected to each other. With such arrangement, the data signals on the first intra-group data signal line L1 and the third intra-group data signal line L3 can be provided by the same pin of the IC, thereby ensuring that one data signal line only transmits the data signal corresponding to sub-pixels of one color, while reducing the number of pins for providing data signals in the IC, which is beneficial to reducing the size and cost of the IC.

Furthermore, the first pixel circuit 101 connected to the first intra-group data signal line L1 and the first pixel circuit 101 connected to the third intra-group data signal line L3 are located in different pixel circuit rows, so as to avoid the situation where the same pin of the IC simultaneously provides data signals to two first pixel circuits 101 located in different pixel circuit columns when scanning a certain row of pixel circuits. Therefore, when scanning any row of pixel circuits, each IC pin only provides a data signal to one first pixel circuit 101, ensuring that in one frame of display, the brightness of the sub-pixels corresponding to each first pixel circuit 101 can be independently controlled, thereby ensuring the display quality of the display panel.

Continue referring to Fig. 7, the second pixel circuits 102 in the first intra-group pixel circuit column Z11 are all connected to the second intra-group data signal line L2, and the second pixel circuits 102 in the second intra-group pixel circuit column Z12 are all connected to the fourth intra-group data signal line L4, the second intra-group data signal line L2 and the fourth intra-group data signal line L4 in the first pixel circuit column group G1 are electrically connected. With such an arrangement, the data signals on the second intra-group data signal line L2 and the fourth intra-group data signal line L4 can be provided by the same pin of the IC, thereby ensuring that one data signal line only transmits a data signal corresponding to sub-pixels of one color, while reducing the number of pins providing data signals in the IC, which is beneficial to reducing the size and cost of the IC.

Furthermore, the second pixel circuit 102 connected to the second intra-group data signal line L2 and the second pixel circuit 102 connected to the fourth intra-group data signal line L4 are located in different pixel circuit rows, so as to avoid the situation where the same pin of the IC simultaneously provides data signals to two second pixel circuits 102 located in different pixel circuit columns when scanning a certain row of pixel circuits. Therefore, when scanning any row of pixel circuits, each IC pin only provides a data signal to one second pixel circuit 102, ensuring that in one frame of display, the brightness of the sub-pixel corresponding to each second pixel circuit 102 can be independently controlled, thereby ensuring the display quality of the display panel.

Continue referring to Fig. 7, in an embodiment, the first pixel circuits 101 and the second pixel circuits 102 are alternately arranged along the row direction, and the first pixel circuit column group G1 comprises two adjacent first pixel circuit columns Z1.

Specifically, as shown in Fig. 7, in the row direction, the first pixel circuits 101 and the second pixel circuits 102 are arranged alternately, and third pixel circuits 103 are arranged between the first pixel circuits 101 and the second pixel circuits 102. With such an arrangement, the arrangement of the first pixel circuits 101 and the second pixel circuits 102 can be more dispersed, so that the display panel is not prone to produce local bright lines, which is beneficial to improving the display uniformity of the display panel.

Continue referring to Fig. 7, in an embodiment, the display panel provided by the embodiments of the present disclosure further comprises a non-display region NAA located on at least one side of the display region AA, and in the first pixel circuit column group G1, the first intra-group data signal line L1 and the third intra-group data signal line L3 are electrically connected via a first data connecting line L13, the second intra-group data signal line L2 and the fourth intra-group data signal line L4 are electrically connected via a second data connecting line L24, and the first data connecting line L13 and the second data connecting line L24 are both located in the non-display region NAA.

Specifically, as shown in Fig. 7, the non-display region NAA may be a lower frame area located on one side of the display region AA along the column direction, which is not limited thereto. The embodiments of the present disclosure does not specifically limit the positional relationship between the display region AA and the non-display region NAA.

In this embodiment, as shown in Fig. 7, by providing a first data connecting line L13 extending in the row direction, the first intra-group data signal line L1 and the third intra-group data signal line L3 in the first pixel circuit column group G1 are electrically connected via the first data connecting line L13. In addition, by providing a second data connecting line L24 extending in the row direction, the second intra-group data signal line L2 and the fourth intra-group data signal line L4 in the first pixel circuit column group G1 are electrically connected via the second data connecting line L24.

Among them, the first data connecting line L13 and the second data connecting line L24 are both located in the non-display region NAA, which can avoid the first data connecting line L13 and the second data connecting line L24 from blocking the display region AA, thereby alleviating the influence of the first data connecting line L13 and the second data connecting line L24 on the display effect.

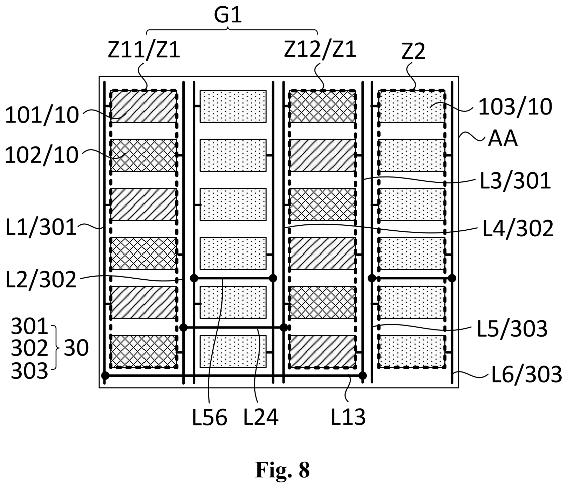

Fig. 8 is a structural schematic diagram of a display panel provided by another embodiment of the present disclosure. As shown in Fig. 8, in an embodiment, in the first pixel circuit column group G1, the first intra-group data signal line L1 and the third intra-group data signal line L3 are electrically connected via the first data connecting line L13, and the second intra-group data signal line L2 and the fourth intra-group data signal line L4 are electrically connected via the second data connecting line L24, and the first data connecting line L13 and the second data connecting line L24 are both located in the display region AA.

Specifically, as shown in Fig. 8, by providing a first data connecting line L13 extending in the row direction, the first intra-group data signal line L1 and the third intra-group data signal line L3 in the first pixel circuit column group G1 are electrically connected via the first data connecting line L13. Furthermore, by providing a second data connecting line L24 extending in the row direction, the second intra-group data signal line L2 and the fourth intra-group data signal line L4 in the first pixel circuit column group G1 are electrically connected via the second data connecting line L24.

The first data connecting line L13 and the second data connecting line L24 are both located in the display region AA, which is different from the solution of setting the first data connecting line L13 and the second data connecting line L24 in the non- display region NAA. It can reduce the wirings in the non-display region NAA, which is beneficial to reduce the area used for wiring in the non-display region NAA and realize a narrow bezel design.

Continue referring to Fig. 8, in an embodiment, the first data connecting line L13 and the second data connecting line L24 are located between adjacent rows of pixel circuits 10 in the display region AA, which can avoid the generation of parasitic capacitance between the first data connecting line L13 and the second data connecting line L24 and between metal layers in the pixel circuit 10, thereby alleviating the influence of the first data connecting line L13 and the second data connecting line L24 on the performance of the pixel circuit 10, which is not limited thereto.

In other embodiments, along a direction perpendicular to the plane where the display panel is located, the first data connecting line L13 and the second data connecting line L24 may alternatively at least partially overlap with the pixel circuit 10, so that the first data connecting line L13 and the second data connecting line L24 do not need to occupy additional space, which is beneficial to improving the pixel density of the display panel. The embodiments of the present disclosure do not specifically limit this.

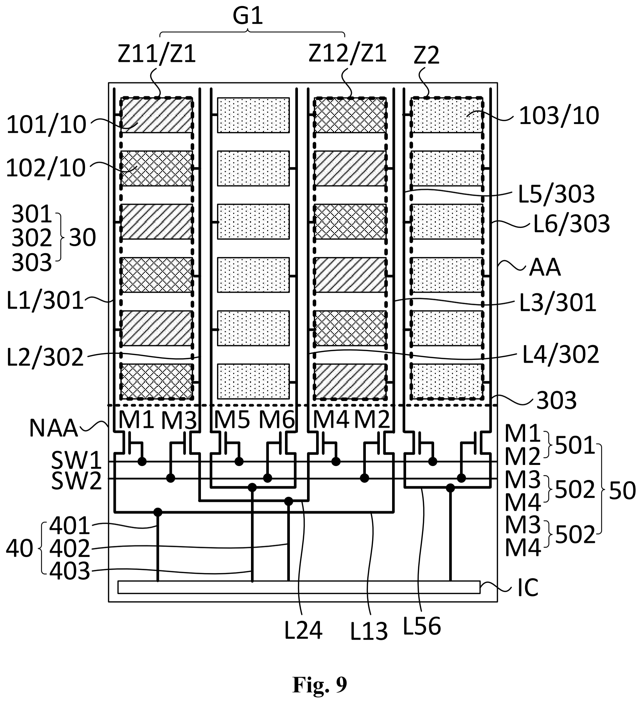

Fig. 9 is a schematic structural diagram of a display panel provided by another embodiment of the present disclosure. As shown in Fig. 9, in an embodiment, the display panel provided by an embodiment of the present disclosure further comprises a plurality of data signal output lines 40 and a plurality of gating circuits 50. The data signal output lines 40 comprise a first data signal output line 401 and a second data signal output line 402. The gating circuit 50 comprises a first gating circuit 501 and a second gating circuit 502. In the first pixel circuit column group G1, the first intra-group data signal line L1 and the third intra-group data signal line L3 are electrically connected to the same first data signal output line 401 via the first gating circuit 501. The first gating circuit 501 is configured to transmit the data signal output by the first data signal output line 401 to the first intra-group data signal line L1 and the third intra-group data signal line L3 in a time-division manner. In the first pixel circuit column group G1, the second intra-group data signal line L2 and the fourth intra-group data signal line L4 are electrically connected to the same second data signal output line 402 via the second gating circuit 502. The second gating circuit 502 is configured to transmit the data signal output by the second data signal output line 402 to the second intra-group data signal line L2 and the fourth intra-group data signal line L4 in a time-division manner.

As shown in Figs. 7 and 9, a plurality of data signal output lines 40 are provided on the display panel, and the data signal output lines 40 are electrically connected to the pins of the integrated circuit IC and the data signal lines 30, respectively. The integrated circuit IC provides data signals to the data signal lines 30 via the data signal output lines 40.

Specifically, as shown in Figs. 7 and 9, the data signal output lines 40 comprise a first data signal output line 401 and a second data signal output line 402. In the first pixel circuit column group G1, the first intra-group data signal line L1 and the third intra-group data signal line L3 are both electrically connected to the same first data signal output line 401. In this situation, the first data signal output line 401 provides data signals to the first intra-group data signal line L1 and the third intra-group data signal line L3 simultaneously. Similarly, in the first pixel circuit column group G1, the second intra-group data signal line L2 and the fourth intra-group data signal line L4 are both electrically connected to the same second data signal output line 402. In this situation, the second data signal output line 402 provides data signals to the second intra-group data signal line L2 and the fourth intra-group data signal line L4 simultaneously.

Continue referring to Fig. 7, one data signal output line 40 needs to provide data signals to two data signal lines 30 simultaneously, each data signal line 30 is connected to a certain number of pixel circuits 10, and each pixel circuit 10 has its own parasitic capacitance. Therefore, when a data signal output line 40 provides data signals to two data signal lines 30 simultaneously, the capacitive load (loading) on pin of the integrated circuit IC comprises the parasitic capacitance of the pixel circuits 10 connected to the two data signal lines 30, which will cause a problem of large capacitive load. The larger the capacitive load, the more energy required for charging and discharging, and the power consumption will also increase.

Based on the above technical problems, in this embodiment, as shown in Fig. 9, a plurality of gating circuits 50 are further provided on the display panel. The gating circuit 50 is configured to transmit the data signal from the data signal output line 40 to different data signal lines 30 in a time-division manner, so that at the same time point, the gating circuit 50 will selectively transmit the data signal to one data signal line 30, ensuring that the pin of each integrated circuit IC only provides a data signal to one data signal line 30 at any time, thereby effectively reducing the capacitive load on the pin of the integrated circuit IC, and reducing power consumption.

Specifically, as shown in Fig. 9, the gating circuit 50 comprises a first gating circuit 501 and a second gating circuit 502. In the first pixel circuit column group G1, the first intra-group data signal line L1 and the third intra-group data signal line L3 are electrically connected to the same first data signal output line 401 via the first gating circuit 501, so that the data signal output by the first data signal output line 401 is transmitted to the first intra-group data signal line L1 and the third intra-group data signal line L3 via the first gating circuit 501 in a time-division manner, ensuring that pin of the integrated circuit IC connected to the first data signal output line 401 only provides data signals to either the first intra-group data signal line L1 or the third intra-group data signal line L3 at any time, and reducing the capacitive load on the pin of the integrated circuit IC, and further reducing power consumption.

Similarly, in the first pixel circuit column group G1, the second intra-group data signal line L2 and the fourth intra-group data signal line L4 are electrically connected to the same second data signal output line 402 via the second gating circuit 502, so that the data signal output by the second data signal output line 402 is transmitted to the second intra-group data signal line L2 and the fourth intra-group data signal line L4 via the second gating circuit 502 in a time-division manner, ensuring that the pin of the integrated circuit IC connected to the second data signal output line 402 only provides data signals to either the second intra-group data signal line L2 or the fourth intra-group data signal line L4 at any time, thereby reducing the capacitive load on the pin of the integrated circuit IC, and further reducing power consumption.

According to the test results, after adopting the solution provided by the embodiments of the application, the power consumption of the integrated circuit IC can be reduced by 10% when the display panel displays a white image, and the power consumption of the integrated circuit IC can be reduced by about 40% when the display panel displays a red or blue image.

Continue referring to Fig. 9, in an embodiment, the data signal output line 40, the gating circuit 50 and the integrated circuit IC are all located in the non-display region NAA, which can avoid the data signal output line 40, the gating circuit 50 and the integrated circuit IC from blocking the display region AA, thereby alleviating the influence of the data signal output line 40, the gating circuit 50 and the integrated circuit IC on the display effect.

In other embodiments, the integrated circuit IC may alternatively be disposed on a flexible circuit board bound and connected to the display panel, which is beneficial for reducing the area of the non-display region NAA and realizing a narrow bezel design, which is not specifically limited in the embodiments of the present disclosure.

Continuing referring to Fig. 9, in an embodiment, the data signal output lines 40 extend in the column direction and are arranged in the row direction, which facilitates the electrical connection of the data signal output line 40 between the pin of the integrated circuit IC and the data signal line 30, while avoiding short circuits between different data signal output lines 40, which is not specifically limited in the embodiments of the present disclosure.

Continue referring to Fig. 9, in an embodiment, the first gating circuit 501 comprises a first switching transistor M1 and a second switching transistor M2, the first switching transistor M1 is connected between the first intra-group data signal line L1 and the first data signal output line 401, and the second switching transistor M2 is connected between the third intra-group data signal line L3 and the first data signal output line 401. The second gating circuit 502 comprises a third switching transistor M3 and a fourth switching transistor M4, the third switching transistor M3 is connected between the second intra-group data signal line L2 and the second data signal output line 402, and the fourth switching transistor M4 is connected between the fourth intra-group data signal line L4 and the second data signal output line 402. The gate of the first switching transistor M1 and the gate of the fourth switching transistor M4 receive a first switching signal SW1, and the gate of the second switching transistor and the gate of the third switching transistor M3 receive a second switching signal SW2.

Specifically, as shown in Fig. 9, the first gating circuit 501 comprises a first switching transistor M1 and a second switching transistor M2, wherein one end of the first switching transistor M1 is connected to the first intra-group data signal line L1, and the other end of the first switching transistor M1 is connected to the first data signal output line 401; one end of the second switching transistor M2 is connected to the third intra-group data signal line L3, and the other end of the second switching transistor M2 is connected to the first data signal output line 401.

Furthermore, the gate of the first switching transistor M1 receives a first switching signal SW1 used to control the first switching transistor M1 to be turned on or off. When the first switching transistor M1 is turned on, the first intra-group data signal line L1 and the first data signal output line 401 are connected to each other. In this situation, the first data signal output line 401 provides a data signal to the first intra-group data signal line L1; when the first switching transistor M1 is turned off, the first intra-group data signal line L1 and the first data signal output line 401 are insulated from each other.

The gate of the second switching transistor M2 receives the second switching signal SW2 used to control the second switching transistor M2 to be turned on or off. When the second switching transistor M2 is turned on, the third intra-group data signal line L3 and the first data signal output line 401 are connected to each other. In this situation, the first data signal output line 401 provides a data signal to the third intra-group data signal line L3; when the second switching transistor M2 is turned off, the third intra-group data signal line L3 and the first data signal output line 401 are insulated from each other.

The gate of the first switching transistor M1 and the gate of the second switching transistor M2 receive different switching signals, namely the first switching signal SW1 and the second switching signal SW2 respectively, so that the first switching transistor M1 and the second switching transistor M2 are turned on in a time-division manner, thereby realizing the transmission of the data signal output by the first data signal output line 401 to the first intra-group data signal line L1 and the third intra-group data signal line L3 in a time-division manner, ensuring that the pin of the integrated circuit IC connected to the first data signal output line 401 only provides data signals to either the first intra-group data signal line L1 or the third intra-group data signal line L3 at any time, thereby reducing the capacitive load on the pin of the integrated circuit IC and reducing power consumption.

Similarly, referring to Fig. 9, the second gating circuit 502 comprises a third switching transistor M3 and a fourth switching transistor M4, one end of the third switching transistor M3 is connected to the second intra-group data signal line L2, and the other end of the third switching transistor M3 is connected to the second data signal output line 402; one end of the fourth switching transistor M4 is connected to the fourth intra-group data signal line L4, and the other end of the fourth switching transistor M4 is connected to the second data signal output line 402.

The gate of the third switching transistor M3 receives the second switching signal SW2 used to control the third switching transistor M3 to be turned on or off. When the third switching transistor M3 is turned on, the second intra-group data signal line L2 is connected to the second data signal output line 402. In this situation, the second data signal output line 402 provides a data signal to the second intra-group data signal line L2; when the third switching transistor M3 is turned off, the second intra-group data signal line L2 and the second data signal output line 402 are insulated from each other.

The gate of the fourth switching transistor M4 receives the first switching signal SW1 used to control the fourth switching transistor M4 to be turned on or off. When the fourth switching transistor M4 is turned on, the fourth intra-group data signal line L4 and the second data signal output line 402 are connected to each other. In this situation, the second data signal output line 402 provides a data signal to the fourth intra-group data signal line L4; when the fourth switching transistor M4 is turned off, the fourth intra-group data signal line L4 and the second data signal output line 402 are insulated from each other.

The gate of the third switching transistor M3 and the gate of the fourth switching transistor M4 receive different switching signals, namely the second switching signal SW2 and first switching signal SW1 respectively, so that the third switching transistor M3 and the fourth switching transistor M4 are turned on in a time-division manner, thereby realizing the transmission of the data signal output by the second data signal output line 402 to the second intra-group data signal line L2 and the fourth intra-group data signal line L4 in a time-division manner, ensuring that the pin of the integrated circuit IC connected to the second data signal output line 402 only provides data signals to either the second intra-group data signal line L2 or the fourth intra-group data signal line L4 at any time, thereby reducing the capacitive load on the pin of the integrated circuit IC and reducing power consumption.

Further, as shown in Fig. 9, the first pixel circuit 101 connected to the first intra-group data signal line L1 and the second pixel circuit 102 connected to the fourth intra-group data signal line L4 are located in the same pixel circuit row. Therefore, the gate of the first switching transistor M1 and the gate of the fourth switching transistor M4 can be set to both receive the first switching signal SW1, so that the first switching transistor M1 and the fourth switching transistor M4 are simultaneously turned on, ensuring that the first pixel circuit 101 and the second pixel circuit 102 located in the same row simultaneously receive the data signal. Such a setting can reduce the number of switching signals, simplify the control logic, and help reduce the number of switching signal lines that transmit switching signals, thereby reducing costs.

Similarly, the second pixel circuit 102 connected to the second intra-group data signal line L2 and the first pixel circuit 101 connected to the third intra-group data signal line L3 are located in the same pixel circuit row. Therefore, the gate of the second switching transistor M2 and the gate of the third switching transistor M3 can be set to both receive the second switching signal SW2, so that the second switching transistor M2 and the third switching transistor M3 are turned on simultaneously, ensuring that the first pixel circuit 101 and the second pixel circuit 102 located in the same row receive the data signal simultaneously. Such a setting can reduce the number of switching signals, simplify the control logic, and help reduce the number of switching signal lines that transmit switching signals, thereby reducing costs.

Continue referring to Figs. 7 to 9, in an embodiment, the plurality of first pixel circuit columns Z1 are divided into a plurality of first pixel circuit column groups G1, and the first pixel circuit column group G1 comprises two adjacent first pixel circuit columns Z1 which are respectively a first intra-group pixel circuit column Z11 and a second intra-group pixel circuit column Z12. The first data signal line 301 connected to the first pixel circuits 101 in the first intra-group pixel circuit column Z11 is the first intra-group data signal line L1, the second data signal line 302 connected to the second pixel circuits 102 in the first intra-group pixel circuit column Z11 is the second intra-group data signal line L2, the first data signal line 301 connected to the first pixel circuits 101 in the second intra-group pixel circuit column Z12 is the third intra-group data signal line L3, and the second data signal line 302 connected to the second pixel circuits 102 in the second intra-group pixel circuit column Z12 is the fourth intra-group data signal line L4. In the row direction, the first intra-group data signal line L1 and the second intra-group data signal line L2 are located on different sides of the first intra-group pixel circuit column Z11, and the third intra-group data signal line L3 and the fourth intra-group data signal line L4 are located on different sides of the second intra-group pixel circuit column Z12.

The structure of the first intra-group pixel circuit column Z11 and the second intra-group pixel circuit column Z12 in the first pixel circuit column group G1, as well as the connection structure of the first intra-group data signal line L1, the second intra-group data signal line L2, the third intra-group data signal line L3 and the fourth intra-group data signal line L4 can refer to the above embodiments and will not be repeated here.

In this embodiment, as shown in Figs. 7 to 9, the first intra-group data signal line L1 and the second intra-group data signal line L2 are respectively located on different sides of the first intra-group pixel circuit column Z11 along the row direction. In the row direction, the first intra-group data signal line L1 and the second intra-group data signal line L2 are both spaced apart from the first intra-group pixel circuit column Z11, so as to avoid parasitic capacitances between the first intra-group data signal line L1 and the second intra-group data signal line L2 and the metal layers of the pixel circuit 10 in the first intra-group pixel circuit column Z11, thereby alleviating the influence of the first intra-group data signal line L1 and the second intra-group data signal line L2 on the performance of the pixel circuit 10. While in the row direction, there is a large distance between the first intra-group data signal line L1 and the second intra-group data signal line L2, thereby reducing the mutual interference of data signals between the first intra-group data signal line L1 and the second intra-group data signal line L2.

Similarly, along the row direction, the third intra-group data signal line L3 and the fourth intra-group data signal line L4 are arranged on different sides of the second intra-group pixel circuit column Z12. In the row direction, the third intra-group data signal line L3 and the fourth intra-group data signal line L4 are both spaced a certain distance from the second intra-group pixel circuit column Z12, so that parasitic capacitances can be avoided between the third intra-group data signal line L3 and the fourth intra-group data signal line L4 and the metal layers of the pixel circuit 10 in the second intra-group pixel circuit column Z12, thereby alleviating the influence of the third intra-group data signal line L3 and the fourth intra-group data signal line L4 on the performance of the pixel circuit 10. While in the row direction, there is a large distance between the third intra-group data signal line L3 and the fourth intra-group data signal line L4, thereby reducing the mutual interference of data signals between the third intra-group data signal line L3 and the fourth intra-group data signal line L4.

Continue referring to Figs. 7 to 9, in an embodiment, the plurality of first pixel circuit columns Z1 are divided into a plurality of first pixel circuit column groups G1, and the first pixel circuit column group G1 comprises two adjacent first pixel circuit columns Z1 which are respectively a first intra-group pixel circuit column Z11 and a second intra-group pixel circuit column Z12. The first data signal line 301 connected to the first pixel circuits 101 in the first intra-group pixel circuit column Z11 is the first intra-group data signal line L1, the second data signal line 302 connected to the second pixel circuits 102 in the first intra-group pixel circuit column Z11 is the second intra-group data signal line L2, the first data signal line 301 connected to the first pixel circuits 101 in the second intra-group pixel circuit column Z12 is the third intra-group data signal line L3, and the second data signal line 302 connected to the second pixel circuits 102 in the second intra-group pixel circuit column Z12 is the fourth intra-group data signal line L4. In the first pixel circuit column group G1, the second intra-group data signal line L2 and the fourth intra-group data signal line L4 are located between the first intra-group data signal line L1 and the third intra-group data signal line L3.

The structure of the first intra-group pixel circuit column Z11 and the second intra-group pixel circuit column Z12 in the first pixel circuit column group G1, as well as the connection structure of the first intra-group data signal line L1, the second intra-group data signal line L2, the third intra-group data signal line L3 and the fourth intra-group data signal line L4 can refer to the above embodiments and will not be repeated here.

In this embodiment, as shown in Figs. 7 to 9, the first intra-group data signal line L1 and the third intra-group data signal line L3 are both connected to the first pixel circuits 101, and the first pixel circuits 101 are located in the sub-pixels of the same color; the second intra-group data signal line L2 and the fourth intra-group data signal line L4 are both connected to the second pixel circuits 102, and the second pixel circuits 102 are located in the sub-pixels of the same color.

In the first pixel circuit column group G1, the second intra-group data signal line L2 and the fourth intra-group data signal line L4 are arranged between the first intra-group data signal line L1 and the third intra-group data signal line L3, thus along the row direction, the first intra-group data signal line L1, the second intra-group data signal line L2, the fourth intra-group data signal line L4 and the third intra-group data signal line L3 can be arranged sequentially, so that the second intra-group data signal line L2 and the fourth intra-group data signal line L4 can be symmetrically distributed with respect to the central axis of the first pixel circuit column group G1, and the first intra-group data signal line L1 and the third intra-group data signal line L3 can also be symmetrically distributed with respect to the central axis of the first pixel circuit column group G1. That is, the data signal lines 30 connecting sub-pixels of the same color can be symmetrically distributed with respect to the central axis of the first pixel circuit column group G1, which is conducive to making the color deviation of the display image have better symmetry, thereby mitigating the color deviation at different viewing directions, that is, no matter from which direction the display image is viewed, the consistency and accuracy of the color will be improved, and thus the display image can be viewed from a wider angle range without feeling obvious color changes, thereby enhancing the user experience.

It should be noted that the central axis of the first pixel circuit column group G1 is a central axis extending along the column direction.

Continue referring to Fig. 7, in an embodiment, the display panel provided in the embodiment of the present disclosure further comprises a non-display region NAA located at least on one side of the display region AA. In the first pixel circuit column group G1, the first intra-group data signal line L1 and the third intra-group data signal line L3 are electrically connected via the first data connecting line L13, the second intra-group data signal line L2 and the fourth intra-group data signal line L4 are electrically connected via the second data connecting line L24, the first data connecting line L13 and the second data connecting line L24 are both located in the non-display region NAA, and the second data connecting line L24 is located on the side of the first data connecting line L13 close to the display region AA.

The position relationship between the display region AA and the non-display region NAA, the connection relationship between the first intra-group data signal line L1, the second intra-group data signal line L2, the third intra-group data signal line L3, the fourth intra-group data signal line L4, the first data connecting line L13 and the second data connecting line L24 can be referred to the above embodiments and will not be repeated here.

In this embodiment, as shown in Fig. 7, the first data connecting line L13 and the second data connecting line L24 are both located in the non-display region NAA, which can avoid the first data connecting line L13 and the second data connecting line L24 from blocking the display region AA, thereby alleviating the influence of the first data connecting line L13 and the second data connecting line L24 on the display effect.

Further, as shown in Fig. 7, the second data connecting line L24 is located on the side of the first data connecting line L13 close to the display region AA. In such arrangement, in the direction perpendicular to the plane where the display panel is located, the first data connecting line L13 can be avoided from overlapping with the second intra-group data signal line L2 and the fourth intra-group data signal line L4, thereby reducing the coupling capacitance between the first data connecting line L13 and the second intra-group data signal line L2 and between the first data connecting line L13 and the fourth intra-group data signal line L4, and reducing the mutual interference between the data signal on the first data connecting line L13 and the data signals on the second intra-group data signal line L2 and between the data signal on the first data connecting line L13 and the fourth intra-group data signal line L4.

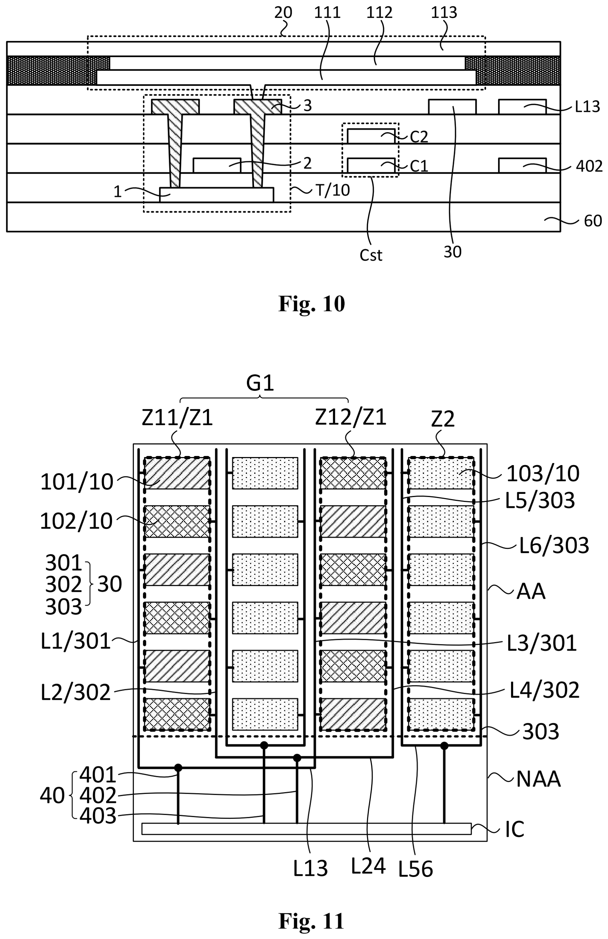

Fig. 10 is a partial cross-sectional diagram of a display panel provided by an embodiment of the present disclosure. As shown in Figs. 7 and 10, in an embodiment, the display panel provided by an embodiment of the present disclosure further comprises a plurality of data signal output lines 40. The data signal output lines 40 comprise a first data signal output line 401 and a second data signal output line 402. In the first pixel circuit column group G1, the first data connecting line L13 is electrically connected to the first data signal output line 401, and the second data connecting line L24 is electrically connected to the second data signal output line 402. The first data connecting line L13 and the second data signal output line 402 are located in different layers.

The structure of the data signal output line 40 and the connection relationship between the first data signal output line 401 and the second data signal output line 402 may be referred to the above embodiments and will not be repeated here.

In this embodiment, as shown in Figs. 7 and 10, in the direction perpendicular to the plane where the display panel is located, the first data connecting line L13 overlaps with the second data signal output line 402. Therefore, by setting the first data connecting line L13 and the second data signal output line 402 in different layers, a short circuit between the first data connecting line L13 and the second data signal output line 402 can be avoided.

Exemplarily, as shown in Figs. 5 and 10, the pixel circuit 10 and the light-emitting element 20 can be arranged on one side of the base substrate 60, the pixel circuit 10 further comprises a storage capacitor Cst, and the storage capacitor Cst comprises a first electrode plate C1 and a second electrode plate C2 that are stacked, where the first electrode plate C1 is located on a side of the second electrode plate C2 close to the base substrate 60.

As shown in Fig. 10, the second data signal output line 402 can be located in the same layer as the first electrode plate C1 and/or the second electrode plate C2, the data signal line 30 can be located in the same layer as the source-drain electrode 3, and the first data connecting line L13 can be located in the same layer as the data signal line 30, which is not limited thereto.

It can be understood that, under the condition of ensuring that the first data connecting line L13 and the second data signal output line 402 are located in different layers, the first data connecting line L13 can be set in the same layer as the existing metal films in the pixel circuit 10, thereby reducing the number of metal layers, which is beneficial to reducing the thickness of the display panel; meanwhile, the first data connecting line L13 can also be prepared in the same process as the existing metal layers in the pixel circuit 10, thereby shortening the process time and reducing manufacturing costs.

Fig. 11 is a schematic structural diagram of a display panel provided by another embodiment of the present disclosure. As shown in Fig. 11, in an embodiment, a plurality of first pixel circuit columns Z1 are divided into a plurality of first pixel circuit column groups G1, and the first pixel circuit column group G1 comprises two first pixel circuit columns Z1 which are respectively a first intra-group pixel circuit column Z11 and a second intra-group pixel circuit column Z12. The first data signal line 301 connected to the first pixel circuits 101 in the first intra-group pixel circuit column Z11 is the first intra-group data signal line L1, the second data signal line 302 connected to the second pixel circuits 102 in the first intra-group pixel circuit column Z11 is the second intra-group data signal line L2, the first data signal line 301 connected to the first pixel circuits 101 in the second intra-group pixel circuit column Z12 is the third intra-group data signal line L3, and the second data signal line 302 connected to the second pixel circuits 102 in the second intra-group pixel circuit column Z12 is the fourth intra-group data signal line L4. In the first pixel circuit column group G1, the first intra-group data signal line L1, the second intra-group data signal line L2, the third intra-group data signal line L3, and the fourth intra-group data signal line L4 are sequentially arranged along the row direction.

The structure of the first intra-group pixel circuit column Z11 and the second intra-group pixel circuit column Z12 in the first pixel circuit column group G1, as well as the connection structure of the first intra-group data signal line L1, the second intra-group data signal line L2, the third intra-group data signal line L3 and the fourth intra-group data signal line L4 can be referred to the above embodiments and will not be repeated here.

In this embodiment, as shown in Fig. 11, the first intra-group data signal line L1 and the third intra-group data signal line L3 are both connected to the first pixel circuits 101, and the first pixel circuits 101 are located in the sub-pixels of the same color; the second intra-group data signal line L2 and the fourth intra-group data signal line L4 are both connected to the second pixel circuits 102, and the second pixel circuits 102 are located in the sub-pixels of the same color.

As shown in Fig. 11, in the first pixel circuit column group G1, the first intra-group data signal line L1, the second intra-group data signal line L2, the third intra-group data signal line L3, and the fourth intra-group data signal line L4 are arranged sequentially along the row direction. Thus, along the row direction, the first intra-group data signal line L1 is located on the left side of the first intra-group pixel circuit column Z11, and the third intra-group data signal line L3 is located on the left side of the second intra-group pixel circuit column Z12; the second intra-group data signal line L2 is located on the right side of the first intra-group pixel circuit column Z11, and the fourth intra-group data signal line L4 is located on the right side of the second intra-group pixel circuit column Z12. That is, the data signal lines 30 connecting sub-pixels of the same color are located on the same side of the first pixel circuit column Z1 connected thereto, such an arrangement can make the positional relationship between the data signal line 30 connecting the sub-pixels of the same color and the first pixel circuit column Z1 connected thereto correspondingly more consistent. In this situation, the parasitic capacitances between the data signal line 30 connecting the sub-pixels of the same color and the metal layers or signal nodes in the first pixel circuit column Z1 connected thereto correspondingly are at similar levels. In the process of preparing the display panel, even if there are process fluctuations, the deviations in the overlapping between the data signal line 30 connecting the sub-pixels of the same color and the metal layers or signal nodes in the first pixel circuit column Z1 connected thereto correspondingly have the same trend of change, thereby improving the display uniformity of the display panel and avoiding the vertical stripe phenomenon caused by brightness differences.

Continue referring to Fig. 11, in an embodiment, the display panel provided in the embodiment of the present disclosure further comprises a non-display region NAA located at least on one side of the display region AA. In the first pixel circuit column group G1, the first intra-group data signal line L1 and the third intra-group data signal line L3 are electrically connected via the first data connecting line L13, the second intra-group data signal line L2 and the fourth intra-group data signal line L4 are electrically connected via the second data connecting line L24, and both the first data connecting line L13 and the second data connecting line L24 are located in the non-display region NAA.

The second data connecting line L24 is located on a side of the first data connecting line L13 close to the display region AA, and the second data connecting line L24 and the third intra-group data signal line L3 are located in different layers.

Or, the first data connecting line L13 is located on a side of the second data connecting line L24 close to the display region AA, and the first data connecting line L13 and the second intra-group data signal line L2 are located in different layers.

The position relationship between the display region AA and the non-display region NAA, the connection relationship between the first intra-group data signal line L1, the second intra-group data signal line L2, the third intra-group data signal line L3, the fourth intra-group data signal line L4, the first data connecting line L13 and the second data connecting line L24 can be referred to the above embodiments and will not be repeated here.

In this embodiment, as shown in Fig. 11, the first data connecting line L13 and the second data connecting line L24 are both located in the non-display region NAA, which can avoid the first data connecting line L13 and the second data connecting line L24 from blocking the display region AA, thereby alleviating the influence of the first data connecting line L13 and the second data connecting line L24 on the display effect.

Further, as shown in Fig. 11, the second data connecting line L24 may be located on a side of the first data connecting line L13 close to the display region AA, and in this case, in a direction perpendicular to the plane where the display panel is located, the second data connecting line L24 overlap with the third intra-group data signal line L3. Therefore, in this embodiment, by arranging the second data connecting line L24 and the third intra-group data signal line L3 in different layers, a short circuit between the first data connecting line L13 and the second data signal output line 402 is avoided.

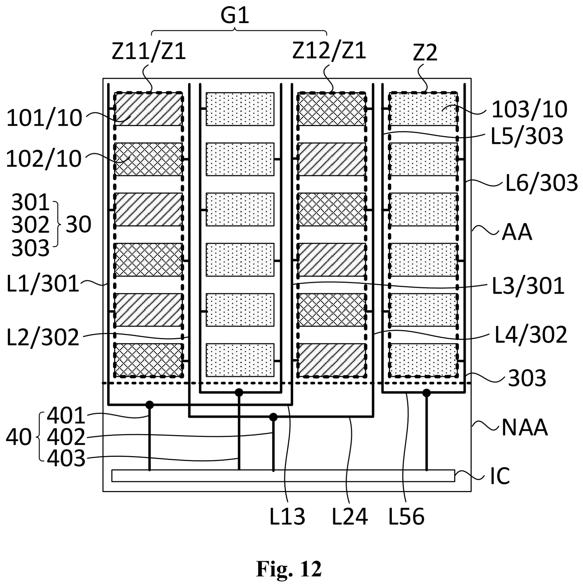

Fig. 12 is a schematic structural diagram of a display panel provided by another embodiment of the present disclosure. As shown in Fig. 12, in an embodiment, the first data connecting line L13 is located on a side of the second data connecting line L24 close to the display region AA. In this situation, in a direction perpendicular to the plane where the display panel is located, the first data connecting line L13 overlaps with the second intra-group data signal line L2. Therefore, in this embodiment, by arranging the first data connecting line L13 and the second intra-group data signal line L2 in different layers, a short circuit between the first data connecting line L13 and the second intra-group data signal line L2 is avoided.

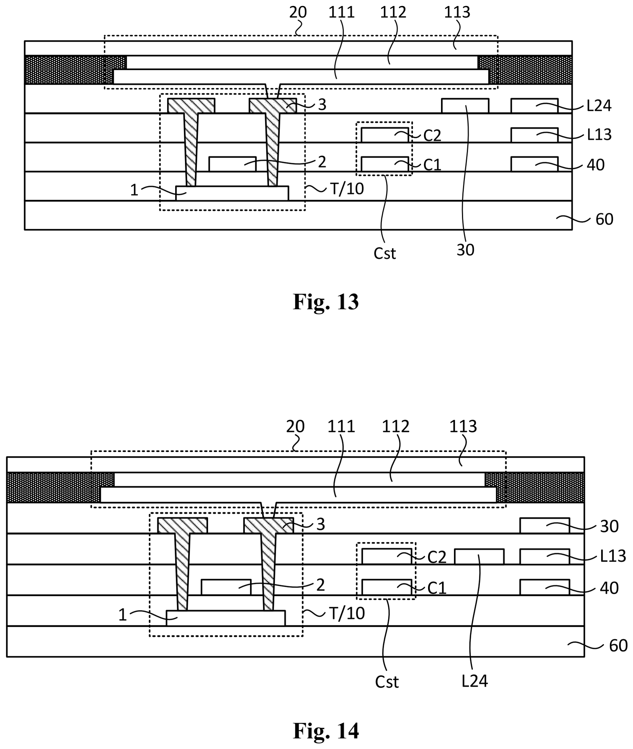

Fig. 13 is a partial cross-sectional diagram of a display panel provided by another embodiment of the present disclosure. As shown in Figs. 12 and 13, in an embodiment, in the first pixel circuit column group G1, the first intra-group data signal line L1 and the third intra-group data signal line L3 are electrically connected via the first data connecting line L13, and the second intra-group data signal line L2 and the fourth intra-group data signal line L4 are electrically connected via the second data connecting line L24. The first data connecting line L13 and the second data connecting line L24 are located in the same layer, or the first data connecting line L13 and the second data connecting line L24 are located in different layers.

The connection relationship between the first intra-group data signal line L1, the second intra-group data signal line L2, the third intra-group data signal line L3, the fourth intra-group data signal line L4, the first data connecting line L13 and the second data connecting line L24 can be referred to the above embodiment and will not be repeated here.

In this embodiment, as shown in Figs. 12 and 13, the first data connecting line L13 and the second data connecting line L24 may be located in different layers.

Exemplarily, as shown in Figs. 12 and 13, the data signal output line 40 can be located in the same layer as the first electrode plate C1, the data signal line 30 can be located in the same layer as the source-drain electrode 3, the second data connecting line L24 can be located in the same layer as the data signal line 30, and the first data connecting line L13 can be located in the same layer as the second electrode plate C2, which is not limited thereto.

Fig. 14 is a partial cross-sectional diagram of a display panel provided in another embodiment of the present disclosure. As shown in Figs. 7 and 14, in an embodiment, the first data connecting line L13 and the second data connecting line L24 may be located in the same layer.

Exemplarily, as shown in Figs. 7 and 14, the data signal output line 40 can be located in the same layer as the first electrode plate C1, the data signal line 30 can be located in the same layer as the source-drain electrode 3, and the second data connecting line L24 and the first data connecting line L13 can both be located in the same layer as the second electrode plate C2, which is not limited thereto.

It should be noted that, under the condition of ensuring that the first data connecting line L13 and the second data connecting line L24 will not short-circuited, the first data connecting line L13 and the second data connecting line L24 can be set in the same layer as the existing metal layers in the pixel circuit 10, thereby reducing the number of metal layers, which is beneficial to reducing the thickness of the display panel; meanwhile, the first data connecting line L13 and the second data connecting line L24 can also be prepared in the same process as the existing metal layers in the pixel circuit 10, thereby shortening the process time and reducing manufacturing costs.

Exemplarily, the first data connecting line L13 may be located in the same layer as the data signal output line 40 and/or located in the same layer as the data signal line 30, which is not limited thereto by the present disclosure.

Similarly, the second data connecting line L24 can be located in the same layer as the data signal output line 40 and/or located in the same layer as the data signal line 30, which is not limited thereto.

The data signal output line 40 may be located in the same layer as the first electrode plate C1 and/or the second electrode plate C2, and the data signal line 30 may be located in the same layer as the source-drain electrode 3, which is not specifically limited in the embodiments of the present disclosure.

Continue referring to Figs. 7 to 12, in an embodiment, the third data signal line 303 comprises a first sub-data signal line L5 and a second sub-data signal line L6. In the row direction, the first sub-data signal line L5 and the second sub-data signal line L6 are located on different sides of the second pixel circuit column Z2.

Specifically, two third data signal lines 303 are correspondingly arranged for one second pixel circuit columns Z2, and the two third data signal lines 303 are respectively a first sub-data signal line L5 and a second sub-data signal line L6.

As shown in Figs. 7 to 12, in the row direction, the first sub-data signal line L5 and the second sub-data signal line L6 are located on different sides of the second pixel circuit column Z2. In the row direction, the first sub-data signal line L5 and the second sub-data signal line L6 are both spaced a certain distance from the second pixel circuit column Z2, which can avoid the formation of parasitic capacitance between the first sub-data signal line L5 and the metal layers of the pixel circuit 10 as well as and between the second sub-data signal line L6 and the metal layers of the pixel circuit 10, in the second pixel circuit column Z2, thereby alleviating the influence of the first sub-data signal line L5 and the second sub-data signal line L6 on the performance of the pixel circuit 10. While in the row direction, there is a large distance between the first sub-data signal line L5 and the second sub-data signal line L6, thereby reducing the mutual interference of data signals between the first sub-data signal line L5 and the second sub-data signal line L6.

In addition, as shown in Figs. 7 to 12, in an embodiment of the present disclosure, a same number of data signal lines 30 are provided between adjacent first pixel circuit columns Z1 and adjacent second pixel circuit columns Z2. For example, two data signal lines 30 are provided between adjacent first pixel circuit columns Z1 and between second pixel circuit columns Z2, so that the data signal lines 30 are more evenly distributed in the row direction, thereby reducing visual interference caused by uneven reflection of light by the data signal lines 30 and improving the overall visual effect of the display panel.

Continue referring to Figs. 7 to 12, in an embodiment, the third data signal line 303 comprises a first sub-data signal line L5 and a second sub-data signal line L6. The first sub-data signal line L5 is electrically connected to the third pixel circuits 103 of odd rows in the second pixel circuit column Z2, and the second sub-data signal line L6 is electrically connected to the third pixel circuits 103 of even rows in the second pixel circuit column Z2.

The structures of the first sub-data signal line L5 and the second sub-data signal line L6 may be referred to the above-mentioned embodiment, which will not be repeated here.

In this embodiment, as shown in Figs. 7 to 12, by setting the first sub-data signal line L5 to be electrically connected to the third pixel circuits 103 of odd rows in the second pixel circuit column Z2, and the second sub-data signal line L6 to be electrically connected to the third pixel circuits 103 of even rows in the second pixel circuit column Z2, the number of pixel circuits 10 connected to each data signal line 30 (for example, the first intra-group data signal line L1, the second intra-group data signal line L2, the third intra-group data signal line L3, the fourth intra-group data signal line L4, the first sub-data signal line L5 and the second sub-data signal line L6) can be the same, so that the capacitive load on each data signal line 30 can be relatively consistent, which is beneficial to ensure that all pixel circuits 10 receive data signals with consistent timing and intensity, thereby helping to improve the display uniformity of the display panel.

Meanwhile, each data signal line 30 has the same number of nodes for connecting to the pixel circuits 10, which can make the pattern distribution of the data signal line 30 more uniform, thereby reducing visual interference caused by uneven light reflection from the data signal line 30 and improving the overall visual effect of the display panel.

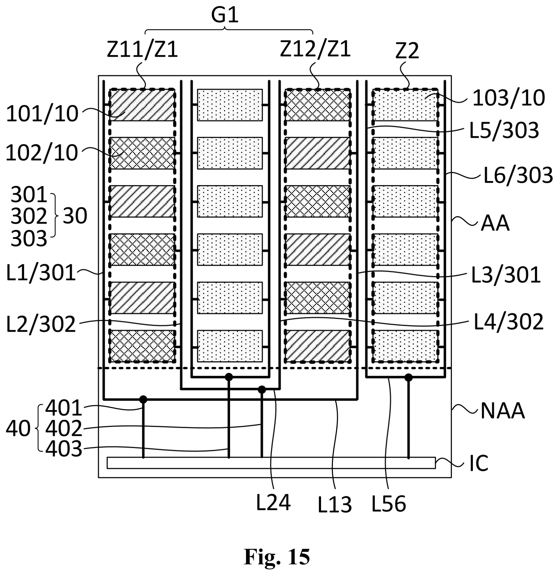

Fig. 15 is a schematic structural diagram of a display panel provided by another embodiment of the present disclosure. As shown in Fig. 15, in an embodiment, the third data signal line 303 comprises a first sub-data signal line L5 and a second sub-data signal line L6. The first sub-data signal line L5 is electrically connected to all third pixel circuits 103 in the second pixel circuit column Z2, and the second sub-data signal line L6 is electrically connected to all third pixel circuits 103 in the second pixel circuit column Z2.

The structure of the first sub-data signal line L5 and the second sub-data signal line L6 may be referred to the above-mentioned embodiment, which will not be repeated here.

In this embodiment, as shown in Fig. 15, the first sub-data signal line L5 is electrically connected to all the third pixel circuits 103 in the second pixel circuit column Z2, and the second sub-data signal line L6 is electrically connected to all the third pixel circuits 103 in the second pixel circuit column Z2, so that data signals can be written to the third pixel circuits 103 via two data signal lines 30 simultaneously, which is beneficial to reducing the line resistance and further reducing the voltage drop on the data signal line 30, ensuring that the third pixel circuit 103 can receive a more stable data signal, while the writing speed of the data signal can also be increased, thereby improving the writing efficiency of the data signal.

Continue referring to Figs. 7 to 9, 11, 12 and 15, in an embodiment, the first sub-data signal line L5 and the second sub-data signal line L6 connected to the same second pixel circuit column Z2 are electrically connected to each other.

By setting the first sub-data signal line L5 and the second sub-data signal line L6 connected to the second pixel circuit column Z2 to be electrically connected to each other, the data signals on the first sub-data signal line L5 and the second sub-data signal line L6 can be provided by the same pin of the IC, thereby reducing the number of the pins providing data signals in the IC, which is beneficial to reducing the size and cost of the IC.

Continue referring to Figs. 7, 9, 11, 12 and 15, in an embodiment, the display panel provided in the embodiment of the present disclosure further comprises a non-display region NAA located at least on one side of the display region AA. The first sub-data signal line L5 and the second sub-data signal line L6 connected to the same second pixel circuit column Z2 are electrically connected to each other via a third data connecting line L56, and the third data connecting line L56 is located in the non-display region NAA.

Specifically, as shown in Figs. 7, 9, 11, 12 and 15, the non-display region NAA may be a lower frame area located on one side of the display region AA along the column direction, which is not limited thereto. The embodiments of the present disclosure does not specifically limit the positional relationship between the display region AA and the non-display region NAA.

In this embodiment, as shown in Figs. 7, 9, 11, 12 and 15, a third data connecting line L56 extending along the row direction is provided to achieve electrical connection between the first sub-data signal line L5 and the second sub-data signal line L6 corresponding to the same second pixel circuit column Z2.

The third data connecting line L56 is located in the non-display region NAA, which can prevent the third data connecting line L56 from blocking the display region AA, thereby alleviating the influence of the third data connecting line L56 on the display effect.

Continue referring to Fig. 8, in an embodiment, the first sub-data signal line L5 and the second sub-data signal line L6 connected to the same second pixel circuit column Z2 are electrically connected to each other via a third data connecting line L56 located in the display region AA.

Specifically, as shown in Fig. 8, by providing a third data connecting line L56 extending along the row direction, the electrical connection between the first sub-data signal line L5 and the second sub-data signal line L6 corresponding to the same second pixel circuit column Z2 is achieved via the third data connecting line L56.

The third data connecting line L56 is located in the display region AA, which is different from the solution of setting the third data connecting line L56 in the non-display region NAA. It can reduce the number of wiring in the non-display region NAA, which is beneficial to reduce the area used for wiring in the non-display region NAA and realize a narrow bezel design.

Continue referring to Fig. 8, in an embodiment, the third data connecting line L56 is located between adjacent rows of pixel circuits 10 in the display region AA, which can avoid the formation of parasitic capacitance between the third data connecting line L56 and the metal layers in the pixel circuit 10, thereby alleviating the influence of the third data connecting line L56 on the performance of the pixel circuit 10, which is not limited thereto.

In other embodiments, along a direction perpendicular to the plane where the display panel is located, the third data connecting line L56 may also at least partially overlaps with the pixel circuit 10, so that the third data connecting line L56 does not need to occupy additional space, which is beneficial to improving the pixel density of the display panel, which are not specifically limited in the embodiments of the present disclosure.

Continue referring to Figs. 7 and 9, in an embodiment, the plurality of first pixel circuit columns Z1 are divided into a plurality of first pixel circuit column groups G1, and the first pixel circuit column group G1 comprises two adjacent first pixel circuit columns Z1 which are respectively a first intra-group pixel circuit column Z11 and a second intra-group pixel circuit column Z12. The first data signal line 301 connected to the first pixel circuits 101 in the first intra-group pixel circuit column Z11 is the first intra-group data signal line L1, the second data signal line 302 connected to the second pixel circuits 102 in the first intra-group pixel circuit column Z11 is the second intra-group data signal line L2, the first data signal line 301 connected to the first pixel circuits 101 in the second intra-group pixel circuit column Z12 is the third intra-group data signal line L3, and the second data signal line 302 connected to the second pixel circuits 102 in the second intra-group pixel circuit column Z12 is the fourth intra-group data signal line L4. In the first pixel circuit column group G1, the first intra-group data signal line L1 is electrically connected to the third intra-group data signal line L3, and the second intra-group data signal line L2 is electrically connected to the fourth intra-group data signal line L4. The first data connecting line L13 and the second data connecting line L24 are both located in the non-display region NAA, the third data connecting line L56 is located on the side of the first data connecting line L13 close to the display region AA, and the second data connecting line L24 is located between the third data connecting line L56 and the first data connecting line L13.

The structure of the first intra-group pixel circuit column Z11 and the second intra-group pixel circuit column Z12 in the first pixel circuit column group G1, as well as the connection relationship between the first intra-group data signal line L1, the second intra-group data signal line L2, the third intra-group data signal line L3, the fourth intra-group data signal line L4, the first data connecting line L13 and the second data connecting line L24 can be referred to the above embodiments and will not be repeated here.

In this embodiment, as shown in Figs. 7 and 9, the first data connecting line L13, the second data connecting line L24 and the third data connecting line L56 are all located in the non-display region NAA, which can avoid the first data connecting line L13, the second data connecting line L24 and the third data connecting line L56 from blocking the display region AA, thereby alleviating the influence of the first data connecting line L13, the second data connecting line L24 and the third data connecting line L56 on the display effect.

Further, as shown in Figs. 7 and 9, in the row direction, the third data connecting line L56, the second data connecting line L24 and the first data connecting line L13 are arranged sequentially on one side of the display region AA, thus in the direction perpendicular to the plane where the display panel is located, the first data connecting line L13 and the second intra-group data signal line L2 and the fourth intra-group data signal line L4 do not overlap, and the second data connecting line L24 do not overlap with the third data signal line 303, thereby reducing the coupling capacitance between different data connecting lines and data signal lines, and reducing mutual interference between different data signals.

Continue referring to Figs. 7, 9, 11, 12 and 15, in an embodiment, the display panel provided in the embodiments of the present disclosure further comprises a plurality of data signal output lines 40. The data signal output lines 40 comprise a first data signal output line 401, a second data signal output line 402 and a third data signal output line 403. In the first pixel circuit column group G1, the first data connecting line L13 is electrically connected to the first data signal output line 401, the second data connecting line L24 is electrically connected to the second data signal output line 402, and the third data connecting line L56 is electrically connected to the third data signal output line 403. The third data signal output line 403 and the first data connecting line L13 are located in different layers, and the third data signal output line 403 and the second data connecting line L24 are located in different layers.

As shown in Figs. 7, 9, 11, 12 and 15, a plurality of data signal output lines 40 are provided on the display panel, and the data signal output lines 40 are electrically connected to the pins of the integrated circuit IC and the data signal lines 30 respectively, and the integrated circuit IC provides data signals to the data signal lines 30 via the data signal output lines 40.

Specifically, as shown in Figs. 7, 9, 11, 12 and 15, the data signal output line 40 comprises a first data signal output line 401, a second data signal output line 402 and a third data signal output line 403. In the first pixel circuit column group G1, the first intra-group data signal line L1 and the third intra-group data signal line L3 are both electrically connected to the same first data signal output line 401. In this situation, the first data signal output line 401 can provide data signals to both the first intra-group data signal line L1 and the third intra-group data signal line L3. Similarly, in the first pixel circuit column group G1, the second intra-group data signal line L2 and the fourth intra-group data signal line L4 are both electrically connected to the same second data signal output line 402. In this situation, the second data signal output line 402 can provide data signals to both the second intra-group data signal line L2 and the fourth intra-group data signal line L4. In the third data signal line 303 connected to the same second pixel circuit column Z2, the first sub-data signal line L5 and the second sub-data signal line L6 are both electrically connected to the same third data signal output line 403. In this situation, the third data signal output line 403 can provide data signals to both the first sub-data signal line L5 and the second sub-data signal line L6.

In this embodiment, as shown in Figs. 7, 9, 11, 12 and 15, in a direction perpendicular to the plane where the display panel is located, the third data signal output line 403 overlaps with the first data connecting line L13, and the third data signal output line 403 overlaps with the second data connecting line L24. Therefore, the third data signal output line 403 and the first data connecting line L13 are located in different layers, and the third data signal output line 403 and the second data connecting line L24 are located in different layers to avoid short circuits between the third data signal output line 403 and the first data connecting line L13, and between the third data signal output line 403 and the second data connecting line L24.

It should be noted that, under the condition of ensuring that the third data signal output line 403 and the first data connecting line L13 are located in different layers, the first data connecting line L13 can be set in the same layer as the existing metal film layers in the pixel circuit 10, thereby reducing the number of metal layers, which is beneficial to reducing the thickness of the display panel; meanwhile, the first data connecting line L13 can also be prepared in the same process as the existing metal film layers in the pixel circuit 10, thereby shortening the process time and reducing manufacturing costs.

Similarly, under the condition of ensuring that the third data signal output line 403 and the second data connecting line L24 are located in different layers, the second data connecting line L24 can be set in the same layer as the existing metal film layers in the pixel circuit 10, thereby reducing the number of metal layers, which is beneficial to reducing the thickness of the display panel; meanwhile, the second data connecting line L24 can also be prepared in the same process as the existing metal film layers in the pixel circuit 10, thereby shortening the process time and reducing manufacturing costs.

In an embodiment, the first data connecting line L13, the second data connecting line L24 and the third data connecting line L56 may be located in the same layer, or at least two of the first data connecting line L13, the second data connecting line L24 and the third data connecting line L56 may be located in different layers.

Under the condition of ensuring that the first data connecting line L13, the second data connecting line L24 and the third data connecting line L56 do not short-circuited, the first data connecting line L13, the second data connecting line L24 and the third data connecting line L56 can be set in the same layer as the existing metal film layers in the pixel circuit 10, thereby reducing the number of metal layers, which is beneficial to reducing the thickness of the display panel; meanwhile, the first data connecting line L13, the second data connecting line L24 and the third data connecting line L56 can also be prepared in the same process as the existing metal film layers in the pixel circuit 10, thereby shortening the process time and reducing the manufacturing cost.

Continue referring to Fig. 9, in an embodiment, the display panel provided in the embodiment of the present disclosure further comprises a plurality of data signal output lines 40 and a plurality of gating circuits 50, the data signal output line 40 comprise a third data signal output line 403, and the gating circuit 50 comprises a third gating circuit 503. In the first sub-data signal line L5 and the second sub-data signal line L6 connected to the same second pixel circuit column Z2, the first sub-data signal line L5 and the second sub-data signal line L6 are electrically connected to the same third data signal output line 403 via the third gating circuit 503, and the third gating circuit 503 is configured to transmit the data signal output by the third data signal output line 403 to the first sub-data signal line L5 and the second sub-data signal line L6 in a time-division manner.

As shown in Fig. 9, a plurality of data signal output lines 40 are provided on the display panel. The data signal output lines 40 are electrically connected to the pins of the integrated circuit IC and the data signal lines 30, respectively. The integrated circuit IC provides data signals to the data signal lines 30 via the data signal output lines 40.

The data signal output line 40 comprises a third data signal output line 403. In the third data signal lines 303 connected to the same second pixel circuit column Z2, the first sub-data signal line L5 and the second sub-data signal line L6 are both electrically connected to the same third data signal output line 403. In this situation, the third data signal output line 403 can provide data signals to both the first sub-data signal line L5 and the second sub-data signal line L6.

Continue referring to Fig. 9, one third data signal output line 403 needs to provide data signals to the first sub-data signal line L5 and the second sub-data signal line L6 simultaneously, thus the capacitive load (loading) on the pin of the integrated circuit IC comprises the parasitic capacitance of the pixel circuit 10 connected to the first sub-data signal line L5 and the second sub-data signal line L6, which will cause a problem of large capacitive load. The larger the capacitive load, the more energy required for charging and discharging, and the higher the power consumption.

Based on the above technical problems, in this embodiment, as shown in Fig. 9, a plurality of gating circuits 50 are further provided on the display panel, and the gating circuit 50 are configured to transmit the data signals from the data signal output lines 40 to different data signal lines 30 in a time-division manner, so that at the same timing point, the gating circuit 50 will selectively transmit a data signal to one data signal line 30, ensuring that each pin of the integrated circuit IC only provides a data signal to one data signal line 30 at any time, thereby effectively reducing the capacitive load on the pin of the integrated circuit IC, and reducing power consumption.

Specifically, as shown in Fig. 9, the gating circuit 50 comprises a third gating circuit 503. In the first sub-data signal line L5 and the second sub-data signal line L6 connected to the same second pixel circuit column Z2, the first sub-data signal line L5 and the second sub-data signal line L6 are both electrically connected to the same third data signal output line 403 via the third gating circuit 503, so that the data signal output by the third data signal output line 403 is transmitted to the first sub-data signal line L5 and the second sub-data signal line L6 in a time-division manner via the third gating circuit 503, ensuring that the pin of the integrated circuit IC connected to the third data signal output line 403 only provides data signals to the first sub-data signal line L5 or the second sub-data signal line L6 at any time, thereby reducing the capacitive load on pin of the integrated circuit IC and further reducing power consumption.

Continue referring to Fig. 9, in an embodiment, the data signal output line 40, the gating circuit 50 and the integrated circuit IC are all located in the non-display region NAA, which can avoid the data signal output line 40, the gating circuit 50 and the integrated circuit IC from blocking the display region AA, thereby alleviating the influence of the data signal output line 40, the gating circuit 50 and the integrated circuit IC on the display effect.

In other embodiments, the integrated circuit IC may also be disposed on a flexible circuit board bound and connected to the display panel, which is beneficial to reducing the area of the non-display region NAA and realizing a narrow bezel design, which are not specifically limited in the embodiments of the present disclosure.

Continuing referring to Fig. 9, in an embodiment, the data signal output lines 40 extend in the column direction and are arranged in the row direction, which facilitates the electrical connection between the data signal output line 40 and the pin of the integrated circuit IC and the data signal line 30 while avoiding short circuits between different data signal output lines 40, which are not limited thereto and not specifically limited in the embodiments of the present disclosure.

Continuing referring to Fig. 9, in an embodiment, the third gating circuit 503 comprises a fifth switching transistor M5 and a sixth switching transistor M6, the fifth switching transistor M5 is connected between the first sub-data signal line L5 and the third data signal output line 403, and the sixth switching transistor M6 is connected between the second sub-data signal line L6 and the third data signal output line 403. A gate of the fifth switching transistor M5 receives a third switching signal, and a gate of the sixth switching transistor L6 receives a fourth switching signal.

Specifically, as shown in Fig. 9, the third gating circuit 503 comprises the fifth switching transistor M5 and the sixth switching transistor M6, one end of the fifth switching transistor M5 is connected to the first sub-data signal line L5, and the other end is connected to the third data signal output line 403.

Furthermore, the gate of the fifth switching transistor M5 receives the third switching signal used to control the fifth switching transistor M5 to be turned on or off. When the fifth switching transistor M5 is turned on, the first sub-data signal line L5 and the third data signal output line 403 are connected to each other. In this situation, the third data signal output line 403 provides a data signal to the first sub-data signal line L5; when the fifth switching transistor M5 is turned off, the first sub-data signal line L5 and the third data signal output line 403 are insulated from each other.

The gate of the sixth switching transistor M6 receives the fourth switching signal used to control the sixth switching transistor M6 to be turned on or off. When the sixth switching transistor M6 is turned on, the second sub-data signal line L6 and the third data signal output line 403 are connected to each other. In this situation, the third data signal output line 403 provides a data signal to the second sub-data signal line L6; when the sixth switching transistor M6 is turned off, the second sub-data signal line L6 and the third data signal output line 403 are insulated from each other.

The gate of the fifth switching transistor M5 and the gate of the sixth switching transistor M6 receive different third switching signals and fourth switching signals, so that the fifth switching transistor M5 and the sixth switching transistor M6 are turned on in a time-division manner, thereby realizing the transmission of the data signal output by the third data signal output line 403 to the first sub-data signal line L5 and the second sub-data signal line L6 in a time-division manner, ensuring that the pin of the integrated circuit IC connected to the third data signal output line 403 only provides the data signal to either the first sub-data signal line L5 or the second sub-data signal line L6 at any time, thereby reducing the capacitive load on pin of the integrated circuit IC and reducing power consumption.

Further, as shown in Fig. 9, the first pixel circuit 101 connected to the first intra-group data signal line L1, the second pixel circuit 102 connected to the fourth intra-group data signal line L4, and the third data signal line 303 connected to the first sub-data signal line L5 are located in the same pixel circuit row. Therefore, the third switching signal received by the gate of the fifth switching transistor M5 can be set to be the same switching signal as the first switching signal SW1 received by the gate of the first switching transistor M1 and the gate of the fourth switching transistor M4, so that the fifth switching transistor M5, the first switching transistor M1 and the fourth switching transistor M4 are turned on simultaneously, ensuring that the first pixel circuit 101, the second pixel circuit 102 and the third pixel circuit 103 located in the same row receive the data signal simultaneously. Such a setting can reduce the number of switching signals, simplify the control logic, and help reduce the number of switching signal lines that transmit switching signals, thereby reducing costs.

Similarly, the second pixel circuit 102 connected to the second intra-group data signal line L2, the first pixel circuit 101 connected to the third intra-group data signal line L3, and the third data signal line 303 connected to the second sub-data signal line L6 are located in the same pixel circuit row. Therefore, the fourth switching signal received by the gate of the sixth switching transistor M6 and the second switching signal SW2 received by the gate of the second switching transistor M2 and the gate of the third switching transistor M3 can be set to be the same switching signal, so that the sixth switching transistor M6, the second switching transistor M2 and the third switching transistor M3 are turned on simultaneously, ensuring that the first pixel circuit 101, the second pixel circuit 102 and the third pixel circuit 103 located in the same row receive the data signal simultaneously. Such a setting can reduce the number of switching signals, simplify the control logic, and help reduce the number of switching signal lines that transmit switching signals, thereby reducing costs.

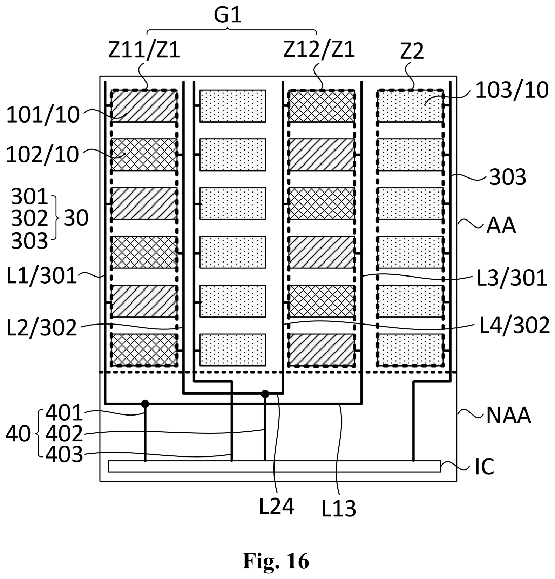

Fig. 16 is a schematic structural diagram of a display panel provided by another embodiment of the present disclosure. As shown in Fig. 16, in an embodiment, the third pixel circuits 103 in the second pixel circuit column Z2 are electrically connected to only one third data signal line 303.

In this embodiment, as shown in Fig. 16, each second pixel circuit column Z2 is only provided with one third data signal line 303, so that the number of the third data signal lines 303 can be reduced, which is beneficial to increasing the light transmission area of the display panel. Meanwhile, the coverage area of the third data signal line 303 is reduced, which is beneficial to increasing the distance between the third data signal line 303 and other signal lines, thereby reducing the coupling effect between the third data signal line 303 and other signal lines, and reducing the mutual interference between the signal lines.

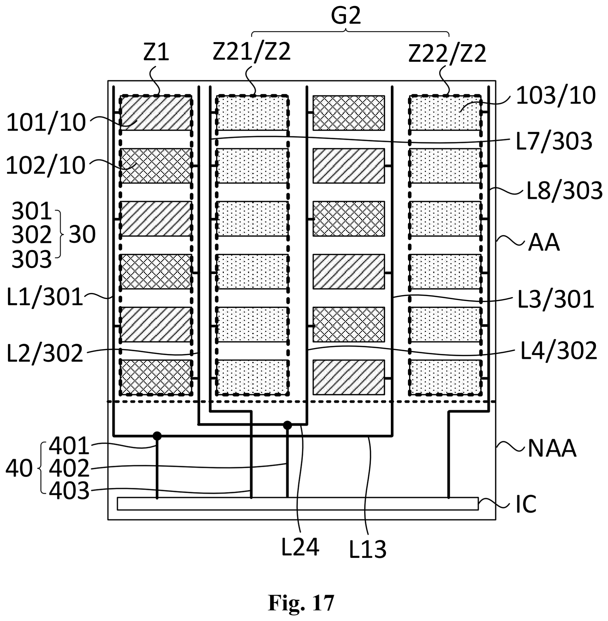

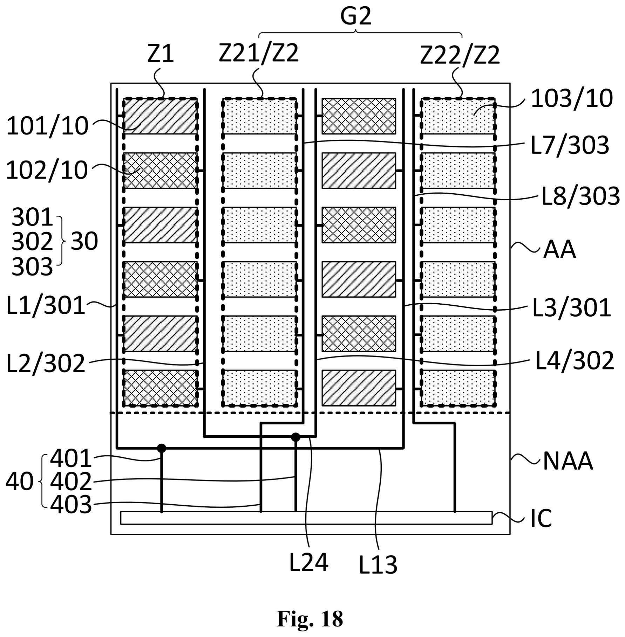

Fig. 17 is a schematic structural diagram of a display panel provided by another embodiment of the present disclosure, and Fig. 18 is a schematic structural diagram of a display panel provided by another embodiment of the present disclosure. As shown in Figs. 17 and 18, in an embodiment, a plurality of second pixel circuit columns Z2 are divided into a plurality of second pixel circuit column groups G2, and the second pixel circuit column group G2 comprises two adjacent second pixel circuit columns Z2 which are respectively a third intra-group pixel circuit column Z21 and a fourth intra-group pixel circuit column Z22. The third data signal line 303 connected to the third intra-group pixel circuit column Z21 is the fifth intra-group data signal line L7, and the third data signal line 303 connected to the fourth intra-group pixel circuit column Z22 is the sixth intra-group data signal line L8.

In the second pixel circuit column group G2, the fifth intra-group data signal line L7 is located on the side of the third intra-group pixel circuit column Z21 away from the fourth intra-group pixel circuit column Z22, and the sixth intra-group data signal line L8 is located on the side of the fourth intra-group pixel circuit column Z22 away from the third intra-group pixel circuit column Z21.

Or, in the second pixel circuit column group G2, the fifth intra-group data signal line L7 is located on the side of the third intra-group pixel circuit column Z21 close to the fourth intra-group pixel circuit column Z22, and the sixth intra-group data signal line L8 is located on the side of the fourth intra-group pixel circuit column Z22 close to the third intra-group pixel circuit column Z21.

Specifically, as shown in Figs. 17 and 18, in the display region AA, a plurality of second pixel circuit column groups G2 are arranged along the row direction, the second pixel circuit column group G2 comprises a third intra-group pixel circuit column Z21 and a fourth intra-group pixel circuit column Z22 that are adjacently arranged, the third intra-group pixel circuit column Z21 comprises third pixel circuits 103 sequentially arranged along the column direction, and the fourth intra-group pixel circuit column Z22 comprises third pixel circuits 103 sequentially arranged along the column direction.

In this embodiment, the third pixel circuits 103 in the third intra-group pixel circuit column Z21 are all connected to the fifth intra-group data signal line L7, and the third pixel circuits 103 in the fourth intra-group pixel circuit column Z22 are all connected to the sixth intra-group data signal line L8.

As shown in Fig. 17, along the row direction, in the second pixel circuit column group G2, the fifth intra-group data signal line L7 is located on the side of the third intra-group pixel circuit column Z21 away from the fourth intra-group pixel circuit column Z22, and the sixth intra-group data signal line L8 is located on the side of the fourth intra-group pixel circuit column Z22 away from the third intra-group pixel circuit column Z21, thus the fifth intra-group data signal line L7 and the sixth intra-group data signal line L8 are respectively located on the opposite sides of the two second pixel circuit columns Z2 in the second pixel circuit column group G2. In this way, the fifth intra-group data signal line L7 and the sixth intra-group data signal line L8 can be symmetrically distributed relative to the central axis of the second pixel circuit column group G2, which is conducive to making the color deviation of the display screen have better symmetry, thereby mitigating the color deviation at different viewing directions, that is, no matter from which direction the display screen is viewed, the consistency and accuracy of the color will be improved, and thus the display screen can be viewed from a wider angle range without feeling obvious color changes, thereby enhancing the user experience.

As shown in Fig. 18, along the row direction, in the second pixel circuit column group G2, the fifth intra-group data signal line L7 is located on the side of the third intra-group pixel circuit column Z21 close to the fourth intra-group pixel circuit column Z22, and the sixth intra-group data signal line L8 is located on the side of the fourth intra-group pixel circuit column Z22 close to the third intra-group pixel circuit column Z21, thus the fifth intra-group data signal line L7 and the sixth intra-group data signal line L8 are both located between the third intra-group pixel circuit column Z21 and the fourth intra-group pixel circuit column Z22. In this way, the fifth intra-group data signal line L7 and the sixth intra-group data signal line L8 can be symmetrically distributed relative to the central axis of the second pixel circuit column group G2, which is conducive to making the color deviation of the display screen have better symmetry, thereby mitigating the color deviation at different viewing directions, that is, no matter from which direction the display screen is viewed, the consistency and accuracy of the color will be improved, and the display screen can be viewed from a wider angle range without feeling obvious color changes, thereby enhancing the user experience.

It should be noted that the central axis of the second pixel circuit column group G2 is a central axis extending along the column direction.

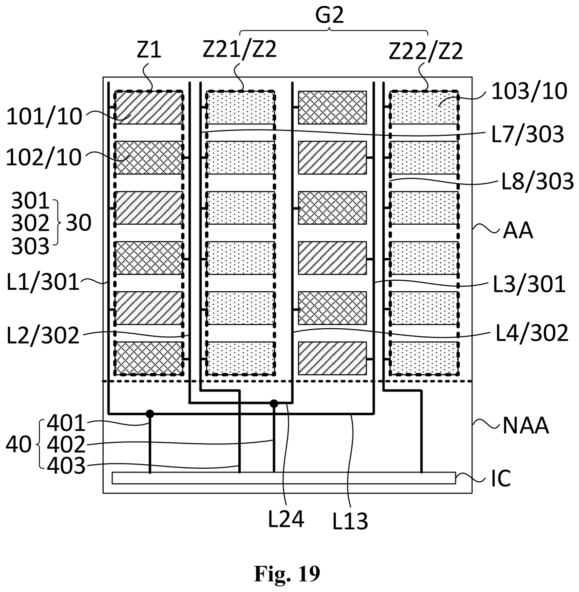

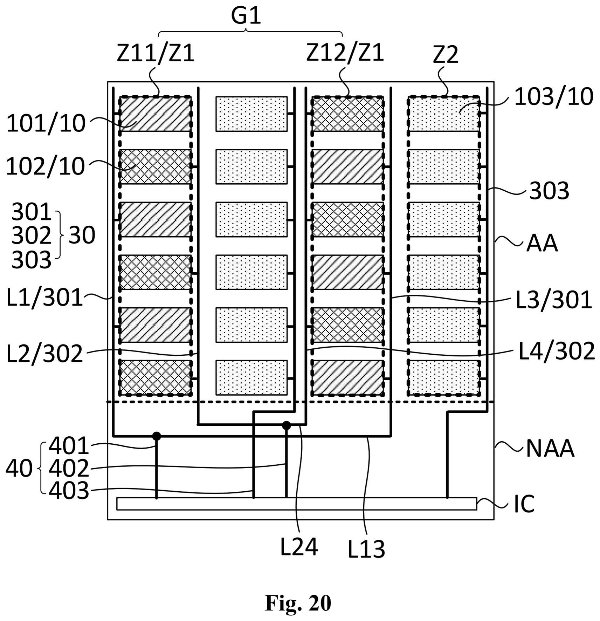

Fig. 19 is a schematic structural diagram of a display panel provided by another embodiment of the present disclosure, and Fig. 20 is a schematic structural diagram of a display panel provided by another embodiment of the present disclosure. As shown in Figs. 19 and 20, in an embodiment, a plurality of second pixel circuit columns Z2 are divided into a plurality of second pixel circuit column groups G2, and the second pixel circuit column group G2 comprises two adjacent second pixel circuit columns Z2 which are respectively a third intra-group pixel circuit column Z21 and a fourth intra-group pixel circuit column Z22. The third data signal line 303 connected to the third intra-group pixel circuit column Z21 is the fifth intra-group data signal line L7, and the third data signal line 303 connected to the fourth intra-group pixel circuit column Z22 is the sixth intra-group data signal line L8.

In the second pixel circuit column group G2, the fifth intra-group data signal line L7 is located on the side of the third intra-group pixel circuit column Z21 away from the fourth intra-group pixel circuit column Z22, and the sixth intra-group data signal line L8 is located on the side of the fourth intra-group pixel circuit column Z22 close to the third intra-group pixel circuit column Z21.

Or, in the second pixel circuit column group G2, the fifth intra-group data signal line L7 is located on the side of the third intra-group pixel circuit column Z21 close to the fourth intra-group pixel circuit column Z22, and the sixth intra-group data signal line L8 is located on the side of the fourth intra-group pixel circuit column Z22 away from the third intra-group pixel circuit column Z21.

The structures of the third intra-group pixel circuit column Z21 and the fourth intra-group pixel circuit column Z22 in the second pixel circuit column group G2, and the connection structure of the fifth intra-group data signal line L7 and the sixth intra-group data signal line L8 can be referred to the above embodiments and will not be repeated here.

In this embodiment, as shown in Fig. 19, in the second pixel circuit column group G2, the fifth intra-group data signal line L7 is located on the side of the third intra-group pixel circuit column Z21 away from the fourth intra-group pixel circuit column Z22, and the sixth intra-group data signal line L8 is located on the side of the fourth intra-group pixel circuit column Z22 close to the third intra-group pixel circuit column Z21. Thus, along the row direction, the fifth intra-group data signal line L7 is located on the left side of the third intra-group pixel circuit column Z21, and the sixth intra-group data signal line L8 is located on the left side of the fourth intra-group pixel circuit column Z22, that is, the third data signal lines 303 are all located on the same side of the second pixel circuit column Z2 connected thereto.

Such an arrangement can make the positional relationship between the third data signal line 303 and the second pixel circuit column Z2 connected thereto more consistent. In this situation, the parasitic capacitance between the third data signal line 303 and the metal layers or signal nodes in the second pixel circuit column Z2 connected thereto are at a similar level. In the process of preparing the display panel, even if there are process fluctuations, the deviations in the overlapping between the third data signal line 303 and the metal layers or signal nodes in the second pixel circuit column Z2 connected thereto have a same trend change, thereby improving the display uniformity of the display panel and avoiding vertical stripes caused by brightness differences.

Continuing referring to Fig. 20, in the second pixel circuit column group G2, the fifth intra-group data signal line L7 is located on the side of the third intra-group pixel circuit column Z21 close to the fourth intra-group pixel circuit column Z22, and the sixth intra-group data signal line L8 is located on the side of the fourth intra-group pixel circuit column Z22 away from the third intra-group pixel circuit column Z21. Thus, along the row direction, the fifth intra-group data signal line L7 is located on the right side of the third intra-group pixel circuit column Z21, and the sixth intra-group data signal line L8 is located on the right side of the fourth intra-group pixel circuit column Z22, that is, the third data signal lines 303 are all located on the same side of the second pixel circuit column Z2 connected thereto.

Such an arrangement can make the positional relationship between the third data signal line 303 and the second pixel circuit column Z2 connected thereto more consistent. In this situation, the parasitic capacitance between the third data signal line 303 and the metal layers or signal nodes in the second pixel circuit column Z2 connected thereto are at a similar level. In the process of preparing the display panel, even if there are process fluctuations, the deviations in the overlapping between the third data signal line 303 and the metal layers or signal nodes in the second pixel circuit column Z2 connected thereto have a same trend change, thereby improving the display uniformity of the display panel and avoiding vertical stripes caused by brightness differences.

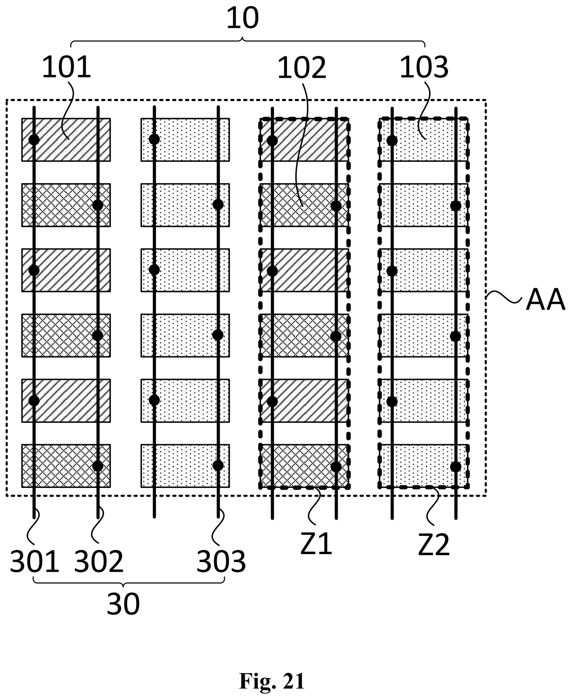

Fig. 21 is a structural schematic diagram of a display panel provided by another embodiment of the present disclosure. As shown in Fig. 21, in an embodiment, in the direction perpendicular to the plane where the display panel is located, the first data signal line 301 and the second data signal line 302 both overlap with the first pixel circuit column Z1, and the third data signal line 303 overlaps with the second pixel circuit column Z2.

Specifically, as shown in Fig. 21, in the direction perpendicular to the plane where the display panel is located, the first data signal line 301 and the second data signal line 302 overlap with the first pixel circuit column Z1, and the third data signal line 303 overlaps with the second pixel circuit column Z2, thereby avoiding the first data signal line 301, the second data signal line 302 and the third data signal line 303 from occupying additional space, which is beneficial to improving the pixel density of the display panel.

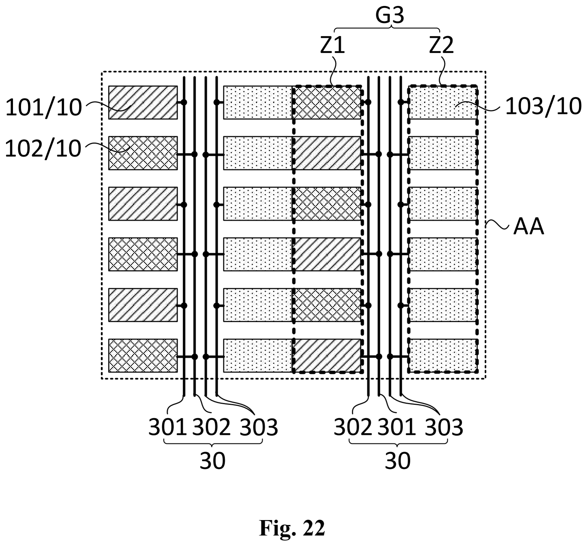

Fig. 22 is a structural schematic diagram of a display panel provided by another embodiment of the present disclosure. As shown in Fig. 22, in an embodiment, a plurality of first pixel circuit columns Z1 and a plurality of second pixel circuit columns Z2 are divided into a plurality of third pixel circuit column groups G3, and the third pixel circuit column groups G3 comprise a first pixel circuit column Z1 and a second pixel circuit column Z2 adjacent to each other along the row direction, and the adjacent first pixel circuit column Z1 and second pixel circuit column Z2 are in a mirror-symmetrical pattern.

Specifically, as shown in Fig. 22, in the display region AA, a plurality of third pixel circuit column groups G3 are arranged along the row direction, the third pixel circuit column group G3 comprises a first pixel circuit column Z1 and a second pixel circuit column Z2 that are adjacently arranged, the first pixel circuit column Z1 comprises first pixel circuits 101 and second pixel circuits 102 alternately arranged along the column direction, and the second pixel circuit column Z2 comprises third pixel circuits 103 arranged sequentially along the column direction.

In the third pixel circuit column group G3, the first pixel circuit column Z1 and second pixel circuit column Z2 that are adjacently arranged are in a mirror-symmetrical pattern. In this situation, in the same row of pixel circuits 10, the pixel circuit 10 located in the first pixel circuit column Z1 and the pixel circuit 10 located in the second pixel circuit column Z2 are adjacent and in a mirror-symmetrical pattern. Thus, when the two pixel circuits 10 are connected to some signal lines, the two pixel circuits 10 can share a connecting via hole, thereby reducing the number of holes, which helps to improve the transmittance of the display panel. When an optical sensor device such as an under-screen fingerprint recognition module is provided in the display panel, it helps to improve the performance of the optical sensor device.

Exemplarily, taking the pixel circuit 10 shown in Fig. 4 as an example, the pixel circuit 10 may comprise a first light-emitting control transistor T1, a data writing transistor T2, a driving transistor T3, a threshold compensation transistor T4, an initialization reset transistor T5, a second light-emitting control transistor T6, an anode reset transistor T7, a bias transistor T8 and a storage capacitor Cst.

One end of the initialization reset transistor T5 is configured to receive a first reference signal VREF1, the other end of the initialization reset transistor T5 is connected to a gate of the driving transistor T3 at a first node N1, a gate of the initialization reset transistor T5 receives a first scanning signal S1N used to control the initialization reset transistor T5 turning on and off. When the initialization reset transistor T5 is turned on, the first reference signal VREF1 is written to the gate of the driving transistor T3 to reset the first node N1.

The storage capacitor Cst is configured to receive a first power signal, and the other plate of the storage capacitor Cst is connected to the first node N1. The storage capacitor Cst can ensure that the potential of the first node N1 is stable.

The threshold compensation transistor T4 is connected between the gate of the driving transistor T3 (i.e., the first node N1) and a second end of the driving transistor T3 (i.e., a third node N3). A gate of the threshold compensation transistor T4 receives a second scanning signal S2N used to control the threshold compensation transistor T4 turning on and off. When the threshold compensation transistor T4 is turned on, it can compensate for the threshold voltage of the driving transistor T3.

One end of the data writing transistor T2 is configured to receive the data signal DATA, and the other end of the data writing transistor T2 is connected to the first end of the driving transistor T3 (i.e., the second node N2). The gate of the data writing transistor T2 is configured to receive a third scanning signal SP used to control the data writing transistor T2 turning on and off. When the data writing transistor T2 is turned on, the data signal DATA can be written to the gate of the driving transistor T3.

One end of the anode reset transistor T7 is configured to receive a second reference signal VREF2, the other end of the anode reset transistor T7 is connected to the anode of the light-emitting element 20, the gate of the anode reset transistor T7 is configured to receive a fourth scanning signal SPX used to control the anode reset transistor T7 turning on and off, and the anode reset transistor T7 can write the second reference signal VREF2 to the anode of the light-emitting element 20 when it is turned on.

One end of the first light-emitting control transistor T1 is configured to receive a positive power voltage PVDD, and the other end of the first light-emitting control transistor T1 is connected to the first end of the driving transistor T3 (i.e., the second node N2); one end of the second light-emitting control transistor T6 is configured to receive a negative power voltage PVEE, and the other end of the second light-emitting control transistor T6 is connected to the second end of the driving transistor T3 (i.e., the third node N3). The gate of the first light-emitting control transistor T1 and the gate of the second light-emitting control transistor T6 are configured to receive a light-emitting control signal EM used to control the first light-emitting control transistor T1 and the second light-emitting control transistor T6 turning on and off. When the first light-emitting control transistor T1 and the second light-emitting control transistor T6 are turned on, the positive power voltage PVDD and the negative power voltage PVEE can both be fed to the light-emitting element 20, thereby realizing the light emission and display of the light-emitting element 20.

One end of the bias transistor T8 is configured to receive a bias signal DVH, and the other end of the bias transistor T8 is connected to the first end of the driving transistor T3 (i.e., the second node N2) or the second end of the driving transistor T3 (i.e., the third node N3). The gate of the bias transistor T8 is configured to receive a fourth scanning signal SPX used to control the bias transistor T8 turning on and off. When the bias transistor T8 is turned on, the bias transistor T8 writes the bias signal DVH into the first end of the driving transistor T3 (i.e., the second node N2) and/or the second end of the driving transistor T3 (i.e., the third node N3).

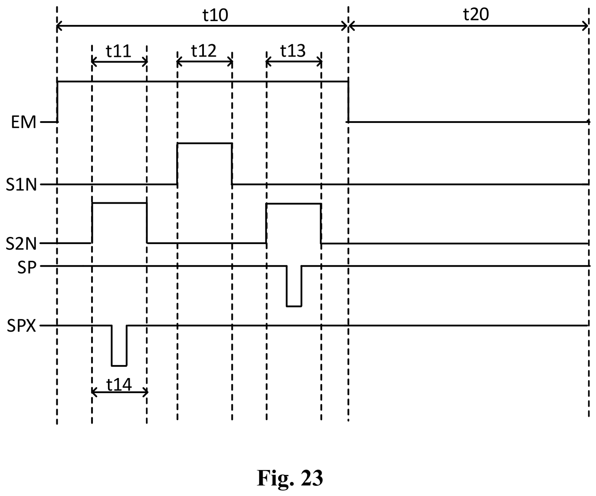

Fig. 23 is a timing diagram of signals provided to the pixel circuit shown in Fig. 4 in a driving cycle according to an embodiment of the present disclosure. As shown in Figs. 4 and 23, illustratively, the operation process of the pixel circuit 10 may comprise a pre-stage t10 and a light-emitting stage t20. The pre-stage t10 is a stage in which the light-emitting element 20 does not emit light, and the light-emitting stage t20 is a stage in which the light-emitting element 20 emits light. In some cases, the pre-stage t10 and the light-emitting stage t20 may be proceed sequentially.

Specifically, as shown in Figs. 4 and 23, in the pre-stage t10, the light-emitting control signal EM is an ineffective pulse, and the first light-emitting control transistor T1 and the second light-emitting control transistor T6 are turned off under the action of the light-emitting control signal EM, in this situation, the light-emitting element 20 does not emit light. In the light-emitting stage t20, the light-emitting control signal EM is an effective pulse, and the first light-emitting control transistor T1 and the second light-emitting control transistor T6 are turned on under the action of the light-emitting control signal EM, in this situation, a driving current generated by the driving transistor T3 can be transmitted to the light-emitting element 20, thereby controlling the light-emitting element 02 to enter the light-emitting stage and emit light.

It should be noted that the effective pulse of the light-emitting control signal EM can be set according to the channel types of the first light-emitting control transistor T1 and the second light-emitting control transistor T6.

Exemplarily, as shown in Figs. 4 and 23, when the first light-emitting control transistor T1 and the second light-emitting control transistor T6 are both PMOS transistors, the ineffective pulse of the light emission control signal EM is at a high level, and the effective pulse of the light emission control signal EM is at a low level.

In other embodiments, if the first light-emitting control transistor T1 and the second light-emitting control transistor T6 are NMOS transistors, the ineffective pulse of the light-emitting control signal EM is a low level, and the effective pulse of the light-emitting control signal EM is a high level, which are not specifically limited in the embodiments of the present disclosure.

Continue referring to Figs. 4 and 23, in an embodiment, the pre-stage t10 of the pixel circuit 10 may comprise an initialization stage t11.

In the initialization stage t11, the fourth scanning signal SPX is an effective pulse at a low level, so that the anode reset transistor T7 is turned on, and the second reference signal VREF2 is transmitted to the anode of the light-emitting element 20 via the anode reset transistor T7 to initialize the anode of the light-emitting element 20, thereby preventing the driving current provided to the anode of the light-emitting element 20 in the previous frame from affecting the display luminous brightness of the light-emitting element 20 in the next frame.

Continue referring to Figs. 4 and 23, in an embodiment, the pre-stage t10 of the pixel circuit 10 may comprise a reset stage t12.

In the reset stage t12, the first scanning signal S1N is an effective signal of a high level, so that the initialization reset transistor T5 is turned on, and the first reference signal VREF1 is transmitted to the gate of the driving transistor T3 (that is, the first node N1) via the turned-on initialization reset transistor T5, thereby resetting the gate of the driving transistor T3. In this situation, the gate potential of the driving transistor T3 is consistent with the potential of the first reference signal VREF 1, so as to avoid the data signal of the previous frame carried on the gate of the driving transistor T3 affecting the writing of the data signal of the next frame.

Continue referring to Figs. 4 and 23, in an embodiment, the pre-stage t10 of the pixel circuit 10 may further comprise a data writing stage t13.

In the data writing stage t13, the third scanning signal SP is a low-level effective pulse, and the second scanning signal S2N is a high-level effective pulse, so that the data writing transistor T2 and the threshold compensation transistor T4 are turned on. Meanwhile, the gate potential of the driving transistor T3 is consistent with the first reference signal VREF1, and the driving transistor T3 is also turned on. The data signal passes through the data writing transistor T2, the driving transistor T3 and the threshold compensation transistor T4, and is applied to the gate of the driving transistor T3 (i.e., the first node N1), and the potential of the first node N1 is gradually increased until the driving transistor T3 is turned off. When the driving transistor T3 is turned off, the gate potential of the driving transistor T3 is Vdata-|Vth|, where Vdata is the voltage of the data signal DATA, and |Vth| is the threshold voltage of the driving transistor T3.

Continue referring to Figs. 4 and 23, in an embodiment, after the data writing stage t13 ends, the display panel may enter a light-emitting stage t20.

In the light-emitting stage t20, the light-emitting control signal EM is an effective pulse at a low level, the first light-emitting control transistor T1 and the second light-emitting control transistor T6 are turned on. Since the first light-emitting control transistor T1 is turned on, the positive power voltage PVDD is transmitted to the first end of the driving transistor T3 (i.e., the second node N2), and the voltage difference between the first end of the driving transistor T3 (i.e., the second node N2) and its gate (i.e., the first node N1) is PVDD-(Vdata-[Vth|), so that the driving current generated by the driving transistor T3 is K*(Vdata-PVDD)2, where K is a coefficient related to the size and material of the driving transistor T3. In this way, the driving current generated by the driving transistor T3 is independent of its own threshold voltage |Vth|, and the driving current is transmitted to the anode of the light-emitting element 20 via the turned-on second light-emitting control transistor T6, so that the light-emitting element 20 emits light.

Continue referring to Figs. 4 and 23, in an embodiment, the pre-stage t10 of the pixel circuit 10 may further comprise a bias adjustment stage t14.

In the bias adjustment stage t14, the fourth scanning signal SPX is an effective pulse at a low level, so that the bias transistor T8 is turned on, and the bias signal DVH is input to the first end (i.e., the second node N2) or the second end (i.e., the third node N3) of the driving transistor T3 via the bias transistor T8, so as to adjust the voltage difference between the gate (i.e., the first node N1) and the first end (i.e., the second node N2) or the second end (i.e., the third node N3) of the driving transistor T3, thereby eliminating the reverse electric field generated inside the driving transistor T3, solving the bias problem, and avoiding the threshold voltage of the driving transistor T3 from shifting, which is conducive to reducing the flicking.

Continue referring to Figs. 4 and 23, in the bias adjustment stage t14, the second scanning signal S2N can be an effective pulse of a high level, so that the threshold compensation transistor T4 is turned on. In this situation, the bias signal DVH can be transmitted to the gate of the driving transistor T3 (i.e., the first node N1) via the threshold compensation transistor T4, so that the gate of the driving transistor T3 (i.e., the first node N1) is consistent with the potential of the first end (i.e., the second node N2) or the second end (i.e., the third node N3), which can further improve the threshold voltage offset phenomenon of the driving transistor T3, thereby reducing flickering.

The bias adjustment stage t14 may be located before the data writing stage t13 or after the data writing stage t13, which is not specifically limited in the embodiments of the present disclosure.

It can be understood that the types of transistors in the pixel circuit 10 and the corresponding driving process are exemplarily described above. In the embodiments of the present disclosure, when the types of transistors in the pixel circuit 10 are changed, a driving process similar to the above can be realized by changing the signal received by the gate of each transistor, which will not be repeated here.

Furthermore, the types of transistors in the pixel circuit 10 may be diversed, for example, all transistors may be low temperature poly-silicon (LTPS) transistors, or all transistors may be oxide (IGZO) transistors, or some may be low temperature poly-silicon transistors and the other may be oxide transistors. Low temperature poly-silicon transistors have the advantages of high speed in turning on and off, high carrier mobility and low power, while oxide transistors have the advantages of low leakage current.

The low-temperature polycrystalline oxide (LTPO) display panel that combines LTPO with oxide not only has the advantages of high resolution, high response speed, high brightness, high aperture ratio, etc. of the low-temperature polycrystalline silicon display panel, but also has the advantage of low leakage current of oxide.

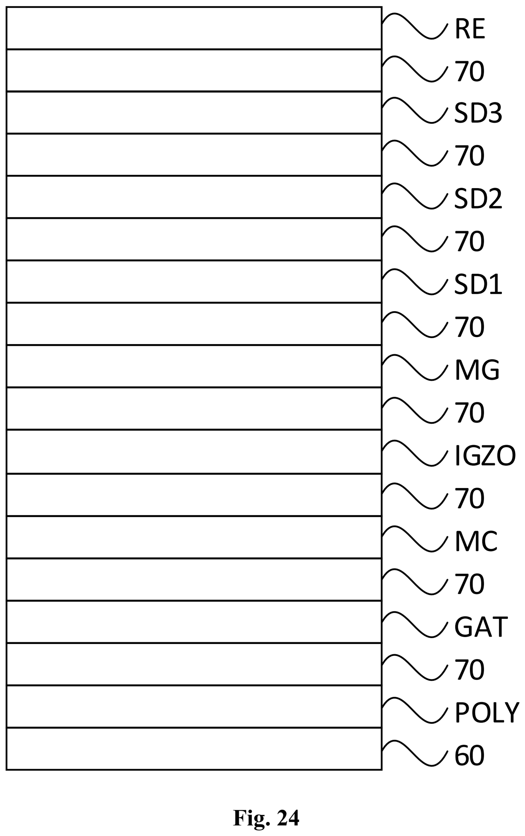

Exemplarily, Fig. 24 is a schematic structural diagram of film layers of a display panel provided in an embodiment of the present disclosure. As shown in Fig. 24, taking the LTPO display panel as an example, a first semiconductor layer POLY, a first metal layer GAT, a second metal layer MC, a second semiconductor layer IGZO, a third metal layer MG, a fourth metal layer SD1, a fifth metal layer SD2, a sixth metal layer SD3 and an anode layer RE are stacked on one side of the base substrate 60, and insulating layers 70 can be provided between any two adjacent conductive film layers to avoid a short circuit between the two adjacent conductive film layers.

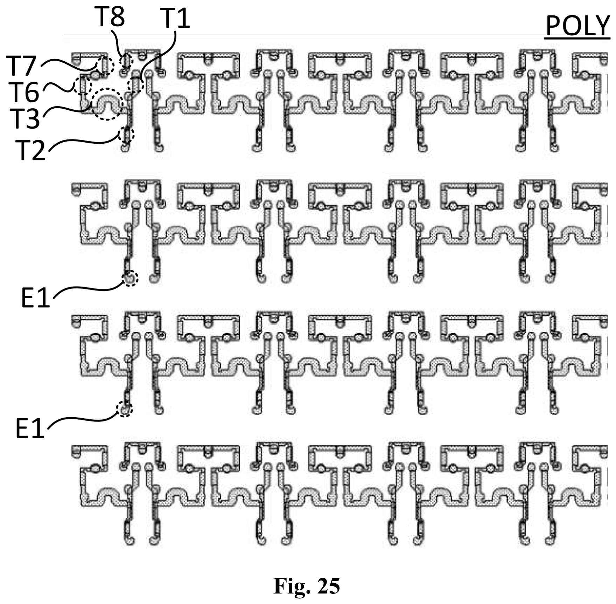

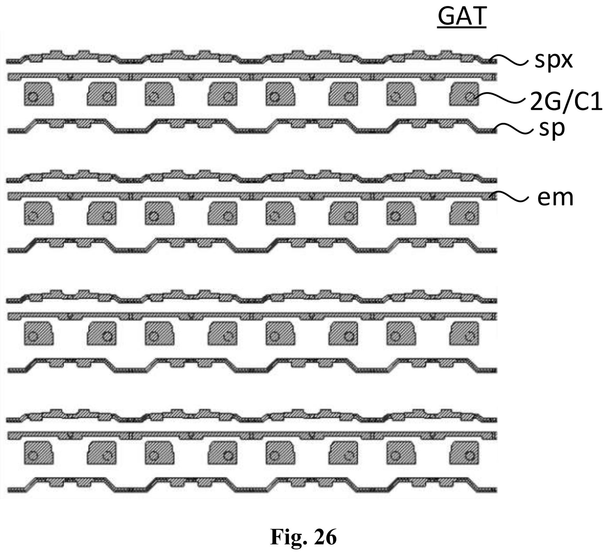

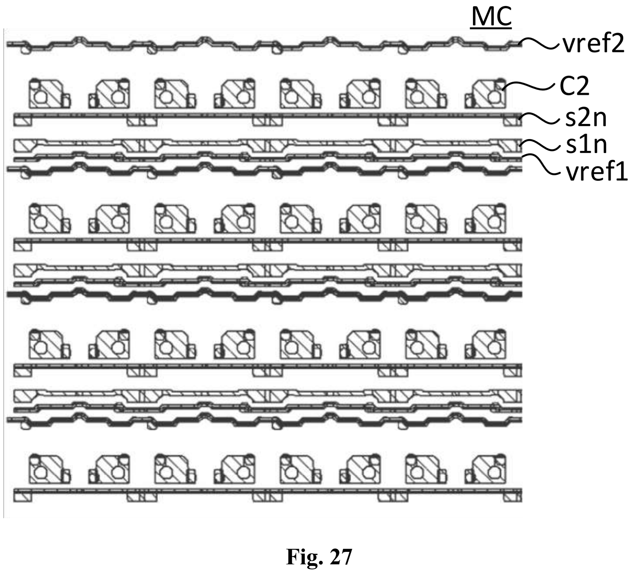

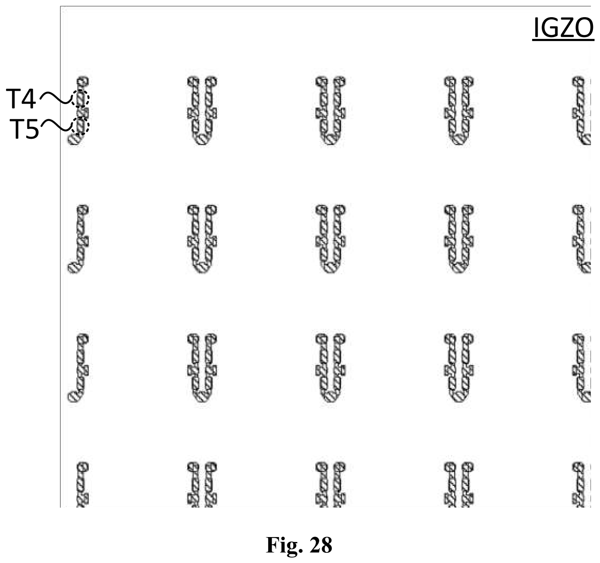

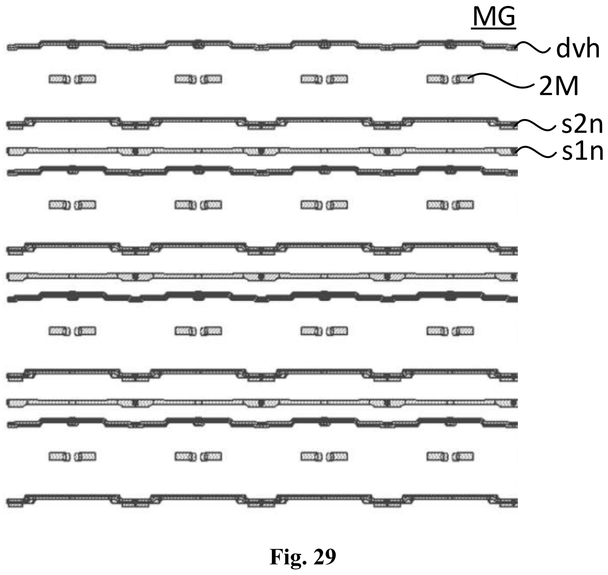

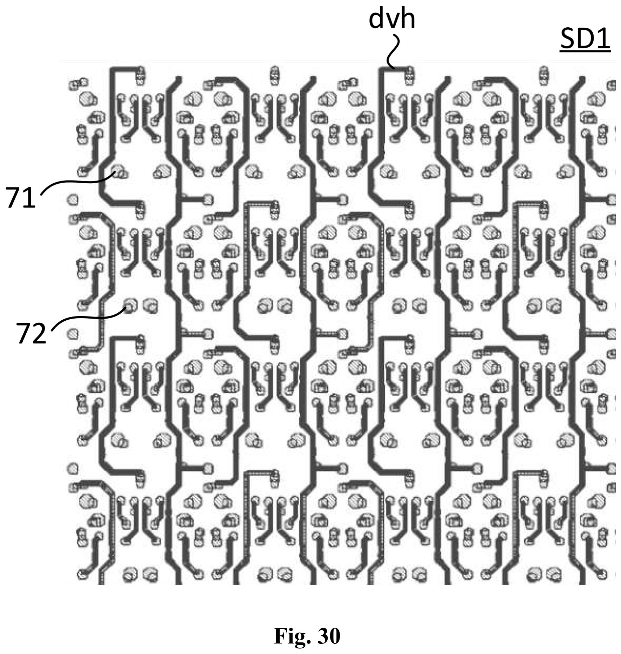

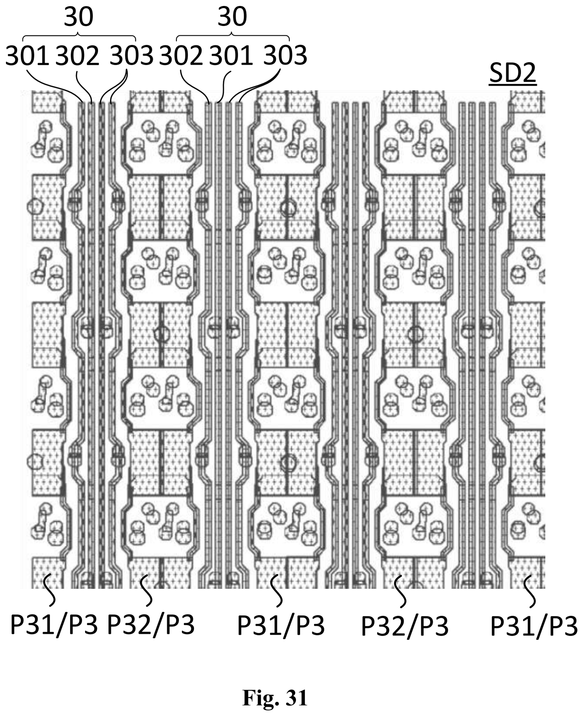

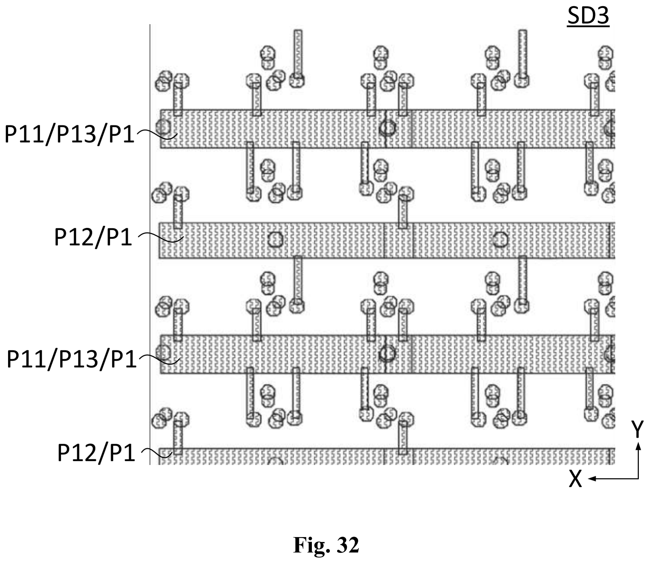

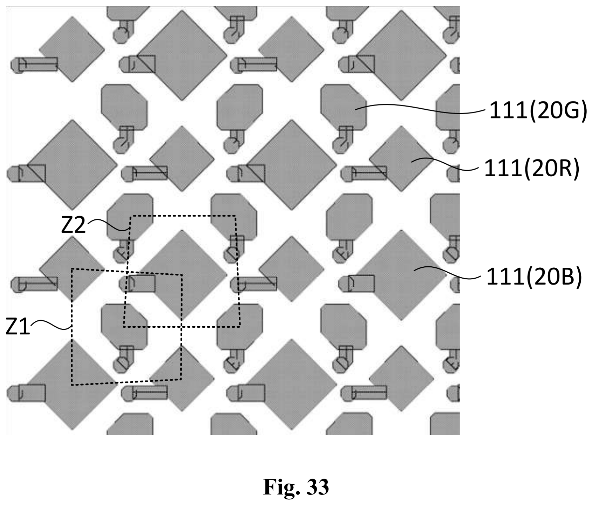

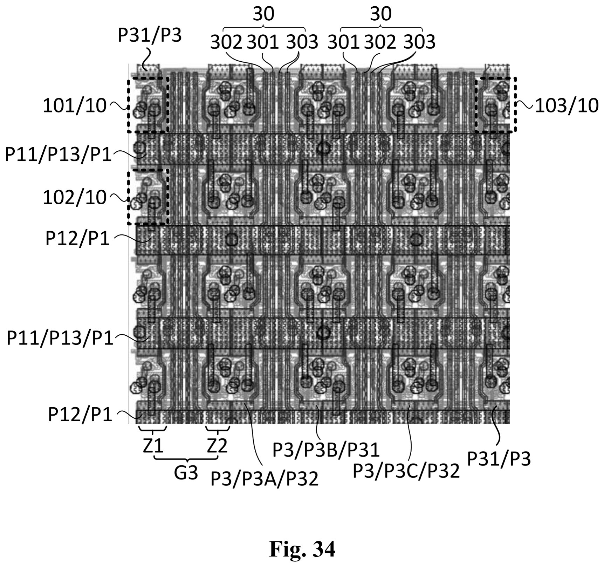

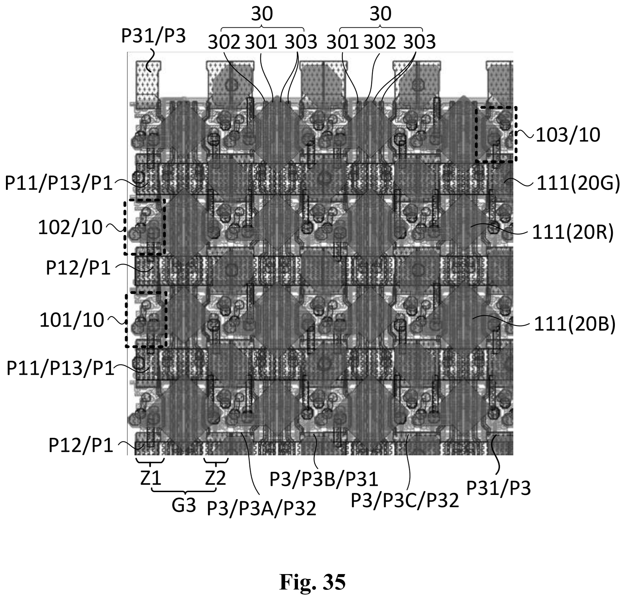

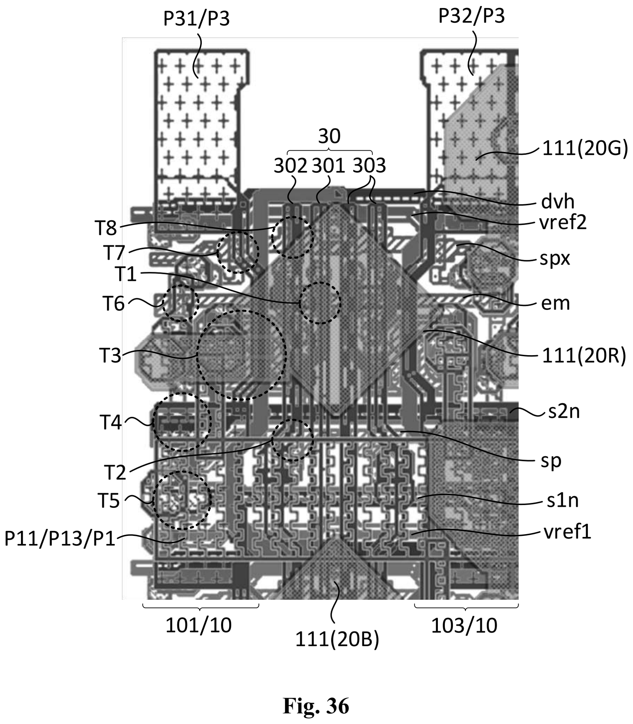

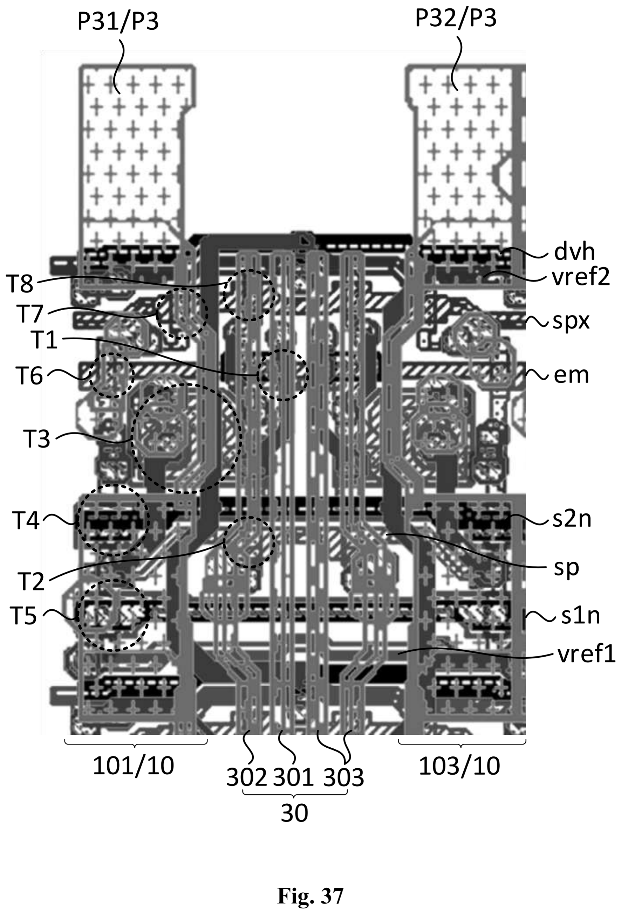

Specifically, Fig. 25 is a schematic structural diagram of a first semiconductor layer in the display panel shown in Fig. 24; Fig. 26 is a schematic structural diagram of a first metal layer in the display panel shown in Fig. 24; Fig. 27 is a schematic structural diagram of a second metal layer in the display panel shown in Fig. 24; Fig. 28 is a schematic structural diagram of a second semiconductor layer in the display panel shown in Fig. 24; Fig. 29 is a schematic structural diagram of a third metal layer in the display panel shown in Fig. 24; Fig. 30 is a schematic structural diagram of a fourth metal layer in the display panel shown in Fig. 24; Fig. 31 is a schematic structural diagram of a fifth metal layer in the display panel shown in Fig. 24; Fig. 32 is a schematic structural diagram of a sixth metal layer in the display panel shown in Fig. 24. Fig.; Fig. 33 is a schematic structural diagram of an anode layer in the display panel shown in Fig. 24; Fig. 34 is a schematic diagram of a stacked structure of a part of the film layers in the display panel shown in Fig. 24, specifically a schematic diagram of the stacked structure from the first semiconductor layer to the sixth metal layer; Fig. 35 is a schematic diagram of the stacked structure of all film layers in the display panel shown in Fig. 24, specifically a schematic diagram of the stacked structure from the first semiconductor layer to the anode layer; Fig. 36 is a schematic diagram of a stacked structure of all film layers of the pixel circuit in the display panel shown in Fig. 24; to clearly illustrate the structure of the pixel circuit, Fig. 37 is a schematic structural diagram of a part of film layers of the pixel circuit in the display panel shown in Fig. 24, specifically a schematic diagram of the stacked structure from the first semiconductor layer to the fifth metal layer.

The structures of the film layers shown in Figs. 24 to 37 can correspond to the pixel circuit 10 shown in Fig. 4, in which the threshold compensation transistor T4 and the initialization reset transistor T5 are oxide (Indium Gallium Zinc Oxide, IGZO) transistors, and the first light-emitting control transistor T1, the data writing transistor T2, the driving transistor T3, the second light-emitting control transistor T6, the anode reset transistor T7 and the bias transistor T8 are low-temperature poly-silicon (Low Temperature Poly-Silicon, LTPS) transistors.

Exemplarily, as shown in Figs. 4 and 24-37, active layers of the first light-emitting control transistor T1, the data writing transistor T2, the driving transistor T3, the second light-emitting control transistor T6, the anode reset transistor T7 and the bias transistor T8 may be located in the first semiconductor layer POLY.

The first light-emitting control transistor T1, the data writing transistor T2, the driving transistor T3, the second light-emitting control transistor T6, the anode reset transistor T7 and the gate 2G of the bias transistor T8, and the first electrode plate C1 of the storage capacitor Cst may be located in the first metal layer GAT.

The first metal layer GAT further comprises a third scanning signal line sp, a fourth scanning signal line spx and a light-emitting control signal line em extending in the row direction. The third scanning signal line sp is electrically connected to the gate of the data writing transistor T2 for transmitting the third scanning signal SP; the fourth scanning signal line spx is electrically connected to the gate of the anode reset transistor T7 and the gate of the bias transistor T8 for transmitting the fourth scanning signal SPX; the light-emitting control signal line em is electrically connected to the gate of the first light-emitting control transistor T1 and the gate of the second light-emitting control transistor T6 for transmitting the light-emitting control signal EM.

The second metal layer MC may comprise a second electrode plate C2 of the storage capacitor Cst, a second reference signal line vref2 extending in the row direction, a second scanning signal line s2n, a first scanning signal line sln and a first reference signal line vrefl. The second reference signal line vref2 is electrically connected to the anode reset transistor T7 for transmitting the second reference signal VREF2; the second scanning signal line s2n is electrically connected to the gate of the threshold compensation transistor T4 for transmitting the second scanning signal S2N; the first scanning signal line sln is electrically connected to the gate of the initialization reset transistor T5 for transmitting the first scanning signal S1N; the first reference signal line vrefl is electrically connected to the initialization reset transistor T5 for transmitting the first reference signal VREF1.

The second semiconductor layer IGZO may comprise an active layer of the threshold compensation transistor T4 and an active layer of the initialization reset transistor T5.

The third metal layer MG may comprise a gate 2M of the threshold compensation transistor T4 and a gate of the initialization reset transistor T5, a bias signal line dvh extending in a row direction, a second scanning signal line s2n, and a first scanning signal line sln. The bias signal line dvh is electrically connected to the bias transistor T8 for transmitting the bias signal DVH; the second scanning signal line s2n is electrically connected to the gate of the threshold compensation transistor T4 for transmitting the second scanning signal S2N; and the first scanning signal line s1n is electrically connected to the gate of the initialization reset transistor T5 for transmitting the first scanning signal S1N.

It should be noted that the first scanning signal line s1n of the second metal layer MC is electrically connected to the first scanning signal line s1n of the third metal layer MG to form a double-layer wiring structure, which is beneficial to reduce line resistance and further reduce the voltage drop of the first scanning signal S1N, thereby ensuring the stability of the first scanning signal S1N.

Similarly, the second scanning signal line s2n of the second metal layer MC and the second scanning signal line s2n of the third metal layer MG form a double-layer wiring structure, which is beneficial to reducing line resistance and further reducing the voltage drop of the second scanning signal S2N, thereby ensuring the stability of the second scanning signal S2N.

The fourth metal layer SD1 may comprise a bias signal line dvh extending along the column direction, the bias signal line dvh extending along the column direction is electrically connected to the bias signal line dvh extending along the row direction in the second metal layer MC, and may form a grid wiring structure, which is beneficial to reducing line resistance, and further reducing the voltage drop of the bias signal DVH, thereby ensuring the stability of the bias signal DVH.

The fifth metal layer SD2 may comprise a data signal line 30 and a third power signal line P3 extending in a column direction, the data signal line 30 is configured to transmit a data signal DATA, and the third power signal line P3 is configured to transmit a positive power voltage PVDD.

The sixth metal layer SD3 may comprise a first power signal line P1 extending along the row direction, the first power signal line P1 extending along the row direction is electrically connected to the first power signal line P1 extending along the column direction in the fifth metal layer SD2, and can form a grid wiring structure, which is beneficial to reducing line resistance, and further reducing the voltage drop of the positive power voltage PVDD, thereby ensuring the stability of the positive power voltage PVDD.

The anode layer RE may comprise the anode 111 of the light-emitting element.

It should be noted that the specific film layers of the display panel can be adaptively adjusted according to actual needs, such as adding or removing some film layers, and the embodiments of the present disclosure do not specifically limit this.

Furthermore, as shown in Figs. 34-37, in the third pixel circuit column group G3, the adjacent first pixel circuit column Z1 and second pixel circuit column Z2 are in a mirror-symmetrical pattern. In this situation, in the same row of pixel circuits 10, the pixel circuit 10 located in the first pixel circuit column Z1 and the pixel circuit 10 located in the second pixel circuit column Z2 are adjacent and in a mirror-symmetrical pattern. For connecting the two pixel circuits 10 to some signal lines, the two pixel circuits 10 can share a connecting via hole, thereby reducing the number of holes, helping to improve the transmittance of the display panel; and when an optical sensor device such as an under-screen fingerprint recognition module is provided in the display panel, it helps to improve the performance of the optical sensor device.

Continue referring to Figs. 22 and 34-37, in an embodiment, in the third pixel circuit column group G3, the first data signal line 301 and the second data signal line 302 connected to the first pixel circuit column Z1, and the third data signal line 303 connected to the second pixel circuit column Z2 are all located between the first pixel circuit column Z1 and the second pixel circuit column Z2.

Specifically, as shown in Figs. 22 and 34-37, in the third pixel circuit column group G3, the first data signal line 301, the second data signal line 302 and the third data signal line 303 are all located between the first pixel circuit column Z1 and the second pixel circuit column Z2, so that the first data signal line 301, the second data signal line 302 and the third data signal line 303 in the third pixel circuit column group G3 are in concentrated placement. In this situation, the first data signal line 301, the second data signal line 302 and the third data signal line 303 in the third pixel circuit column group G3 are close to each other, so that the parasitic capacitance between each of the first data signal line 301, the second data signal line 302 and the third data signal line 303 in the third pixel circuit column group G3 and other metal layers or signal nodes in the pixel circuit 10 in the third pixel circuit column group G3 is at a similar level, which helps to reduce the loss difference between the data signals transmitted on the first data signal line 301, the second data signal line 302 and the third data signal line 303, thereby helping to improve display uniformity.

It should be noted that the boundary of the pixel circuit column Z can be set as the gate boundary of the driving transistor T3 of the pixel circuit 10 in the pixel circuit column, thus the data signal line 30 in the third pixel circuit column group G3 is located between the first pixel circuit column Z1 and the second pixel circuit column Z2. It can be understood that in the row direction, the data signal line 30 is located between the gates of the driving transistor T3 of the pixel circuit 10 in the first pixel circuit column Z1 and the second pixel circuit column Z2.

Continue referring to Figs. 22, 34 and 35, in an embodiment, in two adjacent third pixel circuit column groups G3, the arrangement directions of the first data signal lines 301 and the second data signal lines 302 in different third pixel circuit column groups G3 are the same or opposite.

Specifically, as shown in Fig. 22, in two adjacent third pixel circuit column groups G3, the arrangement directions of the first data signal line 301 and the second data signal line 302 in different third pixel circuit column groups G3 are opposite. Thus, in two adjacent third pixel circuit column groups G3, there are sequentially arranged the first data signal line 301, the second data signal line 302, the third data signal line 303, the third data signal line 303, the second data signal line 302, the first data signal line 301, the third data signal line 303, and the third data signal line 303 in the row direction.

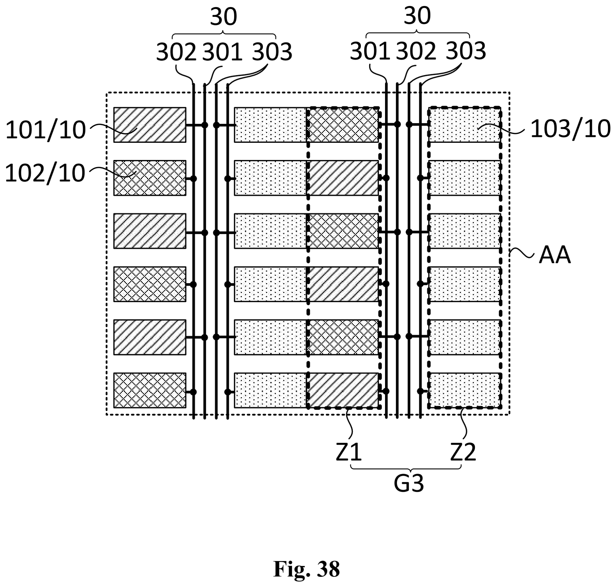

Or, Fig. 38 is a structural schematic diagram of a display panel provided by another embodiment of the present disclosure. As shown in Figs. 34, 35 and 38, in two adjacent third pixel circuit column groups G3, there are sequentially arranged the second data signal line 302, the first data signal line 301, the third data signal line 303, the third data signal line 303, the first data signal line 301, the second data signal line 302, the third data signal line 303, and the third data signal line 303 in the row direction.

In another embodiment, in two adjacent third pixel circuit column groups G3, there may be sequentially arranged the first data signal line 301, the third data signal line 303, the second data signal line 302, the third data signal line 303, the second data signal line 302, the third data signal line 303, the first data signal line 301, and the third data signal line 303 in the row direction; or, there may be sequentially arranged the second data signal line 302, the third data signal line 303, the first data signal line 301, the third data signal line 303, the first data signal line 301, the third data signal line 303, the first data signal line 301, the third data signal line 303, the second data signal line 302, and the third data signal line 303 in the row direction.

In another embodiment, in two adjacent third pixel circuit column groups G3, there may be sequentially arranged the first data signal line 301, the third data signal line 303, the third data signal line 303, the second data signal line 302, the second data signal line 302, the third data signal line 303, the third data signal line 303, and the first data signal line 301 in the row direction; or, there may be sequentially arranged the second data signal line 302, the third data signal line 303, the third data signal line 303, the first data signal line 301, the first data signal line 301, the third data signal line 303, the third data signal line 303, and the second data signal line 302 in the row direction.

With such an arrangement, the first data signal line 301 and the second data signal line 302 in two adjacent third pixel circuit column groups G3 are symmetrically distributed, which is beneficial to making the color shift of the display image have better symmetry, thereby mitigating the color deviation at different viewing directions, that is, no matter from which direction the display image is viewed, the color consistency and accuracy will be improved, and the display image can be viewed from a wider angle range without feeling obvious color changes, thereby enhancing the user experience.

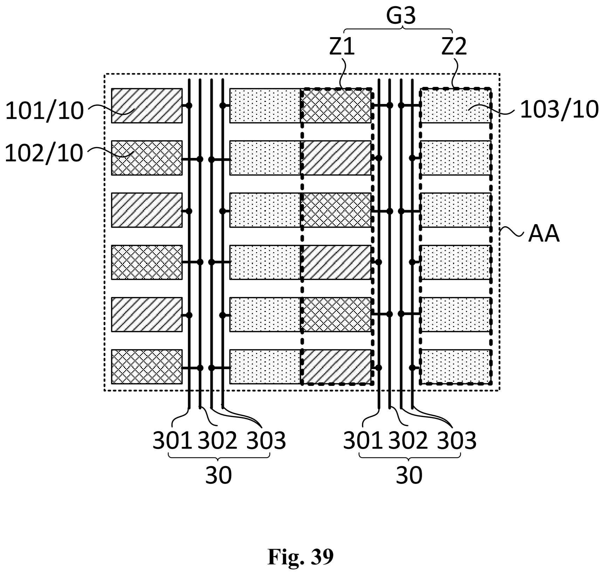

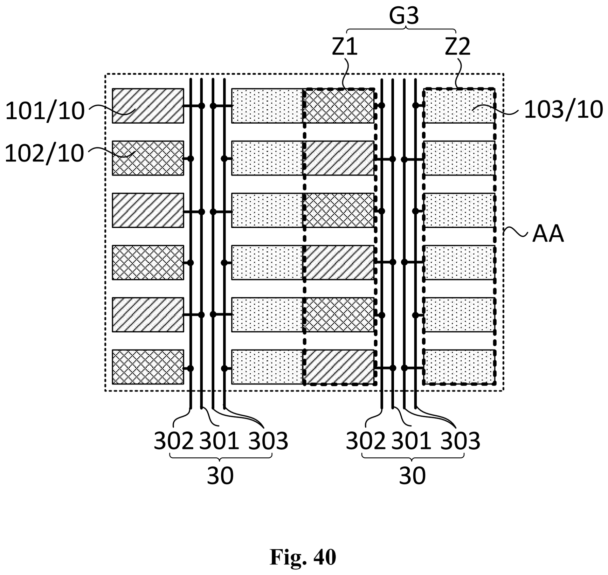

Fig. 39 is a schematic structural diagram of a display panel provided in another embodiment of the present disclosure, and Fig. 40 is a schematic structural diagram of a display panel provided in another embodiment of the present disclosure. As shown in Figs. 39 and 40, in an embodiment, in two adjacent third pixel circuit column groups G3, the first data signal lines 301 and the second data signal lines 302 in different third pixel circuit column groups G3 are arranged in a same direction.

Specifically, as shown in Fig. 39, in two adjacent third pixel circuit column groups G3, there are sequentially arranged the first data signal line 301, the second data signal line 302, the third data signal line 303, the third data signal line 303, the first data signal line 301, the second data signal line 302, the third data signal line 303, and the third data signal line 303 in the row direction.

As shown in Fig. 40, in an embodiment, in two adjacent third pixel circuit column groups G3, there are sequentially arranged the second data signal line 302, the first data signal line 301, the third data signal line 303, the third data signal line 303, the second data signal line 302, the first data signal line 301, the third data signal line 303, and the third data signal line 303 in the row direction.

In another embodiment, in two adjacent third pixel circuit column groups G3, there may be sequentially arranged the first data signal line 301, the third data signal line 303, the second data signal line 302, the third data signal line 303, the first data signal line 301, the third data signal line 303, the second data signal line 302, and the third data signal line 303 in the row direction; or, there may be sequentially arranged the second data signal line 302, the third data signal line 303, the first data signal line 301, the third data signal line 303, the second data signal line 302, the third data signal line 303, the first data signal line 301, and the third data signal line 303 in the row direction.

In another embodiment, in two adjacent third pixel circuit column groups G3, there may be sequentially arranged the first data signal line 301, the third data signal line 303, the third data signal line 303, the second data signal line 302, the first data signal line 301, the third data signal line 303, the third data signal line 303, and the second data signal line 302 in the row direction; or, there may be sequentially arranged the second data signal line 302, the third data signal line 303, the third data signal line 303, the first data signal line 301, the second data signal line 302, the third data signal line 303, the third data signal line 303, and the first data signal line 301 in the row direction.

Such an arrangement can make the positional relationship between the data signal line 30 connecting the sub-pixels of the same color and the pixel circuit 10 connected thereto correspondingly more consistent. In this situation, the parasitic capacitance between the data signal line 30 connecting the sub-pixels of the same color and the metal layers or signal nodes in the pixel circuit 10 connected thereto correspondingly is at a similar level. In the process of preparing the display panel, even if there are process fluctuations, the deviations in the overlapping between the data signal line 30 connecting the sub-pixels of the same color and the metal layers or signal nodes in the pixel circuit 10 connected thereto correspondingly also have the same trend change, thereby improving the display uniformity of the display panel and avoiding the vertical stripe phenomenon caused by brightness differences.

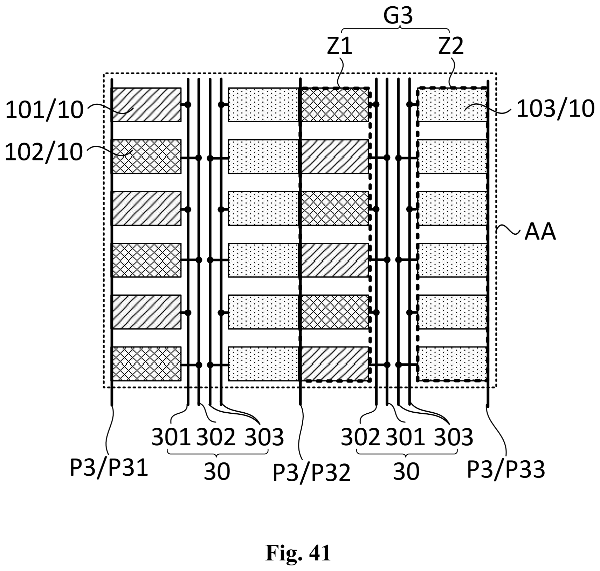

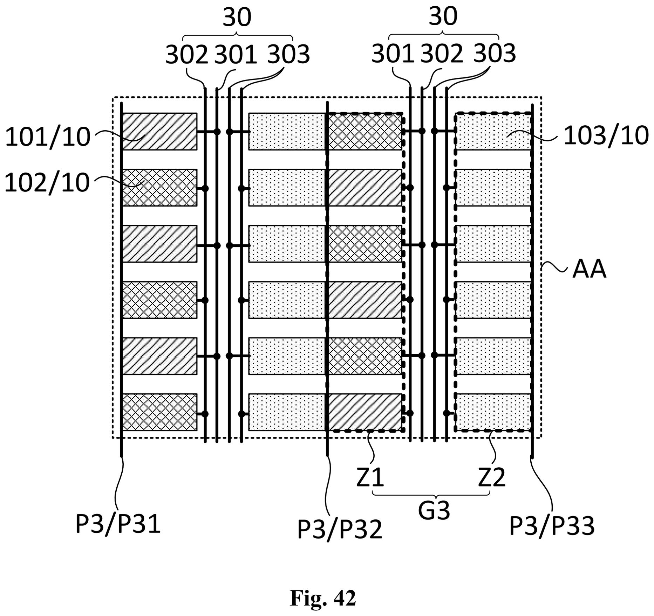

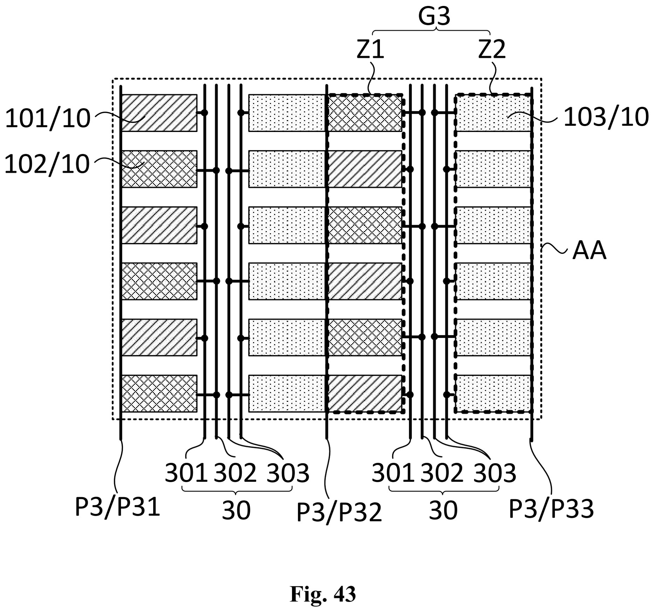

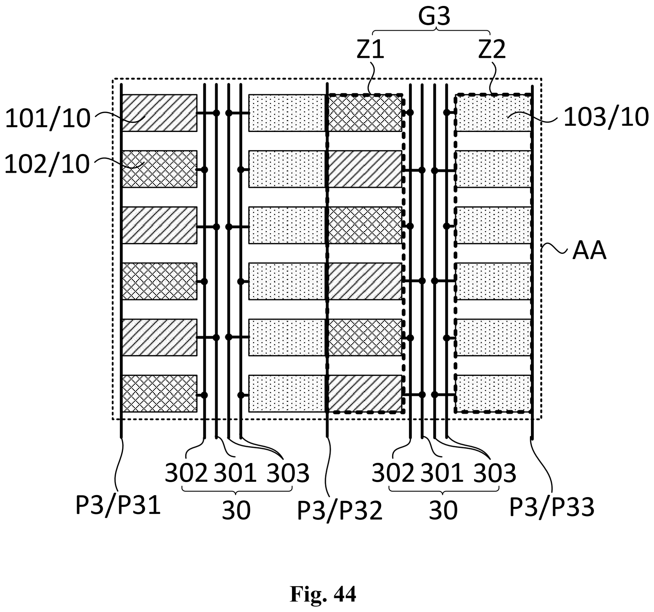

Fig. 41 is a schematic structural diagram of a display panel provided by another embodiment of the present disclosure, Fig. 42 is a schematic structural diagram of a display panel provided by another embodiment of the present disclosure, Fig. 43 is a schematic structural diagram of a display panel provided by another embodiment of the present disclosure, and Fig. 44 is a schematic structural diagram of a display panel provided by another embodiment of the present disclosure. As shown in Figs. 41 to 44, in an embodiment, in the embodiments of the present disclosure, a plurality of third power signal lines P3 are further comprised, which extend along the column direction and are arranged along the row direction. The plurality of third power signal lines P3 comprise a first sub-power signal line P3A, a second sub-power signal line P3B, and a third sub-power signal line P3C that are arranged adjacent to each other sequentially along the row direction. The arrangement direction of the first data signal line 301 and the second data signal line 302 between the first sub-power signal line P3A and the second sub-power signal line P3B is the same as or opposite to the arrangement direction of the first data signal line 301 and the second data signal line 302 between the second sub-power signal line P3B and the third sub-power signal line P3C.

Specifically, as shown in Figs. 34, 35, and 41 to 44, one third power signal line P3 extending along the column direction may be correspondingly provided for every two columns of pixel circuits 10, and the third power signal line P3 is configured to transmit the positive power voltage PVDD.

As shown in Figs. 34, 35, 41 and 42, in the row direction, three third power signal lines P3 that are adjacently and sequentially provided are the first sub-power signal line P3A, the second sub-power signal line P3B and the third sub-power signal line P3C. Thus, the arrangement direction of the first data signal line 301 and the second data signal line 302 between the first sub-power signal line P3A and the second sub-power signal line P3B may be opposite to the arrangement direction of the first data signal line 301 and the second data signal line 302 between the second sub-power signal line P3B and the third sub-power signal line P3C.

Exemplarily, as shown in Fig. 41, between the first sub-power signal line P3A and the second sub-power signal line P3B, there are sequentially arranged the first data signal line 301, the second data signal line 302, the third data signal line 303, and the third data signal line 303 in the row direction; between the second sub-power signal line P3B and the third sub-power signal line P3C, there are sequentially arranged the second data signal line 302, the first data signal line 301, the third data signal line 303, and the third data signal line 303 in the row direction.

Alternatively, as shown in Figs. 34, 35 and 42, between the first sub-power signal line P3A and the second sub-power signal line P3B, there are sequentially arranged the second data signal line 302, the first data signal line 301, the third data signal line 303, and the third data signal line 303 in the row direction; between the second sub-power signal line P3B and the third sub-power signal line P3C, there are sequentially arranged the first data signal line 301, the second data signal line 302, the third data signal line 303, and the third data signal line 303 in the row direction.

In another embodiment, between the first sub-power signal line P3A and the second sub-power signal line P3B, there may be sequentially arranged the first data signal line 301, the third data signal line 303, the second data signal line 302, and the third data signal line 303 in the row direction; between the second sub-power signal line P3B and the third sub-power signal line P3C, there may be sequentially arranged the second data signal line 302, the third data signal line 303, the first data signal line 301, and the third data signal line 303 in the row direction. Or, between the first sub-power signal line P3A and the second sub-power signal line P3B, there may be sequentially arranged the second data signal line 302, the third data signal line 303, the first data signal line 301, and the third data signal line 303 in the row direction; between the second sub-power signal line P3B and the third sub-power signal line P3C, there may be sequentially arranged the first data signal line 301, the third data signal line 303, the second data signal line 302, and the third data signal line 303 in the row direction.

In another embodiment, between the first sub-power signal line P3A and the second sub-power signal line P3B, there may be sequentially arranged the first data signal line 301, the third data signal line 303, the third data signal line 303, and the second data signal line 302 in the row direction; between the second sub-power signal line P3B and the third sub-power signal line P3C, there may be sequentially arranged the second data signal line 302, the third data signal line 303, the third data signal line 303, and the first data signal line 301 in the row direction. Or, between the first sub-power signal line P3A and the second sub-power signal line P3B, there may be sequentially arranged the second data signal line 302, the third data signal line 303, the third data signal line 303, and the first data signal line 301 in the row direction; between the second sub-power signal line P3B and the third sub-power signal line P3C, there may be sequentially arranged the first data signal line 301, the third data signal line 303, the third data signal line 303, and the second data signal line 302 in the row direction.

In this way, the first data signal line 301 and the second data signal line 302 between the first sub-power signal line P3A and the second sub-power signal line P3B, and between the second sub-power signal line P3B and the third sub-power signal line P3C are symmetrically distributed, which is beneficial to making the color deviation of the display image have better symmetry, thereby mitigating the color deviation at different viewing directions, that is, no matter from which direction the display image is viewed, the color consistency and accuracy will be improved, and the display image can be viewed from a wider angle range without feeling obvious color changes, thereby enhancing the user experience.

Continue referring to Figs. 43 and 44, in an embodiment, the arrangement direction of the first data signal line 301 and the second data signal line 302 between the first sub-power signal line P3A and the second sub-power signal line P3B is the same as the arrangement direction of the first data signal line 301 and the second data signal line 302 between the second sub-power signal line P3B and the third sub-power signal line P3C.

As shown in Fig. 43, between the first sub-power signal line P3A and the second sub-power signal line P3B, there are sequentially arranged the first data signal line 301, the second data signal line 302, the third data signal line 303, and the third data signal line 303 in the row direction; between the second sub-power signal line P3B and the third sub-power signal line P3C, there are sequentially arranged the first data signal line 301, the second data signal line 302, the third data signal line 303, and the third data signal line 303 in the row direction.

As shown in Fig. 44, in an embodiment, between the first sub-power signal line P3A and the second sub-power signal line P3B, there are sequentially arranged the second data signal line 302, the first data signal line 301, the third data signal line 303, and the third data signal line 303 in the row direction; between the second sub-power signal line P3B and the third sub-power signal line P3C, there may be sequentially arranged the second data signal line 302, the first data signal line 301, the third data signal line 303, and the third data signal line 303 in the row direction.

In another embodiment, between the first sub-power signal line P3A and the second sub-power signal line P3B, there may be sequentially arranged the first data signal line 301, the third data signal line 303, the second data signal line 302, and the third data signal line 303 in the row direction; between the second sub-power signal line P3B and the third sub-power signal line P3C, there may be sequentially arranged the first data signal line 301, the third data signal line 303, the second data signal line 302, and the third data signal line 303 in the row direction; or, between the first sub-power signal line P3A and the second sub-power signal line P3B, the second data signal line 302, there may be sequentially arranged the third data signal line 303, the first data signal line 301, and the third data signal line 303 in the row direction; between the second sub-power signal line P3B and the third sub-power signal line P3C, there may be sequentially arranged the second data signal line 302, the third data signal line 303, the first data signal line 301, and the third data signal line 303 in the row direction.

In yet another embodiment, between the first sub-power signal line P3A and the second sub-power signal line P3B, there may be sequentially arranged the first data signal line 301, the third data signal line 303, the third data signal line 303, and the second data signal line 302 in the row direction; between the second sub-power signal line P3B and the third sub-power signal line P3C, there may be sequentially arranged the first data signal line 301, the third data signal line 303, the third data signal line 303, and the second data signal line 302 in the row direction; or, between the first sub-power signal line P3A and the second sub-power signal line P3B, there may be sequentially arranged the second data signal line 302, the third data signal line 303, the third data signal line 303, the first data signal line 301, and the second data signal line 302 in the row direction; between the second sub-power signal line P3B and the third sub-power signal line P3C, there may be sequentially arranged the third data signal line 303, the third data signal line 303, and the first data signal line 301 in the row direction.

Such an arrangement can make the positional relationship between the data signal line 30 connecting the sub-pixels of the same color and the pixel circuit 10 connected thereto correspondingly more consistent. In this situation, the parasitic capacitance between the data signal line 30 connecting the sub-pixels of the same color and the metal layers or signal nodes in the pixel circuit 10 connected thereto correspondingly is at a similar level. In the process of preparing the display panel, even if there are process fluctuations, the deviations in the overlapping between the data signal line 30 connecting the sub-pixels of the same color and the metal layers or signal nodes in the pixel circuit 10 connected thereto correspondingly also have the same trend change, thereby improving the display uniformity of the display panel and avoiding the vertical stripe phenomenon caused by brightness differences.

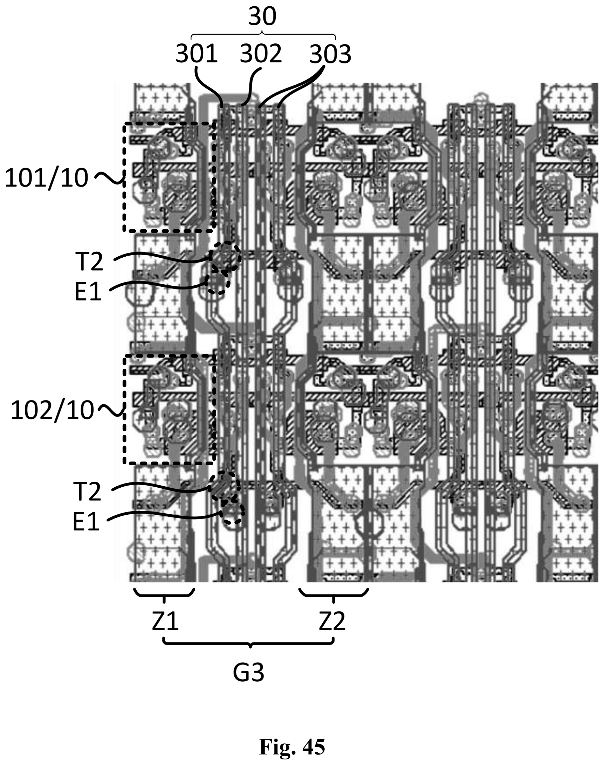

Fig. 45 is a schematic diagram of a stacked structure of another part of film layers in the display panel shown in Fig. 24, specifically a schematic diagram of a stacked structure of a first semiconductor layer, a first metal layer, a fourth metal layer and a fifth metal layer. As shown in Figs. 25, 26, 30, 31 and 45, in an embodiment, the pixel circuit 10 comprises a data writing transistor T2, and the active layer of the data writing transistor T2 comprises a first connecting end E1. In the third pixel circuit column group G3, along the row direction, the first connecting end E1 of the first pixel circuit 101 is located on a side of the second data signal line 302 close to the first data signal line 301, and the first data signal line 301 is electrically connected to the first connecting end E1 of the first pixel circuit 101. In the third pixel circuit column group G3, along the row direction, the first connecting end E1 of the second pixel circuit 102 is located on a side of the first data signal line 301 close to the second data signal line 302, and the second data signal line 302 is electrically connected to the first connecting end E1 of the second pixel circuit 102.

Specifically, as shown in Figs. 25, 26, 30, 31 and 45, the data writing transistor T2 is configured to write the data signal DATA from the data signal line 30 into the pixel circuit 10.

The active layer of the data writing transistor T2 is located in the first semiconductor layer POLY, one end of the active layer of the data writing transistor T2 is provided with a first connecting end E1 configured to form an electrical connection with the data signal line 30.

Specifically, as shown in Figs. 25, 26, 30, 31 and 45, in the third pixel circuit column group G3, along the row direction, the first connecting end E1 of the first pixel circuit 101 is located on a side of the second data signal line 302 close to the first data signal line 301, so that in the row direction, the first connecting end E1 of the first pixel circuit 101 is close to the first data signal line 301, the electrical connection between the first connecting end E1 of the first pixel circuit 101 and the first data signal line 301 is easily achieved, and the additional resistance and capacitance that may be introduced during the connection process can be reduced, which is beneficial to improving the transmission efficiency of the data signal.

Furthermore, in the third pixel circuit column group G3, along the row direction, the first connecting end E1 of the second pixel circuit 102 is located on the side of the first data signal line 301 close to the second data signal line 302, so that in the row direction, the first connecting end E1 of the second pixel circuit 102 is close to the second data signal line 302, the electrical connection between the first connecting end E1 of the second pixel circuit 102 and the second data signal line 302 is easily achieved, and the additional resistance and capacitance that may be introduced during the connection process can be reduced, which is beneficial to improving the transmission efficiency of the data signal.

In an embodiment, the active layer of the data writing transistor T2 is located in the first semiconductor layer POLY, and the first data signal line 301 and the second data signal line 302 are located in the fifth metal layer SD2. The electrical connection between the first connecting end E1 of the first pixel circuit 101 and the first data signal line 301, and the electrical connection between the first connecting end E1 of the second pixel circuit 102 and the second data signal line 302 can be achieved by via(s) in the insulating layer 70 between the first semiconductor layer POLY and the fifth metal layer SD2.

Further, continue referring to Figs. 25, 26, 30, 31 and 45, in an embodiment, the fourth metal layer SD1 comprises a first connecting portion 71 and a second connecting portion 72, and the first connecting end E1 of the first pixel circuit 101 and the first data signal line 301 can be electrically connected via the first connecting portion 71. For example, the first connecting portion 71 is connected to the first connecting end E1 of the first pixel circuit 101 by via connection, and the first data signal line 301 is connected to the first connecting portion 71 via connection, so that the via depth can be reduced each time, thereby avoiding the via depth being too large to cause a circuit break. Similarly, the first connecting end E1 of the second pixel circuit 102 and the second data signal line 302 can be electrically connected via the second connecting portion 72. For example, the second connecting portion 72 is connected to the first connecting end E1 of the second pixel circuit 102 by via connection, and the second data signal line 302 is connected to the second connecting portion 72 by via connection, so that the via depth can be reduced each time, thereby avoiding the via depth being too large to cause a circuit break.

Continue referring to Figs. 25, 26, 30, 31 and 45, in an embodiment, two third data signal lines 303 may be correspondingly provided in one second pixel circuit column Z2, in which one third data signal line 303 is electrically connected to the third pixel circuits 103 of odd rows in the second pixel circuit column Z2, and the other third data signal line 303 is electrically connected to the third pixel circuits 103 of even rows in the second pixel circuit column Z2.

The connection structure between the first connecting end E1 of the third pixel circuit 103 and the corresponding third data signal line 303 can be referred to the connection structure between the first connecting end E1 of the first pixel circuit 101 and the first data signal line 301, and can be referred to the connection structure between the first connecting end E1 of the second pixel circuit 102 and the second data signal line 302. In this way, the connection structure between the first connecting end E1 of the third pixel circuit 103 and the corresponding third data signal line 303, and the connection structure between the first connecting end E1 of the first pixel circuit 101 and the first data signal line 301, and the connection structure between the first connecting end E1 of the second pixel circuit 102 and the second data signal line 302 are distributed symmetrically, which is conducive to making the color deviation of the display image have better symmetry, thereby mitigating the color deviation at different viewing directions, which will not be repeated here.

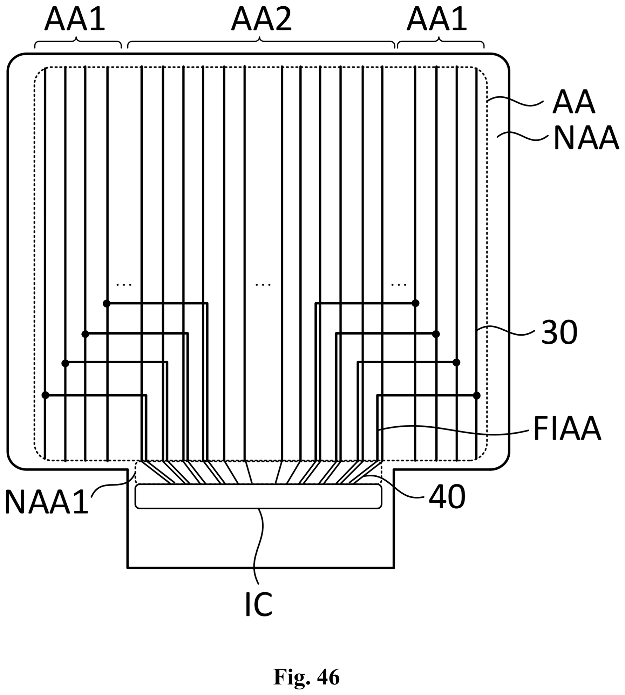

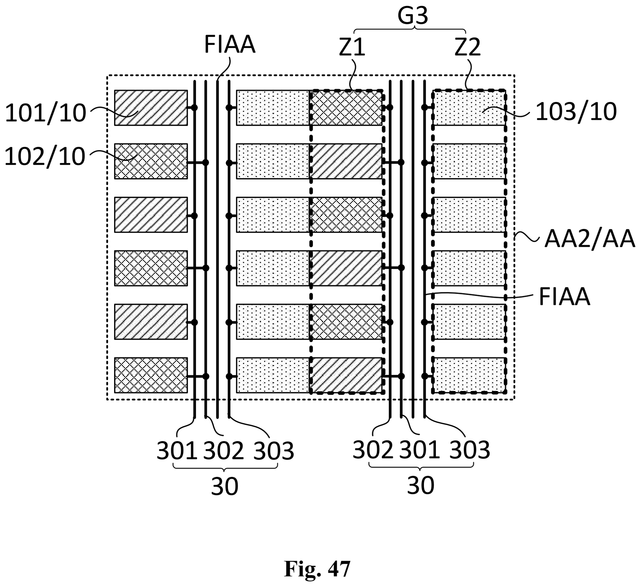

Fig. 46 is a schematic structural diagram of a display panel provided by another embodiment of the present disclosure, and Fig. 47 is a schematic structural diagram of a display panel provided by another embodiment of the present disclosure. As shown in Figs. 46 and 47, in an embodiment, the display region AA comprises a first display region AA1 and a second display region AA2, and along the row direction, the first display region AA1 is located at least on one side of the second display region AA2. The display panel further comprises a plurality of auxiliary signal lines FIAA extending along the column direction and arranged along the row direction. The auxiliary signal lines FIAA are at least partially located in the second display region AA2 and electrically connected to the data signal lines 30 in the first display region AA1. In the third pixel circuit column group G3, the auxiliary signal lines FIAA are located between the data signal lines 30 connected to the first pixel circuit column Z1 and the data signal lines 30 connected to the second pixel circuit column Z2.

Specifically, as shown in Figs. 46 and 47, the display region AA may comprise a first display region AA1 and a second display region AA2. The figure exemplarily shows that in the row direction, the first display regions AA1 are located on both sides of the second display region AA2, in which each first display region AA1 is located between the second display region AA2 and the non-display regions NAA on the left and right sides. Along the row direction, the second display region AA2 is closer to the center of the display panel, and the first display region AA1 is closer to the edge of the display panel. In this way, the non-display region NAA comprises a fan-out area NAA1 located on one side of the display region AA along the column direction. Taking the lower side as an example in the figure, the fan-out area NAA1 can be arranged with multiple data signal output lines 40 respectively electrically connected to the data signal lines 30 and the integrated circuit IC, thereby realizing the electrical connection between the integrated circuit IC and the data signal line 30, ensuring the stable transmission of the data signal, which it is not limited thereto.

Further, as shown in Figs. 46 and 47, a plurality of data signal lines 30 are provided in both the first display region AA1 and the second display region AA2, the data signal lines 30 located in the second display region AA2 can be directly connected to the data signal output lines 40, and the data signal lines 30 located in the first display region AA1 are connected to the data signal output lines 40 via the auxiliary signal lines FIAA at least partially located in the second display region AA2. In this way, the data signal output lines 40 can be centrally arranged in the fan-out area NAA1 below the second display region AA2, thereby reducing the space occupied by the data signal output lines 40, and further reducing the area of the fan-out area NAA1, effectively reducing the area ratio of the non-display region NAA, and achieving a narrow bezel effect.

Continue referring to Fig. 47, in the third pixel circuit column group G3, the auxiliary signal line FIAA is located between the third data signal line 303 connected to the second pixel circuit column Z2 and the set of the first data signal line 301 and the second data signal line 302 connected to the first pixel circuit column Z1. Since the auxiliary signal line FIAA is also configured to transmit data signals, the auxiliary signal line FIAA is in concentrated placement with the first data signal line 301, the second data signal line 302 and the third data signal line 303. In this situation, the auxiliary signal line FIAA, the first data signal line 301 and the second data signal line 302 are close to each other, so that the parasitic capacitance between each of the auxiliary signal line FIAA, the first data signal line 301, the second data signal line 302 and the third data signal line 303 and the metal layers or signal nodes in the pixel circuit 10 is at a similar level, which helps to reduce the loss difference between the data signals transmitted on the auxiliary signal line FIAA, the first data signal line 301, the second data signal line 302 and the third data signal line 303, thereby helping to improve display uniformity.

Meanwhile, the auxiliary signal line FIAA is located between the data signal line 30 connected to the first pixel circuit column Z1 and the data signal line 30 connected to the second pixel circuit column Z2, which can reduce the influence of the auxiliary signal line FIAA on the connection between the pixel circuit 10 and the data signal line 30 in the first pixel circuit column Z1 and the second pixel circuit column Z2.

Continue referring to Fig. 47, in an embodiment, the number of corresponding auxiliary signal lines FIAA arranged in one third pixel circuit column group G3 is less than or equal to one.

Specifically, as shown in Fig. 47, two data signal lines 30 are correspondingly provided for one first pixel circuit column Z1 and one data signal line 30 is correspondingly provided for one second pixel circuit column Z2, so that at least three data signal lines 30 are provided in the third pixel circuit column group G3. In this embodiment, the number of the corresponding auxiliary signal lines FIAA in the third pixel circuit column group G3 is less than or equal to 1, avoiding that too many signal lines for transmitting data signals in the third pixel circuit column group G3 cause the signal lines for transmitting data signals to be too dense, thereby ensuring that there can be sufficient distance between the signal lines for transmitting data signals, reducing the coupling capacitance between each data signal line 30 and the auxiliary signal line FIAA, and reducing the mutual interference of data signals between each data signal line 30 and the auxiliary signal line FIAA.

It should be noted that Fig. 47 only takes the example that one auxiliary signal line FIAA is provided in one third pixel circuit column group G3, but the present disclosure is not limited thereto.

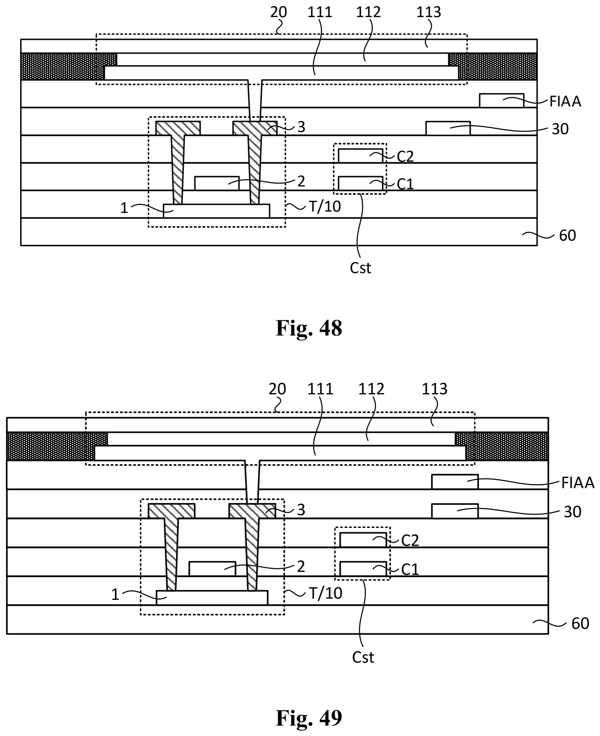

Fig. 48 is a partial cross-sectional diagram of a display panel provided by another embodiment of the present disclosure. As shown in Figs. 47 to 48, in an embodiment, the display region AA comprises a first display region AA1 and a second display region AA2, and along the row direction, the first display region AA1 is located at least on one side of the second display region AA2. The display panel further comprises a plurality of auxiliary signal lines FIAA extending along the column direction and arranged along the row direction. The auxiliary signal line FIAA is at least partially located in the second display region AA2 and electrically connected to the data signal line 30 in the first display region AA1.

The auxiliary signal line FIAA and the data signal line 30 are located in different layers.

In the direction perpendicular to the plane where the display panel is located, the auxiliary signal line FIAA at least partially overlaps with the data signal line 30.

Or, in the direction perpendicular to the plane where the display panel is located, the auxiliary signal line FIAA does not overlap with the data signal line 30.

The positional relationship between the first display region AA1 and the second display region AA2, and the distribution and connection structure of the auxiliary signal line FIAA may be referred to the above embodiments, which will not be repeated here.

In this embodiment, as shown in Figs. 47 and 48, the auxiliary signal line FIAA and the data signal line 30 are located in different layers, which can increase the distance between the auxiliary signal line FIAA and the data signal line 30, thereby reducing the coupling capacitance between the auxiliary signal line FIAA and the data signal line 30, and further reducing the mutual interference of data signals between the auxiliary signal line FIAA and the data signal line 30.

Furthermore, as shown in Figs. 47 and 48, in the direction perpendicular to the plane where the display panel is located, the auxiliary signal line FIAA does not overlap with the data signal line 30, which can further reduce the coupling capacitance between the auxiliary signal line FIAA and the data signal line 30, thereby reducing the mutual interference of data signals between the auxiliary signal line FIAA and the data signal line 30.

Fig. 49 is a partial cross-sectional diagram of a display panel provided in another embodiment of the present disclosure. As shown in Fig. 49, in an embodiment, in the direction perpendicular to the plane where the display panel is located, the auxiliary signal line FIAA at least partially overlaps with the data signal line 30.

Such a configuration can reduce the total shielding area of the auxiliary signal line FIAA and the data signal line 30 in the thickness direction of the display panel, which helps to reduce the influence of the auxiliary signal line FIAA and the data signal line 30 on the display effect of the display region AA and increase the light transmission area of the display panel.

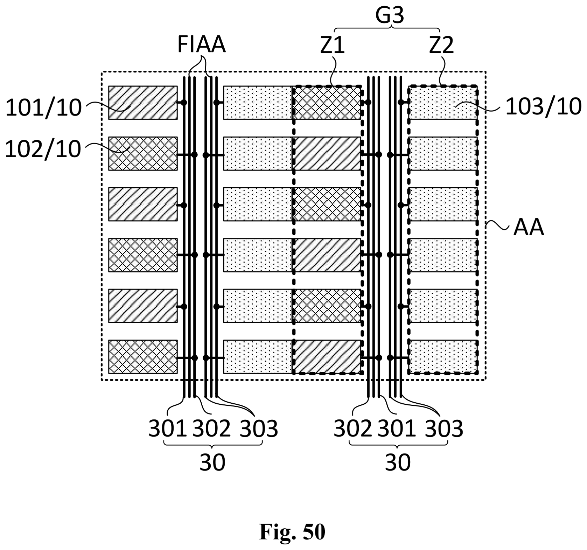

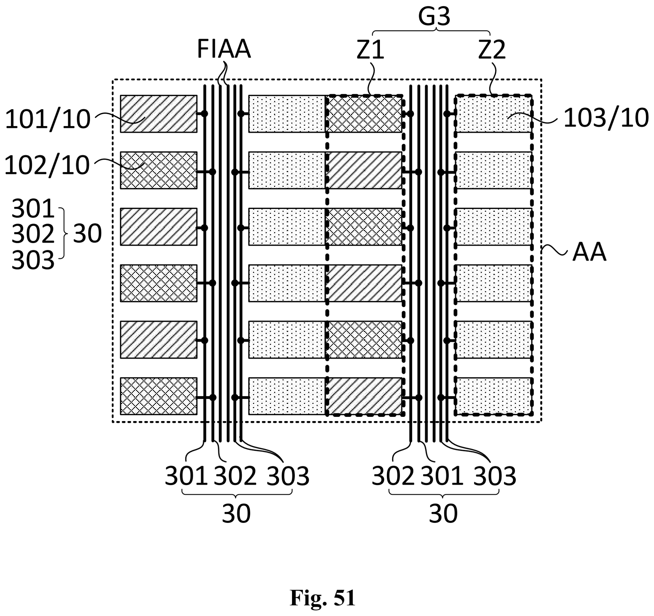

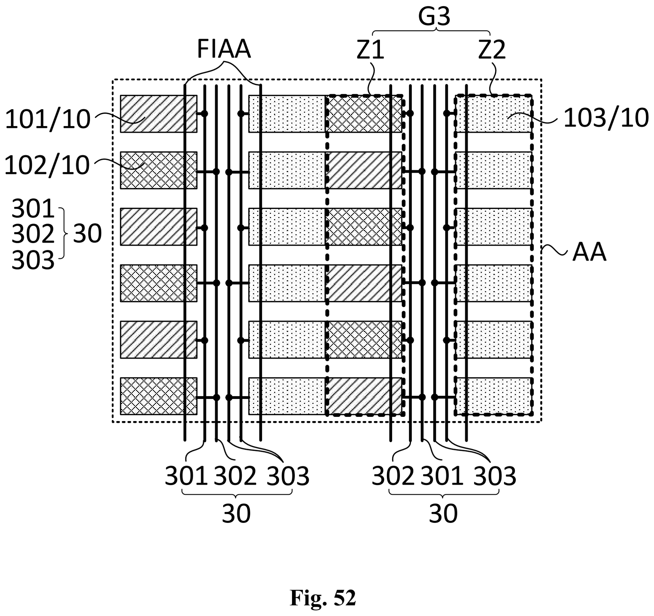

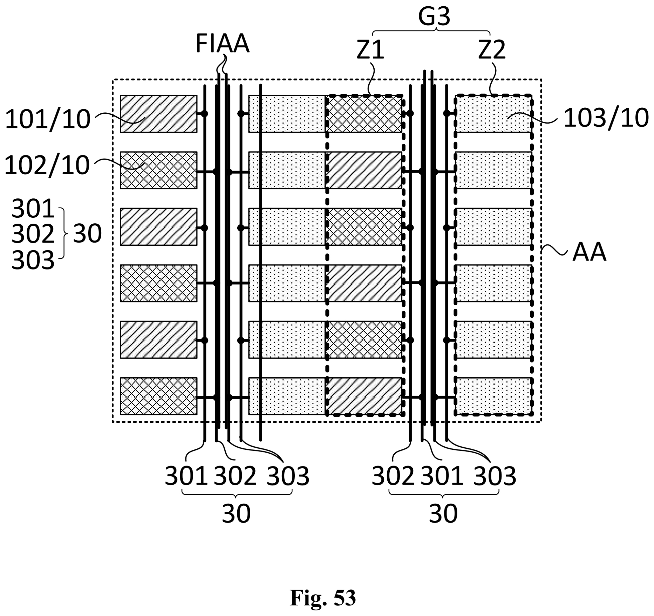

Fig. 50 is a schematic structural diagram of a display panel provided by another embodiment of the present disclosure, Fig. 51 is a schematic structural diagram of a display panel provided by another embodiment of the present disclosure, Fig. 52 is a schematic structural diagram of a display panel provided by another embodiment of the present disclosure, and Fig. 53 is a schematic structural diagram of a display panel provided by another embodiment of the present disclosure. As shown in Figs. 50 to 53, in an embodiment, one first pixel circuit column Z1 corresponds to one auxiliary signal line FIAA, and one second pixel circuit column Z2 corresponds to one auxiliary signal line FIAA.

In the third pixel circuit column group G3, the auxiliary signal line FIAA corresponding to the first pixel circuit column Z1 is located between the first data signal line 301 and the second data signal line 302 corresponding to the first pixel circuit column Z1, and the auxiliary signal line FIAA corresponding to the second pixel circuit column Z2 is located between the two third data signal lines 303 corresponding to the second pixel circuit column Z2.

Or, in the third pixel circuit column group G3, along the row direction, the auxiliary signal line FIAA corresponding to the first pixel circuit column Z1 is located on the same side of the first data signal line 301 and the second data signal line 302 corresponding to the first pixel circuit column Z1, and the auxiliary signal line FIAA corresponding to the second pixel circuit column Z2 is located on the same side of the two third data signal lines 303 corresponding to the second pixel circuit column Z2.

Or, in the direction perpendicular to the plane of the display panel, the auxiliary signal line FIAA corresponding to the first pixel circuit column Z1 at least partially overlaps with the data signal line 30 corresponding to the first pixel circuit column Z1, and the auxiliary signal line FIAA corresponding to the second pixel circuit column Z2 at least partially overlaps with the data signal line 30 corresponding to the second pixel circuit column Z2.

Specifically, as shown in Figs. 50 to 53, one first pixel circuit column Z1 corresponds to one auxiliary signal line FIAA, one second pixel circuit column Z2 corresponds to one auxiliary signal line FIAA, thus one third pixel circuit column group G3 corresponds to two auxiliary signal lines FIAA to increase the number of auxiliary signal lines FIAA. This can increase the area of the first display region AA1, which is conducive to achieving a narrow bezel effect.

As shown in Fig. 50, in the third pixel circuit column group G3, the auxiliary signal line FIAA corresponding to the first pixel circuit column Z1 is located between the first data signal line 301 and the second data signal line 302 corresponding to the first pixel circuit column Z1, so that the auxiliary signal line FIAA corresponding to the first pixel circuit column Z1is in concentrated placement with the first data signal line 301 and the second data signal line 302, and the parasitic capacitance between each of the auxiliary signal line FIAA corresponding to the first pixel circuit column Z1, the first data signal line 301 and the second data signal line 302 and the metal layers or signal nodes in the pixel circuit 10 is at a similar level, which helps to reduce the loss difference between the auxiliary signal line FIAA corresponding to the first pixel circuit column Z1 and the data signals transmitted on the first data signal line 301 and the second data signal line 302, thereby helping to improve display uniformity.

Furthermore, as shown in Fig. 50, in the direction perpendicular to the plane where the display panel is located, there is no overlapping area between the auxiliary signal line FIAA corresponding to the first pixel circuit column Z1 and the first data signal line 301 and the second data signal line 302, which can reduce the coupling capacitance between the auxiliary signal line FIAA corresponding to the first pixel circuit column Z1 and the first data signal line 301 and the second data signal line 302, thereby reducing the mutual interference of data signals between the auxiliary signal line FIAA corresponding to the first pixel circuit column Z1 and the first data signal line 301 and the second data signal line 302.

Similarly, as shown in Fig. 50, the auxiliary signal lines FIAA corresponding to the second pixel circuit column Z2 are located between the two third data signal lines 303 corresponding to the second pixel circuit column Z2, so that the auxiliary signal lines FIAA corresponding to the second pixel circuit column Z2 are in concentrated placement with the third data signal line 303, so that the parasitic capacitance between each of the auxiliary signal lines FIAA corresponding to the second pixel circuit column Z2 and the third data signal line 303 and the metal layers or signal nodes in the pixel circuit 10 is at a similar level, which helps to reduce the loss difference between the data signals transmitted on the auxiliary signal line FIAA corresponding to the second pixel circuit column Z2 and the third data signal line 303, thereby helping to improve display uniformity.

Furthermore, as shown in Fig. 50, in the direction perpendicular to the plane where the display panel is located, there is no overlapping area between the auxiliary signal line FIAA corresponding to the second pixel circuit column Z2 and the third data signal line 303, which can reduce the coupling capacitance between the auxiliary signal line FIAA corresponding to the second pixel circuit column Z2 and the third data signal line 303, thereby reducing the mutual interference of data signals between the auxiliary signal line FIAA corresponding to the second pixel circuit column Z2 and the third data signal line 303.

Continue referring to Figs. 51 and 52, in an embodiment, in the third pixel circuit column group G3, along the row direction, the auxiliary signal line FIAA corresponding to the first pixel circuit column Z1 is located on the same side of the first data signal line 301 and the second data signal line 302 corresponding to the first pixel circuit column Z1, and the auxiliary signal line FIAA corresponding to the second pixel circuit column Z2 is located on the same side of the two third data signal lines 303 corresponding to the second pixel circuit column Z2. In the direction perpendicular to the plane where the display panel is located, there is no overlapping area between the auxiliary signal line FIAA corresponding to the first pixel circuit column Z1 and the data signal line 30, which can reduce the coupling capacitance between the auxiliary signal line FIAA corresponding to the first pixel circuit column Z1 and the data signal line 30, thereby reducing the mutual interference of data signals between the auxiliary signal line FIAA corresponding to the first pixel circuit column Z1 and the data signal line 30.

Fig. 51 exemplarily shows that the auxiliary signal line FIAA corresponding to the first pixel circuit column Z1 is located on the side of the two data signal lines 30 corresponding to the first pixel circuit column Z1 close to the second pixel circuit column Z2, and the auxiliary signal line FIAA corresponding to the second pixel circuit column Z2 is located on the side of the two third data signal lines 303 corresponding to the second pixel circuit column Z2 close to the first pixel circuit column Z1. Fig. 52 exemplarily shows that the auxiliary signal line FIAA corresponding to the first pixel circuit column Z1 is located on the side of the two data signal lines 30 corresponding to the first pixel circuit column Z1 away from the second pixel circuit column Z2, and the auxiliary signal line FIAA corresponding to the second pixel circuit column Z2 is located on the side of the two third data signal lines 303 corresponding to the second pixel circuit column Z2 away from the first pixel circuit column Z1, which is not limited thereto.

Continue referring to Fig. 53, in an embodiment, in the direction perpendicular to the plane where the display panel is located, the auxiliary signal line FIAA corresponding to the first pixel circuit column Z1 at least partially overlaps with the data signal line 30 corresponding to the first pixel circuit column Z1, and the auxiliary signal line FIAA corresponding to the second pixel circuit column Z2 at least partially overlaps with the data signal line 30 corresponding to the second pixel circuit column Z2. In this way, the total shielding area of the auxiliary signal line FIAA and the data signal line 30 in the thickness direction of the display panel can be reduced, thereby increasing the light transmission area of the display panel and alleviating the influence of the auxiliary signal line FIAA and the data signal line 30 on the display effect of the display region AA.

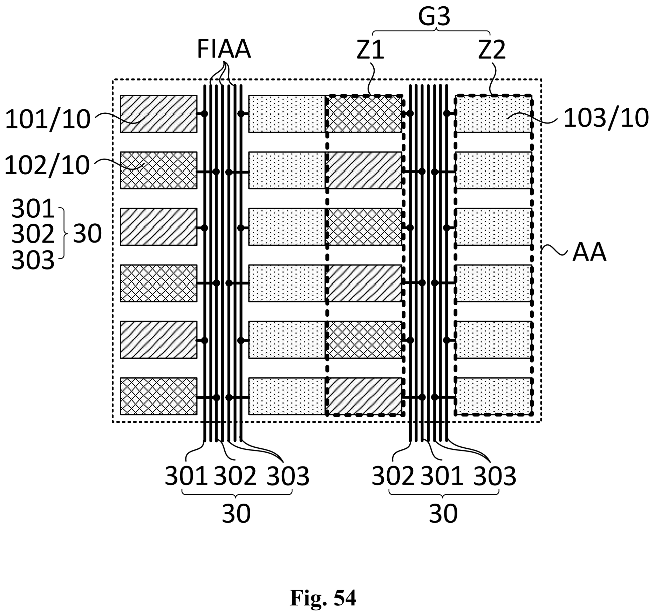

Fig. 54 is a schematic structural diagram of a display panel provided by another embodiment of the present disclosure. As shown in Fig. 54, in an embodiment, the third pixel circuit column group G3 corresponds to three auxiliary signal lines FIAA. In the third pixel circuit column group G3, along the row direction, the three auxiliary signal lines FIAA are located between the first pixel circuit column Z1 and the second pixel circuit column Z2, and the auxiliary signal line FIAA is located between two adjacent data signal lines 30.

Specifically, as shown in Fig. 54, two pixel circuits 10 may correspond to three auxiliary signal lines FIAA. In this situation, one third pixel circuit column group G3 may correspond to three auxiliary signal lines FIAA to increase the number of auxiliary signal lines FIAA. This may increase the area of the first display region AA1, which is conducive to achieving a narrow bezel effect.

As shown in Fig. 54, in the third pixel circuit column group G3, along the row direction, three auxiliary signal lines FIAA are located between the first pixel circuit column Z1 and the second pixel circuit column Z2, so that the auxiliary signal line FIAA is in concentrated placement with the data signal line 30, and the parasitic capacitance between the auxiliary signal line FIAA and the metal layer or signal node in the pixel circuit 10 is at a similar level as that between the data signal line 30 and the metal layer or signal node in the pixel circuit 10, which helps to reduce the loss difference between the data signals transmitted on the auxiliary signal line FIAA and the data signal line 30, and improve display uniformity.

Furthermore, as shown in Fig. 54, the three auxiliary signal lines FIAA may be respectively located between two adjacent data signal lines 30. Thus, in the direction perpendicular to the plane where the display panel is located, the auxiliary signal line FIAA may not overlap with the data signal line 30, which may further reduce the coupling capacitance between the auxiliary signal line FIAA and the data signal line 30, thereby reducing the mutual interference of the data signals between the auxiliary signal line FIAA and the data signal line 30.

Meanwhile, in the third pixel circuit column group G3, the three auxiliary signal lines FIAA can be evenly distributed in the gaps between the four data signal lines 30, thereby reducing visual interference caused by uneven light reflection from the auxiliary signal lines FIAA and improving the overall visual effect of the display panel.

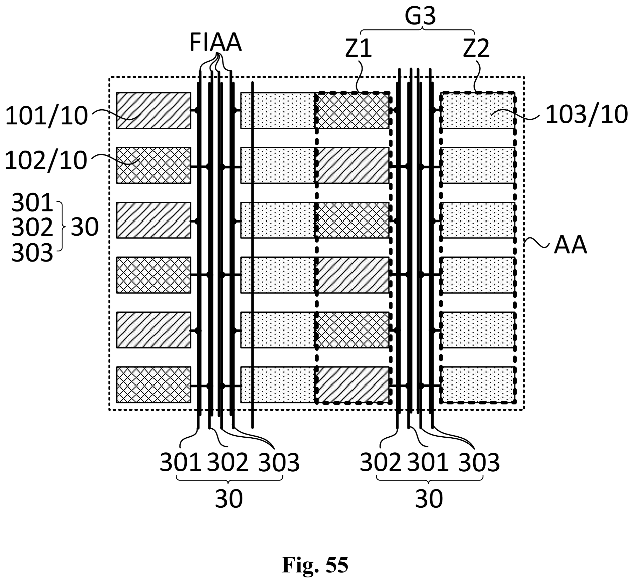

Fig. 55 is a schematic structural diagram of a display panel provided by another embodiment of the present disclosure. As shown in Fig. 55, in an embodiment, one first pixel circuit column Z1 corresponds to two auxiliary signal lines FIAA, and one second pixel circuit column Z2 corresponds to two auxiliary signal lines FIAA. In the direction perpendicular to the plane where the display panel is located, the auxiliary signal line FIAA at least partially overlap with the data signal line 30.

Specifically, as shown in Fig. 55, four auxiliary signal lines FIAA may be correspondingly provided for each column of pixel circuits 10. In this situation, four auxiliary signal lines FIAA may be correspondingly provided for one third pixel circuit column group G3 to increase the number of auxiliary signal lines FIAA. This may increase the area of the first display region AA1, which is conducive to achieving a narrow bezel effect.

Furthermore, as shown in Fig. 55, in the direction perpendicular to the plane where the display panel is located, the auxiliary signal line FIAA at least partially overlap with the data signal line 30. In this way, the total shielding area of the auxiliary signal line FIAA and the data signal line 30 in the thickness direction of the display panel can reduced, thereby increasing the light-transmitting area of the display panel and alleviating the influence of the auxiliary signal line FIAA and the data signal line 30 on the display effect of the display region AA.

Continuing referring to Fig. 47, in an embodiment, in the third pixel circuit column group G3, the first data signal line 301 connected to the first pixel circuit column Z1 is located on a side of the second data signal line 302 connected to the first pixel circuit column Z1 away from the first pixel circuit column Z1, and the distance between the auxiliary signal line FIAA and the second data signal line 302 is greater than the distance between the auxiliary signal line FIAA and the third data signal line 303.

Or, in the third pixel circuit column group G3, the second data signal line 302 connected to the first pixel circuit column Z1 is located on the side of the first data signal line 301 connected to the first pixel circuit column Z1 away from the first pixel circuit column Z1, and the distance between the auxiliary signal line FIAA and the first data signal line 301 is greater than the distance between the auxiliary signal line FIAA and the third data signal line 303.

Specifically, as shown in Fig. 47, one first pixel circuit column Z1 corresponds to one first data signal line 301 and one second data signal line 302, one second pixel circuit column Z2 corresponds to one third data signal line 303, thus one third pixel circuit column group G3 is provided with three data signal lines 30.

As shown in Fig. 47, in this embodiment, in the case that the first data signal line 301 connected to the first pixel circuit column Z1 is located on the side of the second data signal line 302 connected to the first pixel circuit column Z1 away from the first pixel circuit column Z1, the distance between the auxiliary signal line FIAA and the second data signal line 302 is greater than the distance between the auxiliary signal line FIAA and the third data signal line 303, so that the auxiliary signal line FIAA deviates from the center of the third pixel circuit column group G3. In this situation, the auxiliary signal line FIAA is located between the first data signal line 301 and the third data signal line 303, the distance between the auxiliary signal line FIAA and the first data signal line 301 are more consistent with the distance between the auxiliary signal line FIAA and the third data signal line 303. Thus, in the third pixel circuit column group G3, the distribution of the auxiliary signal line FIAA and the data signal line 30 is more uniform, thereby reducing the visual interference caused by the uneven reflection of light from the auxiliary signal line FIAA and the data signal line 30, thereby improving the overall visual effect of the display panel.

Continue referring to Fig. 47, in an embodiment, in the case that the second data signal line 302 connected to the first pixel circuit column Z1 is located on the side of the first data signal line 301 connected to the first pixel circuit column Z1 away from the first pixel circuit column Z1, the distance between the auxiliary signal line FIAA and the first data signal line 301 is greater than the distance between the auxiliary signal line FIAA and the third data signal line 303, so that the auxiliary signal line FIAA deviates from the center of the third pixel circuit column group G3. In this situation, the auxiliary signal line FIAA is located between the second data signal line 302 and the third data signal line 303, the distance between the auxiliary signal line FIAA and the second data signal line 302 are more consistent with the distance between the auxiliary signal line FIAA and the third data signal line 303t. Thus, in the third pixel circuit column group G3, the distribution of the auxiliary signal line FIAA and the data signal line 30 is more uniform, thereby reducing the visual interference caused by the uneven reflection of light by the auxiliary signal line FIAA and the data signal line 30, thereby improving the overall visual effect of the display panel.

Continue referring to Fig. 47, in an embodiment, in the third pixel circuit column group G3, the number of data signal lines 30 connected to the first pixel circuit column Z1 is greater than the number of data signal lines 30 connected to the second pixel circuit column Z2.

Specifically, as shown in Fig. 27, in the third pixel circuit column group G3, by setting the number of data signal lines 30 connected to the second pixel circuit column Z2 to less than the number of data signal lines 30 connected to the first pixel circuit column Z1, the number of data signal lines 30 can be reduced while ensuring the display effect, so that the transmittance can be ensured, while sufficient space can be provided for the auxiliary signal line FIAA, which is beneficial to increase the distance between the auxiliary signal line FIAA and the data signal line 30, reduce the coupling capacitance between the auxiliary signal line FIAA and the data signal line 30, and thereby reduce the mutual interference of data signals between the auxiliary signal line FIAA and the data signal line 30.

Continue referring to Figs. 46 and 47, in an embodiment, the display region AA comprises a first display region AA1 and a second display region AA2, and along the row direction, the first display region AA1 is located on at least one side of the second display region AA2. The display panel further comprises a plurality of auxiliary signal lines FIAA extending along the column direction and arranged along the row direction. The auxiliary signal lines FIAA are at least partially located in the second display region AA2, and the auxiliary signal lines FIAA are electrically connected to the data signal lines 30 in the first display region AA1. In the third pixel circuit column group G3, along the row direction, the numbers of data signal lines 30 on both sides of the auxiliary signal lines FIAA are different.

The positional relationship between the first display region AA1 and the second display region AA2, and the distribution and connection structure of the auxiliary signal line FIAA may be referred to the above embodiments, which will not be repeated here.

In this embodiment, as shown in Figs. 46 and 47, in the third pixel circuit column group G3, along the row direction, the numbers of data signal lines 30 on both sides of the auxiliary signal line FIAA are different. In the case that the number of data signal lines 30 in the third pixel circuit column group G3 is an odd number, the distribution of the auxiliary signal line FIAA and the data signal line 30 can be more uniform, thereby reducing the visual interference caused by the uneven reflection of light from the auxiliary signal line FIAA and the data signal line 30, and improving the overall visual effect of the display panel.

In an embodiment, the plurality of data signal lines 30 are located in the same layer.

By arranging all the data signal lines 30 to be located in the same layer, the number of film layers can be reduced, which is beneficial to reducing the thickness of the display panel and achieving a lightweight design.

For example, as shown in Figs. 24 to 37, the data signal lines 30 may all be disposed on the fifth metal layer SD2, which is not limited thereto.

In an embodiment, along a direction parallel to the plane where the display panel is located, the distance between adjacent data signal lines 30 is greater than or equal to 2.5 $\mu$m. This can avoid signal interference between adjacent data signal lines 30 caused by adjacent data signal lines 30 being too close, making the data signal transmitted on the data signal line 30 more accurate and stable, which is not limited thereto.

It should be noted that the distance between adjacent data signal lines 30 can be set according to actual needs, and the embodiments of the present disclosure are not limited to this. It can be understood that the larger the distance between adjacent data signal lines 30, the smaller the signal interference between adjacent data signal lines 30; but the smaller the distance between adjacent data signal lines 30, the more conducive it is to compressing the size of the pixel circuit 10, thereby helping to improve the pixel density of the display panel.

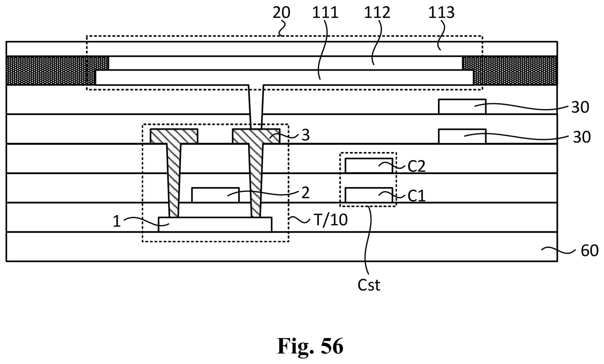

Fig. 56 is a partial cross-sectional diagram of a display panel provided by another embodiment of the present disclosure. As shown in Fig. 56, in an embodiment, at least two data signal lines 30 are located in different layers, and in the direction perpendicular to the plane where the display panel is located, the data signal lines 30 located in different layers at least partially overlap with each other.

Specifically, as shown in Fig. 56, by setting at least two data signal lines 30 in different layers, it helps to increase the distance between different data signal lines 30, reduce the coupling capacitance between different data signal lines 30, and thereby reduce mutual interference of data signals between different data signal lines 30.

Furthermore, as shown in Fig. 56, in the direction perpendicular to the plane where the display panel is located, the data signal lines 30 located in different layers are arranged to at least partially overlap with each other, so that the overall shielding area of the data signal lines 30 in the thickness direction of the display panel can be reduced, thereby increasing the light-transmitting area of the display panel and alleviating the influence of the data signal lines 30 on the display effect of the display region AA.

Continue referring to Figs. 35 and 36, in an embodiment, the light-emitting element 20 comprises a red light-emitting element 20R, a blue light-emitting element 20B and a green light-emitting element 20G, the first pixel circuit 101 is connected to the red light-emitting element 20R, the second pixel circuit 102 is connected to the blue light-emitting element 20B, and the third pixel circuit 103 is connected to the green light-emitting element 20G.

Specifically, as shown in Figs. 35 and 36, the light-emitting element 20 may comprise a red light-emitting element 20R that emits red light, a blue light-emitting element 20B that emits blue light, and a green light-emitting element 20G that emits green light, so as to achieve color display, which is not limited thereto. In some embodiments, the light-emitting element 20 may further comprise a white light-emitting element that emits white light, which are not specifically limited in the embodiments of the present disclosure.

Continue referring to Figs. 35 and 36, in the first pixel circuit column Z1, the red light-emitting element 20R connected to the first pixel circuit 101 and the blue light-emitting element 20B connected to the second pixel circuit 102 are arranged alternately in the column direction; in the second pixel circuit column Z2, the green light-emitting element 20G connected to the third pixel circuit 103 is arranged sequentially in the column direction.

Such a configuration can increase the number of green light-emitting elements 20G. Since the human eyes are most sensitive to green, by setting the number of green light-emitting elements 20G to be greater than the number of green light-emitting elements 20G or the number of blue light-emitting elements 20B, the high sensitivity of the human eyes to green can be better met, which is beneficial to improving the display quality.

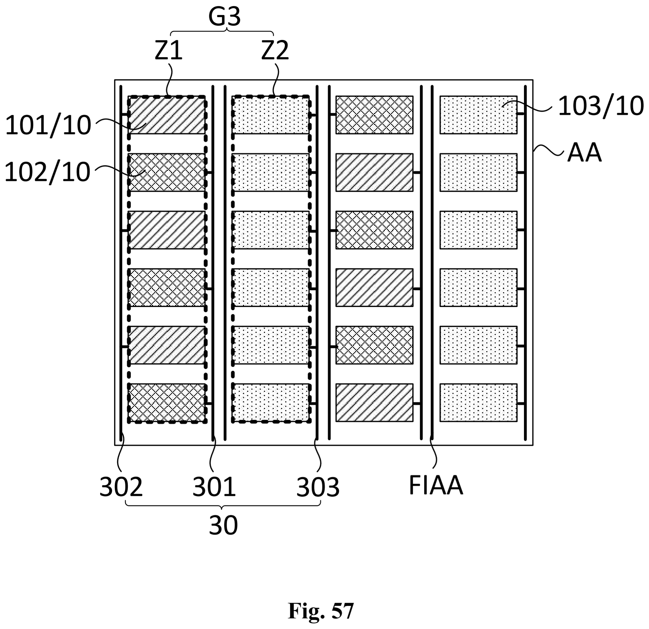

Fig. 57 is a schematic structural diagram of a display panel provided by another embodiment of the present disclosure. As shown in Figs. 46 and 57, in an embodiment, the display region AA comprises a first display region AA1 and a second display region AA2. Along the row direction, the first display region AA1 is located at least on one side of the second display region AA2. The display panel further comprises a plurality of auxiliary signal lines FIAA extending along the column direction and arranged along the row direction. The auxiliary signal lines FIAA are at least partially located in the second display region AA2 and electrically connected to the data signal lines 30 in the first display region AA1. The plurality of first pixel circuit columns Z1 and the plurality of second pixel circuit columns Z2 are divided into a plurality of third pixel circuit column groups G3, and the third pixel circuit column group G3 comprises the first pixel circuit columns Z1 and the second pixel circuit columns Z2 adjacent to each other along the row direction.

The third pixel circuit column group G3 corresponds to one auxiliary signal line FIAA, and the second pixel circuit column Z2 is correspondingly connected to one third data signal line 303. In the third pixel circuit column group G3, the first data signal line 301 and the second data signal line 302 connected to the first pixel circuit column Z1 are respectively located on different sides of the first pixel circuit column Z1. In at least one third pixel circuit column group G3 in the second display region AA2, the auxiliary signal line FIAA and the third data signal line 303 connected to the second pixel circuit column Z2 are respectively located on different sides of the second pixel circuit column Z2.

The positional relationship between the first display region AA1 and the second display region AA2, the connection structure of the auxiliary signal line FIAA, and the structure of the first pixel circuit column Z1 and the second pixel circuit column Z2 in the third pixel circuit column group G3 can be referred to the above embodiments and will not be repeated here.

In this embodiment, as shown in Figs. 46 and 57, one third pixel circuit column group G3 is correspondingly provided with one auxiliary signal line FIAA, and one second pixel circuit column Z2 is correspondingly connected with one third data signal line 303, so that sufficient space can be provided for the auxiliary signal line FIAA while ensuring the transmittance, which is beneficial to increase the distance between the auxiliary signal line FIAA and the data signal line 30, reduce the coupling capacitance between the auxiliary signal line FIAA and the data signal line 30, and further reduce the mutual interference of data signals between the auxiliary signal line FIAA and the data signal line 30.

Further, as shown in Figs. 46 and 57, in the third pixel circuit column group G3, the first data signal line 301 and the second data signal line 302 connected to the first pixel circuit column Z1 are respectively located on different sides of the first pixel circuit column Z1. In the row direction, the first data signal line 301 and the second data signal line 302 are both spaced apart from the first pixel circuit column Z1, which can avoid the formation of parasitic capacitance between the first data signal line 301 and the second data signal line 302 and the metal layers of the pixel circuit 10 in the first pixel circuit column Z1, thereby alleviating the influence of the first data signal line 301 and the second data signal line 302 on the performance of the pixel circuit 10. In the row direction, there is a larger distance between the first data signal line 301 and the second data signal line 302, thereby reducing the mutual interference of data signals between the first data signal line 301 and the second data signal line 302.

Similarly, in at least one third pixel circuit column group G3, the auxiliary signal line FIAA and the third data signal line 303 connected to the second pixel circuit column Z2 are respectively located on different sides of the second pixel circuit column Z2. In the row direction, the auxiliary signal line FIAA and the third data signal line 303 are both spaced apart from the second pixel circuit column Z2, which can avoid the formation of parasitic capacitance between the auxiliary signal line FIAA and the third data signal line 303 and the metal layers of the pixel circuit 10 in the second pixel circuit column Z2, thereby alleviating the influence of the auxiliary signal line FIAA and the third data signal line 303 on the performance of the pixel circuit 10. In the row direction, there is a larger distance between the auxiliary signal line FIAA and the third data signal line 303, thereby reducing the mutual interference of data signals between the auxiliary signal line FIAA and the third data signal line 303.

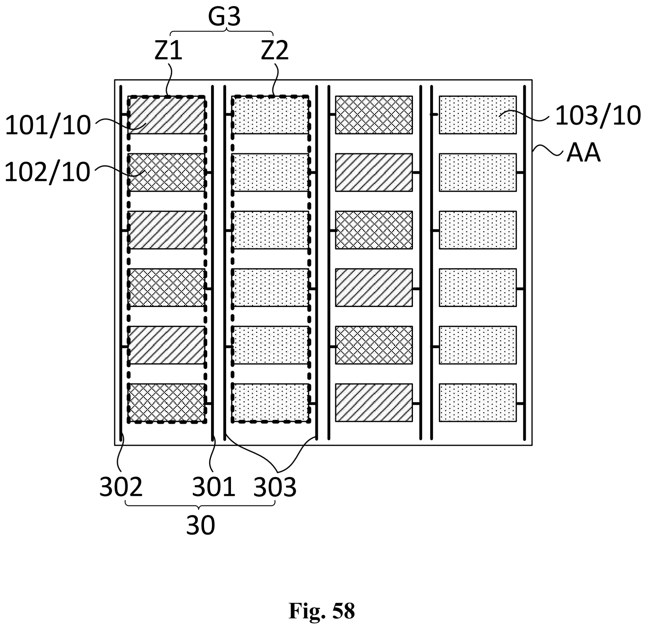

Fig. 58 is a schematic structural diagram of a display panel provided by another embodiment of the present disclosure. As shown in Fig. 58, in an embodiment, in the row direction, the first data signal line 301 connected to the first pixel circuit column Z1 and the second data signal line 302 connected to the second pixel circuit column Z2 are respectively located on opposite sides of the first pixel circuit column Z1. In the row direction, the two third data signal lines 303 connected to the second pixel circuit column Z2 are respectively located on opposite sides of the second pixel circuit column Z2.

Specifically, as shown in Fig. 58, the first pixel circuit column Z1 is correspondingly connected to one first data signal line 301 and one second data signal line 302, in the row direction, the first data signal line 301 and the second data signal line 302 are respectively located on opposite sides of the first pixel circuit column Z1. In the row direction, the first data signal line 301 and the second data signal line 302 are both spaced apart from the first pixel circuit column Z1 by a certain distance, which can avoid the formation of parasitic capacitance between the first data signal line 301 and the second data signal line 302 and the metal layers of the pixel circuit 10 in the first pixel circuit column Z1, thereby alleviating the influence of the first data signal line 301 and the second data signal line 302 on the performance of the pixel circuit 10. In the row direction, there is a larger distance between the first data signal line 301 and the second data signal line 302, thereby reducing the mutual interference of data signals between the first data signal line 301 and the second data signal line 302.

Similarly, the first pixel circuit column Z1 is correspondingly connected to two third data signal lines 303, in the row direction, the two third data signal lines 303 are respectively located on opposite sides of the second pixel circuit column Z2. In the row direction, the two third data signal lines 303 are spaced a certain distance from the second pixel circuit column Z2, which can avoid the formation of parasitic capacitance between the two third data signal lines 303 and the metal layers of the pixel circuit 10 in the second pixel circuit column Z2, thereby alleviating the influence of the auxiliary signal line FIAA and the third data signal line 303 on the performance of the pixel circuit 10. In the row direction, there is a larger distance between the two third data signal lines 303, thereby reducing the mutual interference of data signals between the two third data signal lines 303.

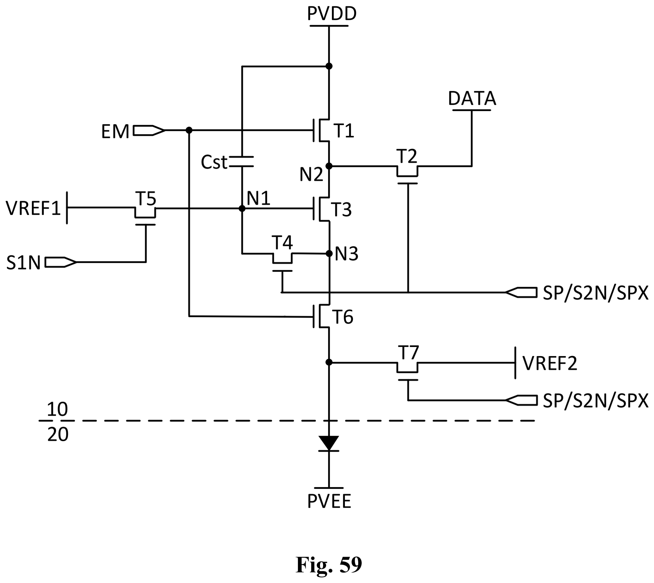

Exemplarily, Fig. 59 is a schematic structural diagram of a pixel circuit provided in another embodiment of the present disclosure. As shown in Fig. 59, the pixel circuit 10 may comprise a first light-emitting control transistor T1, a data writing transistor T2, a driving transistor T3, a threshold compensation transistor T4, an initialization reset transistor T5, a second light-emitting control transistor T6, an anode reset transistor T7 and a storage capacitor Cst.

The connection relationship and function of the first light-emitting control transistor T1, the data writing transistor T2, the driving transistor T3, the threshold compensation transistor T4, the initialization reset transistor T5, the second light-emitting control transistor T6, the anode reset transistor T7 and the storage capacitor Cst can be referred to the above embodiments and will not be repeated here.

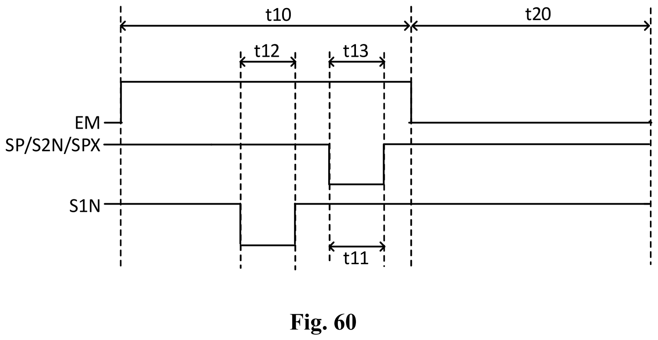

Fig. 60 is a timing diagram of signals provided to the pixel circuit shown in Fig. 59 in a driving cycle, according to an embodiment of the present disclosure. As shown in Figs. 59 and 60, the operation process of the pixel circuit 10 may comprise a pre-stage t10 and a light-emitting stage t20. The pre-stage t10 is a stage in which the light-emitting element 20 does not emit light, and the light-emitting stage t20 is a stage in which the light-emitting element 20 emits light. In some cases, the pre-stage t10 and the light-emitting stage t20 may proceed sequentially.

The pre-stage t10 and the light-emitting stage t20 may be referred to the above embodiments and will not be repeated here.

Continue referring to Figs. 59 and 60, in an embodiment, the pre-stage t10 of the pixel circuit 10 may comprise a reset stage t12.

In the reset stage t12, the first scanning signal S1N is an effective signal at a low level, so that the initialization reset transistor T5 is turned on, and the first reference signal VREF1 is transmitted to the gate of the driving transistor T3 (i.e., the first node N1) via the turned on initialization reset transistor T5, thereby resetting the gate of the driving transistor T3. In this situation, the gate potential of the driving transistor T3 is consistent with the potential of the first reference signal VREF1, so as to prevent the data signal of the previous frame carried on the gate of the driving transistor T3 from affecting the writing of the data signal of the next frame.

Continue referring to Figs. 59 and 60, in an embodiment, the pre-stage t10 of the pixel circuit 10 may further comprise a data writing stage t13.

In the data writing stage t13, the third scanning signal SP and the second scanning signal S2N are both low level effective pulses, so that the data writing transistor T2 and the threshold compensation transistor T4 are turned on. Meanwhile, the gate potential of the driving transistor T3 is consistent with the first reference signal VREF1, and the driving transistor T3 is also turned on. The data signal passes through the data writing transistor T2, the driving transistor T3 and the threshold compensation transistor T4 and is applied to the gate of the driving transistor T3 (i.e., the first node N1), and the potential of the first node N1 is gradually increased until the driving transistor T3 is turned off. When the driving transistor T3 is turned off, the gate potential of the driving transistor T3 is Vdata-|Vth|, where Vdata is the voltage of the data signal DATA, and |Vth| is the threshold voltage of the driving transistor T3.

Continue referring to Figs. 59 and 60, in an embodiment, after the data writing stage t13 ends, the display panel may enter the light-emitting stage t20.

In the light-emitting stage t20, the light-emitting control signal EM is an effective pulse at a low level, the first light-emitting control transistor T1 and the second light-emitting control transistor T6 are turned on, and due to the turning on of the first light-emitting control transistor T1, the positive power voltage PVDD is transmitted to the first end of the driving transistor T3 (i.e., the second node N2), and the voltage difference between the first end of the driving transistor T3 (i.e., the second node N2) and its gate (i.e., the first node N1) is PVDD-(Vdata-|Vth|), so that the driving current generated by the driving transistor T3 is K*(Vdata-PVDD)2, where K is a coefficient related to the size and material of the driving transistor T3, so that the driving current generated by the driving transistor T3 is independent of its own threshold voltage |Vth|, and the driving current is transmitted to the anode of the light-emitting element 20 via the turned on second light-emitting control transistor T6, so that the light-emitting element 20 emits light.

Continue referring to Figs. 59 and 60, in an embodiment, the pre-stage t10 of the pixel circuit 10 may comprise an initialization stage t11.

In the initialization stage t11, the fourth scanning signal SPX is an effective pulse at a low level, so that the anode reset transistor T7 is turned on, and the second reference signal VREF2 is transmitted to the anode of the light-emitting element 20 via the anode reset transistor T7 to initialize the anode of the light-emitting element 20, thereby preventing the driving current provided to the anode of the light-emitting element 20 in the previous frame from affecting the display brightness of the light-emitting element 20 in the next frame.

The transistors in the pixel circuit 10 may be all low temperature poly-silicon (LTPS) transistors, which have the advantages of high switching speed, high carrier mobility and low power. Oxide transistors have the advantages of low leakage current, which is not limited thereto.

Furthermore, the fourth scanning signal SPX, the second scanning signal S2N and the third scanning signal SP may be the same scanning signal, thereby reducing the number of scanning signal lines and reducing the cost.

It can be understood that the above is only exemplary descriptions of the types of and the corresponding driving process transistors in the pixel circuit 10. In the embodiments of the present disclosure, in the case that the types of transistors in the pixel circuit 10 are changed, driving processes similar to the above can be realized by changing the signal received by the gate of each transistor, which will not be repeated here.

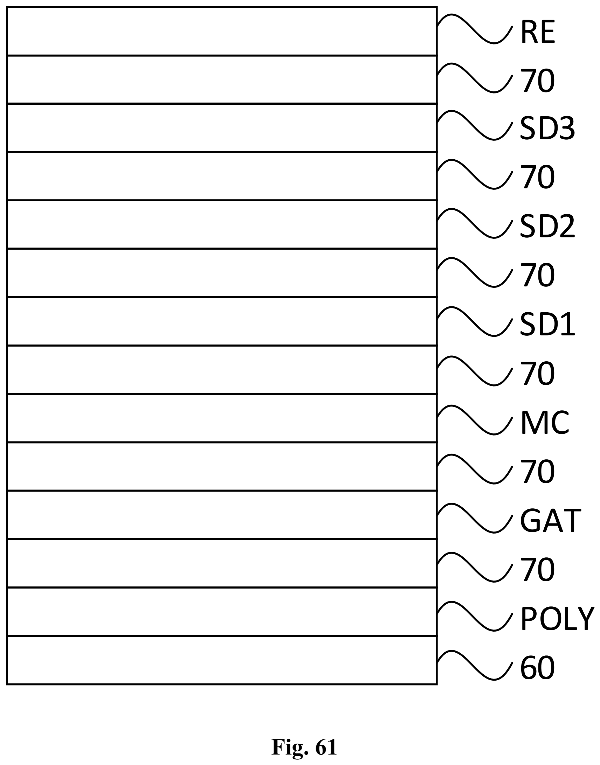

Exemplarily, Fig. 61 is a schematic structural diagram of the film layers of a display panel provided in another embodiment of the present disclosure. As shown in Fig. 61, taking the LTPS display panel as an example, a first semiconductor layer POLY, a first metal layer GAT, a second metal layer MC, a fourth metal layer SD1, a fifth metal layer SD2, a sixth metal layer SD3 and an anode layer RE are stacked on one side of the base substrate 60, and an insulating layer 70 can be provided between any two adjacent conductive film layers to avoid a short circuit between the two adjacent conductive film layers.

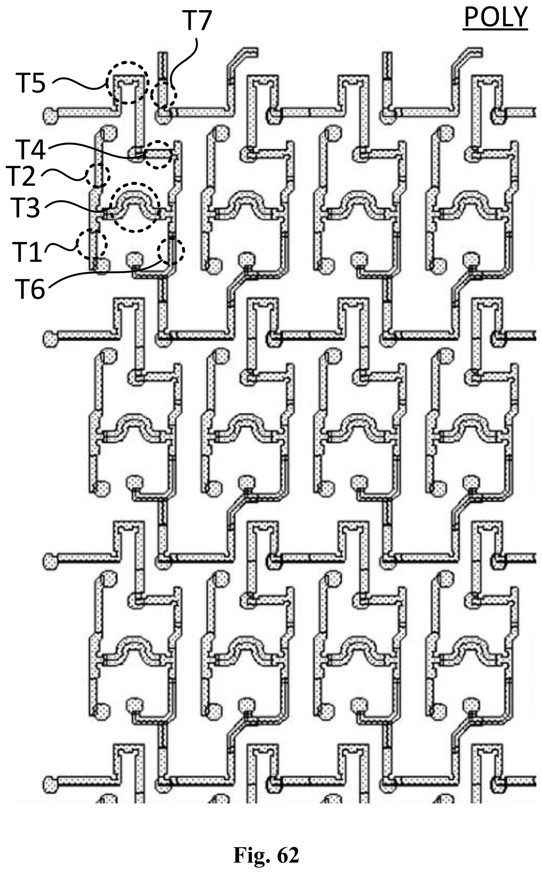

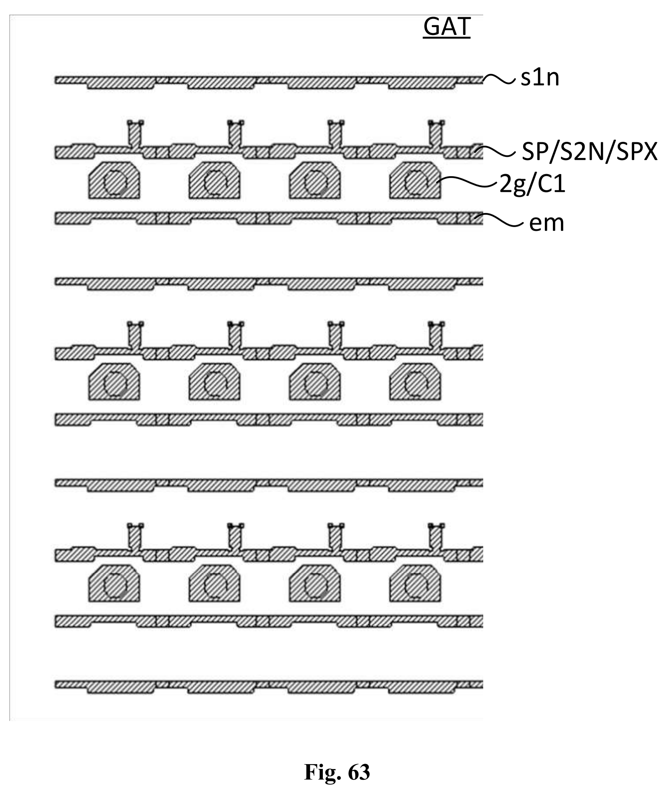

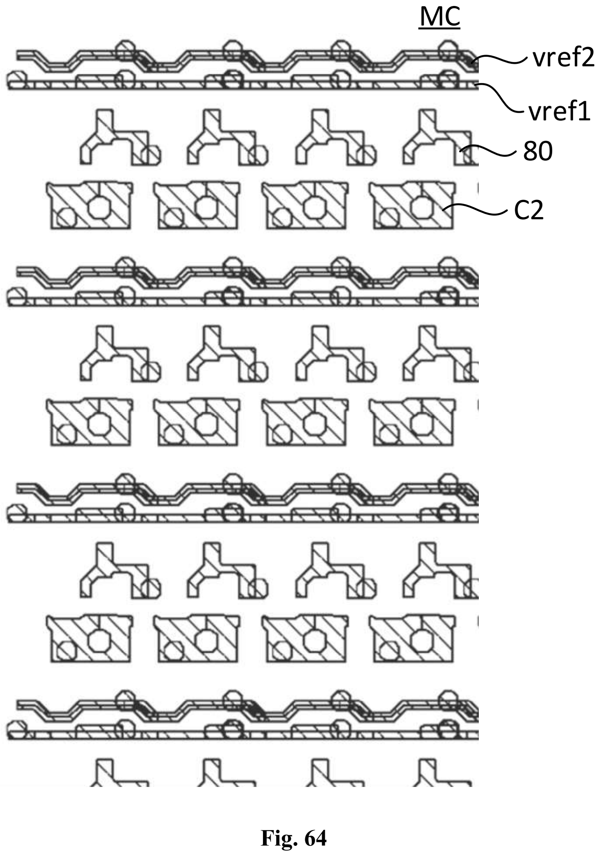

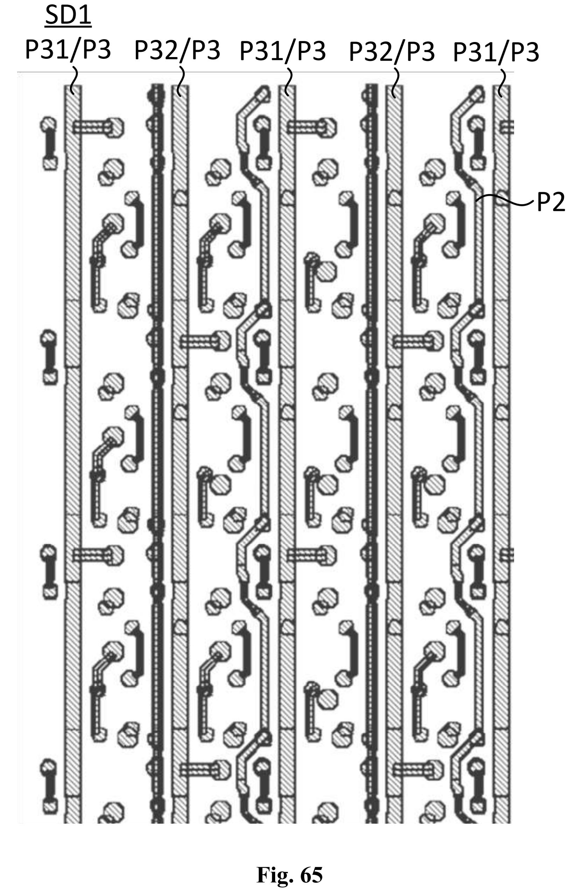

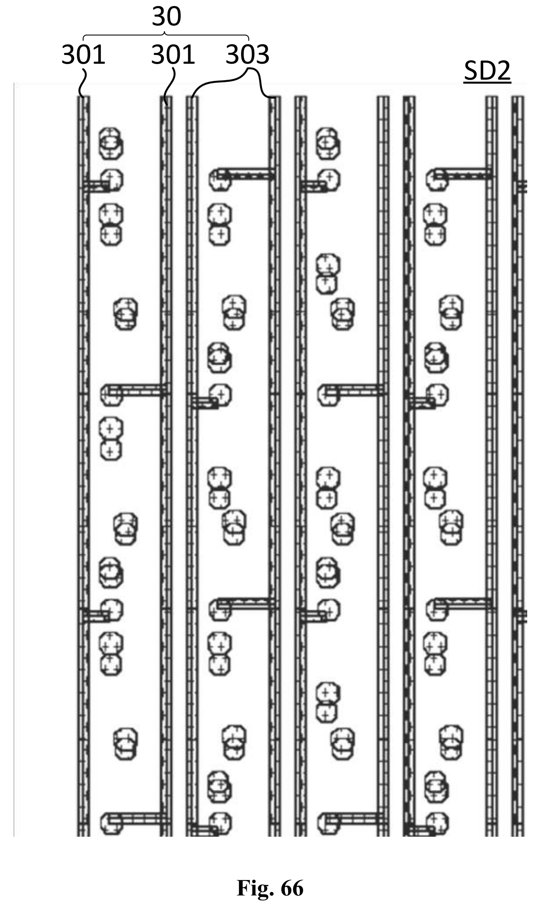

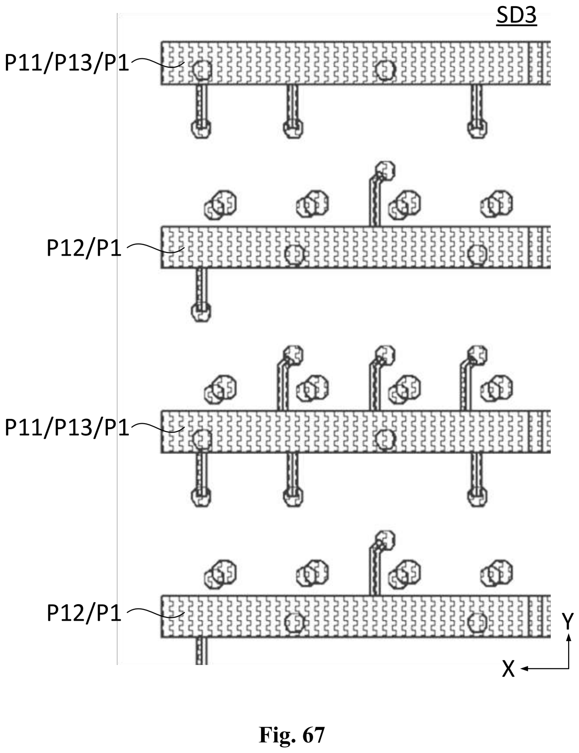

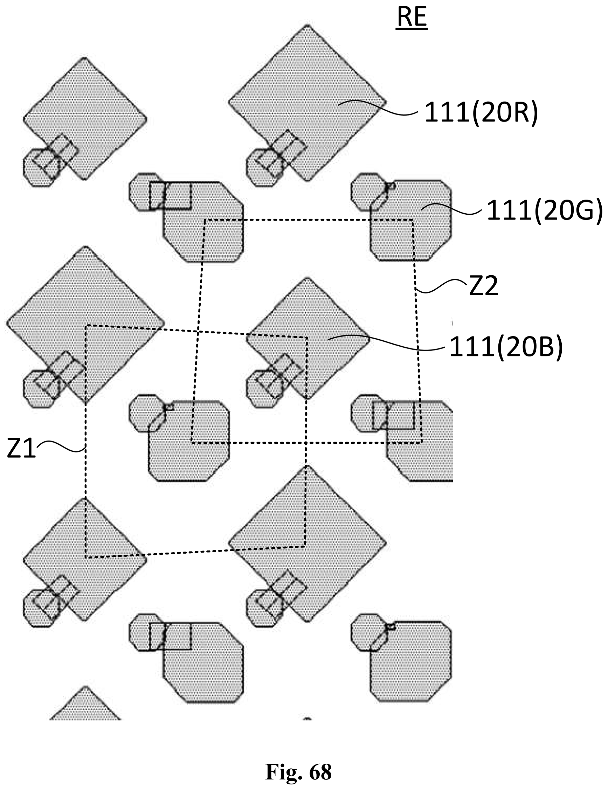

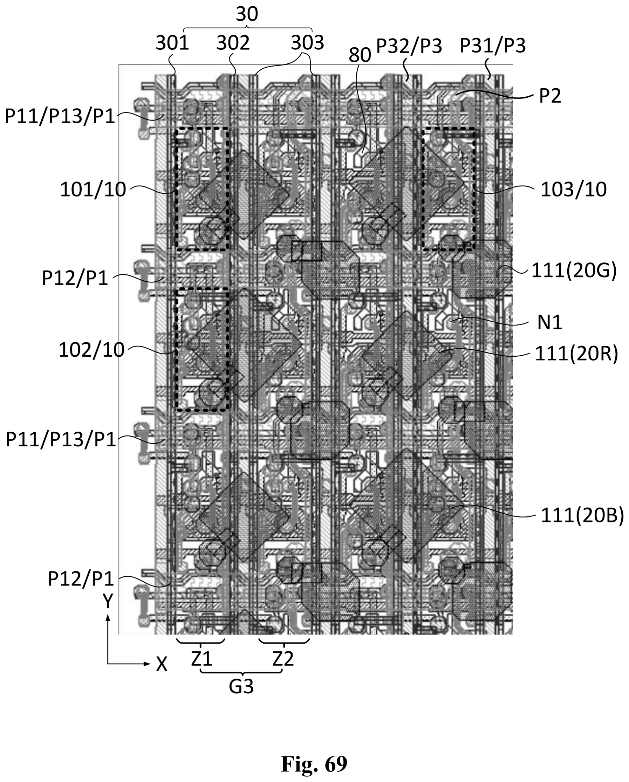

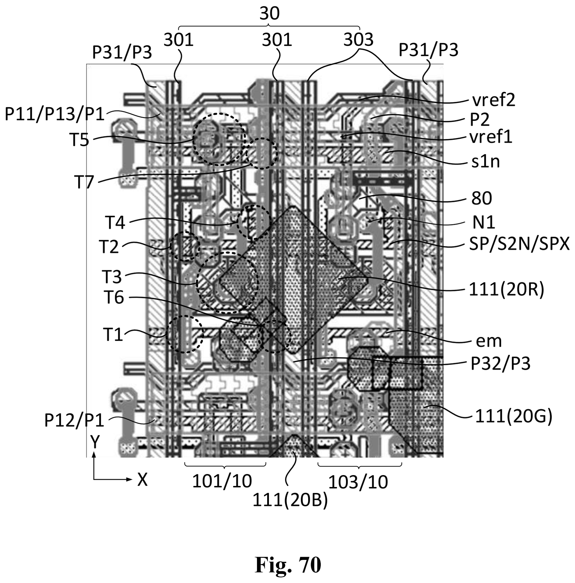

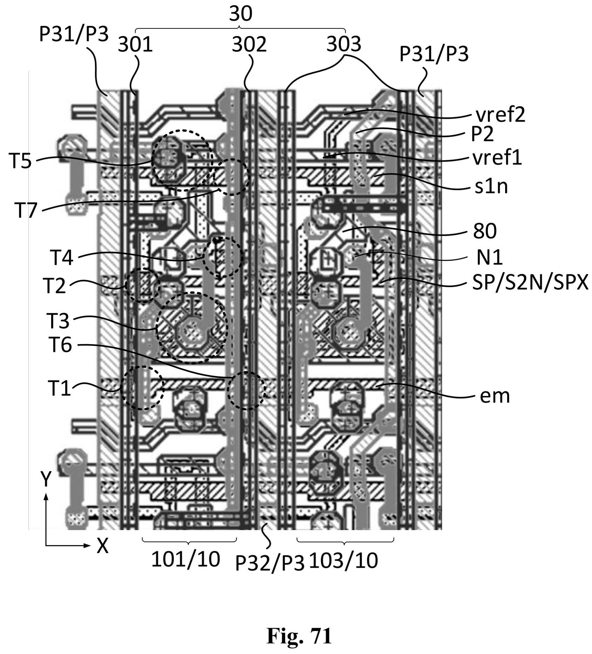

Fig. 62 is a schematic structural diagram of a first semiconductor layer in the display panel shown in Fig. 61; Fig. 63 is a schematic structural diagram of a first metal layer in the display panel shown in Fig. 61; Fig. 64 is a schematic structural diagram of a second metal layer in the display panel shown in Fig. 61; Fig. 65 is a schematic structural diagram of a fourth metal layer in the display panel shown in Fig. 61; Fig. 66 is a schematic structural diagram of a fifth metal layer in the display panel shown in Fig. 61; Fig. 67 is a schematic structural diagram of a sixth metal layer in the display panel shown in Fig. 61; Fig. 68 is a schematic structural diagram of an anode layer in the display panel shown in Fig. 61; Fig. 69 is a schematic diagram of the stacked structure of all film layers in the display panel shown in Fig. 61, specifically a schematic diagram of the stacked structure from the first semiconductor layer to the anode layer; Fig. 70 is a schematic structural diagram of the film layers of a pixel circuit in the display panel shown in Fig. 61; to clearly illustrate the structure of the pixel circuit, Fig. 71 is a schematic structural diagram of a part of film layers of a pixel circuit in the display panel shown in Fig. 61, specifically a schematic diagram of the stacked structure from the first semiconductor layer to the fifth metal layer.

The film layers shown in Figs. 61 to 71 can correspond to the pixel circuit 10 shown in Fig. 59, in which the first light-emitting control transistor T1, the data writing transistor T2, the driving transistor T3, the threshold compensation transistor T4, the initialization reset transistor T5, the second light-emitting control transistor T6 and the anode reset transistor T7 are all low temperature poly-silicon (LTPS) transistors.

Exemplarily, as shown in Figs. 59 to 71, the active layers of the first light-emitting control transistor T1, the data writing transistor T2, the driving transistor T3, the threshold compensation transistor T4, the initialization reset transistor T5, the second light-emitting control transistor T6 and the anode reset transistor T7 can be located in the first semiconductor layer POLY.

The driving transistor T3, the threshold compensation transistor T4, the initialization reset transistor T5, the second light-emitting control transistor T6, the gate 2g of the anode reset transistor T7, and the first electrode plate C1 of the storage capacitor Cst may be located in the first metal layer GAT.

The first metal layer GAT may further comprise a first scanning signal line sln, a third scanning signal line sp, a fourth scanning signal line spx, a second scanning signal line s2n and a light-emitting control signal line em extending in the row direction. The first scanning signal line s1n is electrically connected to the gate of the initialization reset transistor T5 for transmitting the first scanning signal S1N; the third scanning signal line sp is electrically connected to the gate of the data writing transistor T2 for transmitting the third scanning signal SP; the fourth scanning signal line spx is electrically connected to the gate of the anode reset transistor T7 for transmitting the fourth scanning signal SPX; the second scanning signal line s2n is electrically connected to the gate of the threshold compensation transistor T4 for transmitting the second scanning signal S2N; the light-emitting control signal line em is electrically connected to the gate of the first light-emitting control transistor T1 and the gate of the second light-emitting control transistor T6 for transmitting the light-emitting control signal EM.

Furthermore, the third scanning signal line sp, the fourth scanning signal line spx and the second scanning signal line s2n may be the same scanning signal line, which can reduce the number of scanning signal lines and is beneficial to increasing the light transmission area of the display panel.

The second metal layer MC may comprise a second electrode plate C2 of the storage capacitor Cst, and further comprise a first reference signal line vrefl and a second reference signal line vref2 extending in the row direction. The first reference signal line vrefl is electrically connected to the initialization reset transistor T5 for transmitting the first reference signal VREF1; the second reference signal line vref2 is electrically connected to the anode reset transistor T7 for transmitting the second reference signal VREF2.

The fourth metal layer SD1 may comprise a third power signal line P3 extending along a column direction, the third power signal line P3 is configured to transmit a positive power voltage PVDD.

The fifth metal layer SD2 may comprise data signal lines 30 extending along a column direction and configured to transmit data signals DATA.

The sixth metal layer SD3 may comprise a first power signal line P1 extending along the row direction and electrically connected to the third power signal line P3 extending along the column direction in the fourth metal layer SD1 to form a grid wiring structure, which is beneficial to reducing line resistance, thereby reducing the voltage drop of the positive power voltage PVDD, and ensuring the stability of the positive power voltage PVDD.

The anode layer RE may comprise an anode 111 of the light-emitting element.

It should be noted that the specific film layers of the display panel can be adaptively provided according to actual needs, such as adding or removing some film layers, which are not specifically limited in the embodiments of the present disclosure.

Further, as shown in Figs. 62 to 71, the first data signal line 301 connected to the first pixel circuit column Z1 and the second data signal line 302 connected to the second pixel circuit column Z2 are respectively located on opposite sides of the first pixel circuit column Z1, and the two third data signal lines 303 connected to the second pixel circuit column Z2 are respectively located on opposite sides of the second pixel circuit column Z2. In the row direction, there is a certain distance between the data signal line 30 and the pixel circuit 10, which can present the formation of parasitic capacitance between the data signal line 30 and each metal layer of the pixel circuit 10, thereby alleviating the influence of the data signal line 30 on the performance of the pixel circuit 10. In the row direction, there can be a larger distance between adjacent data signal lines 30, thereby reducing the mutual interference of data signals between adjacent data signal lines 30.

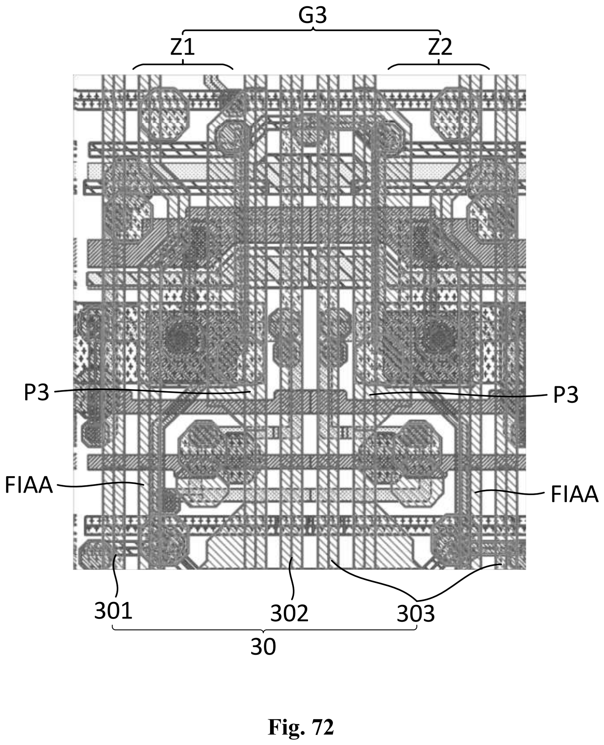

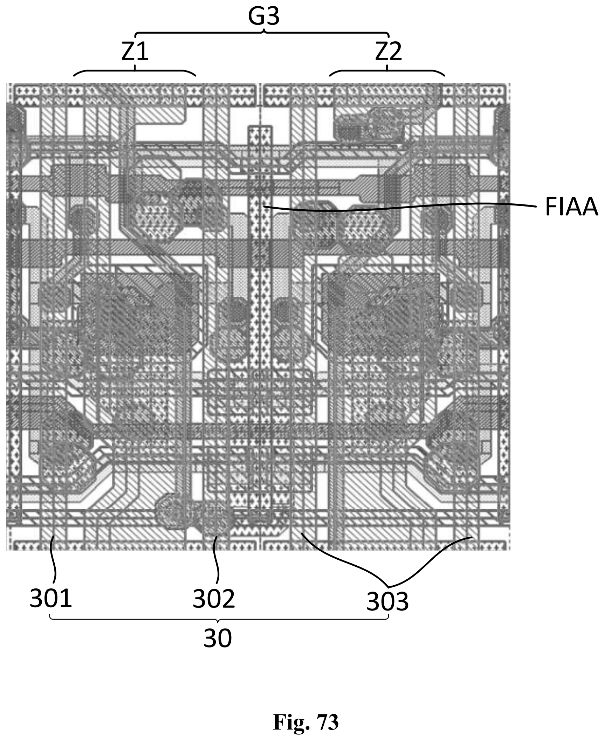

Fig. 72 is a schematic structural diagram of film layers of a pixel circuit provided in an embodiment of the present disclosure, and Fig. 73 is a schematic structural diagram of film layers of a pixel circuit provided in another embodiment of the present disclosure. As shown in Figs. 46, 72 and 73, in an embodiment, the display region AA comprises a first display region AA1 and a second display region AA2, and along the row direction, the first display region AA1 is located at least on one side of the second display region AA2. The display panel further comprises a plurality of auxiliary signal lines FIAA extending along the column direction and arranged along the row direction. The auxiliary signal line FIAA is at least partially located in the second display region AA2 and electrically connected to the data signal line 30 in the first display region AA1.

The auxiliary signal line FIAA and the data signal line 30 are located in different layers.

Or, the auxiliary signal line FIAA and the data signal line 30 are located in the same layer.

The positional relationship between the first display region AA1 and the second display region AA2, and the distribution and connection structure of the auxiliary signal line FIAA may be referred to the above embodiments, which will not be repeated here.

Furthermore, as shown in Fig. 72, the auxiliary signal line FIAA and the data signal line 30 may be located in the same layer, which can reduce the number of layers, thereby facilitating reducing the thickness of the display panel and achieving a thin design.

Exemplarily, as shown in Fig. 72, the auxiliary signal line FIAA and the data signal line 30 may both be located in the sixth metal layer SD3, which is not limited thereto.

Continue referring to Fig. 73, in an embodiment, the auxiliary signal line FIAA and the data signal line 30 can be located in different layers. This helps to increase the distance between the auxiliary signal line FIAA and the data signal line 30, reduce the coupling capacitance between the auxiliary signal line FIAA and the data signal line 30, and thereby reduce the mutual interference of data signals between the auxiliary signal line FIAA and the data signal line 30.

For example, as shown in Fig. 73, the data signal line 30 may be located in the sixth metal layer SD3, and the auxiliary signal line FIAA may be located in the fifth metal layer SD2, which is not limited thereto.

Continue referring to Fig. 72, in an embodiment, the display panel provided in the embodiments of the present disclosure further comprises a plurality of third power signal lines P3 extending in the column direction and arranged in the row direction. One first pixel circuit column Z1 corresponds to one auxiliary signal line FIAA and one third power signal line P3, and the auxiliary signal line FIAA and the third power signal line P3 are located between the first data signal line 301 and the second data signal line 302 connected to the first pixel circuit column Z1. One second pixel circuit column Z2 corresponds to one auxiliary signal line FIAA and one third power signal line P3, and the auxiliary signal line FIAA and the third power signal line P3 are located between the two third data signal lines 303 connected to the second pixel circuit column Z2.

Specifically, as shown in Fig. 72, the third power signal line P3 extends along the column direction and is arranged along the row direction, and is configured to transmit a positive power voltage PVDD having a fixed voltage.

In this embodiment, as shown in Fig. 72, there is a larger distance between the first data signal line 301 and the second data signal line 302 connected to the first pixel circuit column Z1, thereby providing sufficient space for providing the auxiliary signal line FIAA.

One first pixel circuit column Z1 corresponds to one auxiliary signal line FIAA and one third power signal line P3, so as to increase the number of auxiliary signal lines FIAA, thereby increasing the area for arranging the first display region AA1, which is conducive to achieving a narrow bezel effect.

In this embodiment, by providing the auxiliary signal line FIAA between the first data signal line 301 and the second data signal line 302 connected to the first pixel circuit column Z1, the distance between the auxiliary signal line FIAA and the data signal line 30 is increased, reducing the coupling capacitance between the auxiliary signal line FIAA and the data signal line 30, and thereby reducing the mutual interference of data signals between the auxiliary signal line FIAA and the data signal line 30.

Meanwhile, the third power signal line P3 is also arranged between the first data signal line 301 and the second data signal line 302 connected to the first pixel circuit column Z1. The third power signal line P3 can provide a fixed positive power voltage PVDD to serve as a shielding layer for reducing the mutual interference of data signals between the first data signal line 301 and the second data signal line 302 connected to the first pixel circuit column Z1.

Continue referring to Fig. 72, in an embodiment, one second pixel circuit column Z2 corresponds to one auxiliary signal line FIAA and one third power signal line P3 to increase the number of auxiliary signal lines FIAA. This can increase the area for arranging the first display region AA1, which is conducive to achieving a narrow bezel effect.

In this embodiment, by providing the auxiliary signal line FIAA between the two third data signal lines 303 connected to the second pixel circuit column Z2, the distance between the auxiliary signal line FIAA and the third data signal line 303 is increased, reducing the coupling capacitance between the auxiliary signal line FIAA and the third data signal line 303, and thereby reducing the mutual interference of data signals between the auxiliary signal line FIAA and the third data signal line 303.

Meanwhile, the third power signal line P3 is also provided between two third data signal lines 303 connected to the second pixel circuit column Z2. The third power signal line P3 can provide a fixed positive power voltage PVDD, thereby serving as a shielding layer to reduce mutual interference of data signals between the two third data signal lines 303 connected to the second pixel circuit column Z2.

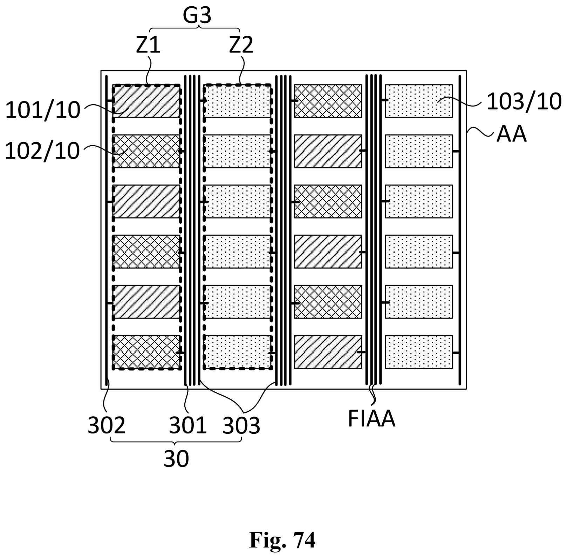

Fig. 74 is a schematic structural diagram of a display panel provided by another embodiment of the present disclosure. As shown in Fig. 74, in an embodiment, one first pixel circuit column Z1 corresponds to one auxiliary signal line FIAA, and one second pixel circuit column Z2 corresponds to one auxiliary signal line FIAA. The auxiliary signal line FIAA is located between two data signal lines 30 between the adjacent first pixel circuit column Z1 and the second pixel circuit column Z2.

Specifically, as shown in Fig. 74, one first pixel circuit column Z1 corresponds to one auxiliary signal line FIAA, and one second pixel circuit column Z2 corresponds to one auxiliary signal line FIAA, so as to increase the number of auxiliary signal lines FIAA. This can increase the area for arranging the first display region AA1, which is conducive to achieving a narrow bezel effect.

Furthermore, as shown in Fig. 74, the auxiliary signal line FIAA is located between two data signal lines 30 between the adjacent first pixel circuit column Z1 and the second pixel circuit column Z2, so that the auxiliary signal line FIAA and the data signal line 30 are in concentrated placement, and the parasitic capacitance between each of the auxiliary signal line FIAA and the data signal line 30 and the metal layers or signal nodes in the pixel circuit 10 is at a similar level, which helps to reduce the loss difference between the data signals transmitted on the auxiliary signal line FIAA and the data signal line 30, thereby improving display uniformity.

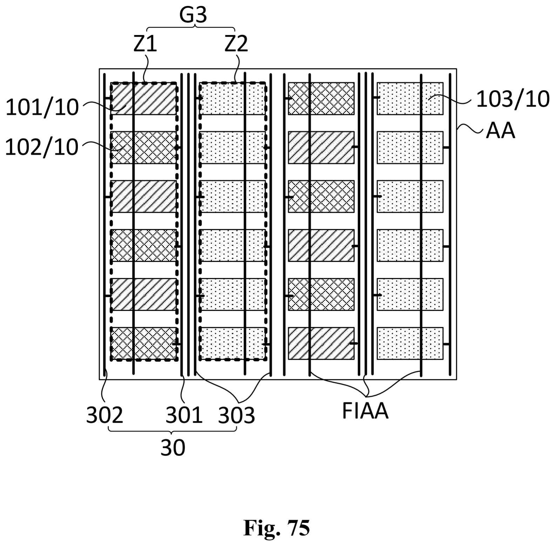

Fig. 75 is a schematic structural diagram of a display panel provided by another embodiment of the present disclosure. As shown in Fig. 75, in an embodiment, multiple first pixel circuit columns Z1 and multiple second pixel circuit columns Z2 are divided into multiple third pixel circuit column groups G3, and the third pixel circuit column group G3 comprises first pixel circuit columns Z1 and second pixel circuit columns Z2 adjacent to each other along the row direction. The third pixel circuit column group G3 corresponds to three auxiliary signal lines FIAA located between any two adjacent data signal lines 30.

The structure of the first pixel circuit column Z1 and the second pixel circuit column in the third pixel circuit column group G3 may be referred to the above embodiments and will not be repeated herein.

Specifically, as shown in Fig. 75, two columns of pixel circuits 10 may correspond to three auxiliary signal lines FIAA. In this situation, one third pixel circuit column group G3 corresponds to three auxiliary signal lines FIAA to increase the number of auxiliary signal lines FIAA. This can increase the area for arranging the first display region AA1, which is conducive to achieving a narrow bezel effect.

Further, as shown in Fig. 75, four data signal lines 30 are correspondingly arranged in the third pixel circuit column group G3. Along the row direction, three auxiliary signal lines FIAA are respectively located between two adjacent data signal lines 30. Thus, in the direction perpendicular to the plane where the display panel is located, the auxiliary signal line FIAA may not overlap with the data signal line 30, which may further reduce the coupling capacitance between the auxiliary signal line FIAA and the data signal line 30, thereby reducing the mutual interference of data signals between the auxiliary signal line FIAA and the data signal line 30.

Meanwhile, in the third pixel circuit column group G3, the three auxiliary signal lines FIAA can be evenly distributed in the gaps between the four data signal lines 30, thereby reducing visual interference caused by uneven light reflection from the auxiliary signal lines FIAA and improving the overall visual effect of the display panel.

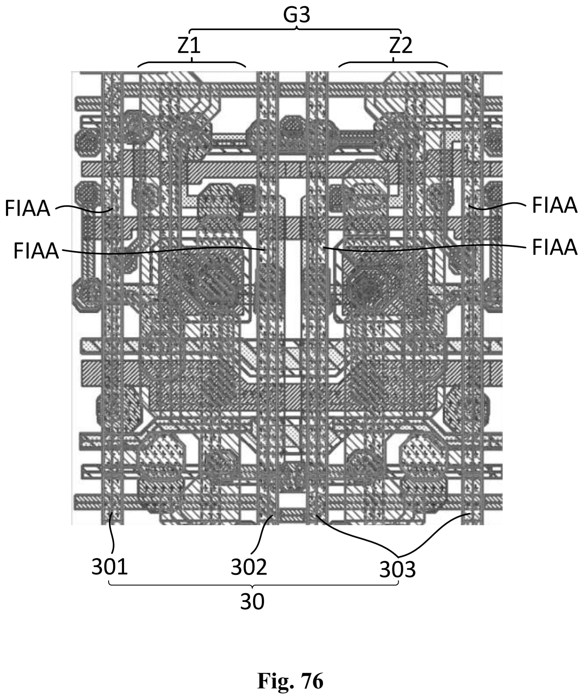

Fig. 76 is a schematic structural diagram of film layers of a pixel circuit provided in another embodiment of the present disclosure. As shown in Fig. 76, in an embodiment, one first pixel circuit column Z1 corresponds to one or two auxiliary signal lines FIAA, and one second pixel circuit column Z2 corresponds to one or two auxiliary signal lines FIAA. In the direction perpendicular to the plane where the display panel is located, the auxiliary signal line FIAA at least partially overlaps with the data signal line 30.

Specifically, as shown in Fig. 76, one first pixel circuit column Z1 may correspond to one or two auxiliary signal lines FIAA, and one second pixel circuit column Z2 may correspond to one or two auxiliary signal lines FIAA, which is conducive to achieving a narrow bezel effect.

Continue referring to Fig. 76, the auxiliary signal line FIAA and the data signal line 30 are located in different layers, and in the direction perpendicular to the plane where the display panel is located, the auxiliary signal line FIAA at least partially overlaps with the data signal line 30. Such a configuration can reduce the overall shielding area of the auxiliary signal line FIAA and the data signal line 30 in the thickness direction of the display panel, thereby increasing the light-transmitting area of the display panel.

It should be noted that Fig. 76 only takes an example that one first pixel circuit column Z1 corresponds to two auxiliary signal lines FIAA and one second pixel circuit column Z2 corresponds to two auxiliary signal lines FIAA, which is not limited thereto.

In addition, Fig. 76 illustrates an example in which the auxiliary signal lines FIAA overlap with the data signal lines 30 in a one-to-one correspondence, which is not limited thereto.

Continue referring to Figs. 46 and 76, in an embodiment, the display region AA comprises a first display region AA1 and a second display region AA2, and along the row direction, the first display region AA1 is located at least on one side of the second display region AA2. The display panel further comprises a plurality of auxiliary signal lines FIAA extending along the column direction and arranged along the row direction. The auxiliary signal lines FIAA are at least partially located in the second display region AA2 and electrically connected to the data signal lines 30 in the first display region AA1.

One first pixel circuit column Z1 corresponds to at least two auxiliary signal lines FIAA, and one second pixel circuit column Z2 corresponds to at least two auxiliary signal lines FIAA.

The positional relationship between the first display region AA1 and the second display region AA2, and the connection structure of the auxiliary signal line FIAA may be referred to the above embodiments, which will not be repeated herein.

In this embodiment, as shown in Figs. 46 and 76, one first pixel circuit column Z1 corresponds to at least two auxiliary signal lines FIAA, and one second pixel circuit column Z2 corresponds to at least two auxiliary signal lines FIAA, so as to increase the number of auxiliary signal lines FIAA. In this way, the area for arranging the first display region AA1 can be increased, which is conducive to achieving a narrow bezel effect.

It should be noted that Fig. 76 only takes an example that one first pixel circuit column Z1 corresponds to two auxiliary signal lines FIAA and one second pixel circuit column Z2 corresponds to two auxiliary signal lines FIAA, which is not limited thereto.

In other embodiments, one first pixel circuit column Z1 may be provided with more auxiliary signal lines FIAA, and one second pixel circuit column Z2 may be provided with more auxiliary signal lines FIAA, which are not specifically limited in the embodiments of the present disclosure.

In an embodiment, the number of auxiliary signal lines FIAA corresponding to one first pixel circuit column Z1 is less than or equal to 4, and the number of auxiliary signal lines FIAA corresponding to one second pixel circuit column Z2 is less than or equal to 4.

As can be seen from the above embodiments, the number of auxiliary signal lines FIAA corresponding to one first pixel circuit column Z1 can be one, two, three or four, and the number of auxiliary signal lines FIAA corresponding to one second pixel circuit column Z2 can be one, two, three or four. In this way, a narrow bezel effect is achieved, while an excessive number of auxiliary signal lines FIAA can be avoided, thereby effectively controlling the mutual interference between the auxiliary signal lines FIAA and the data signal lines 30, while further helping to ensure that the display panel has sufficient light-transmitting area.

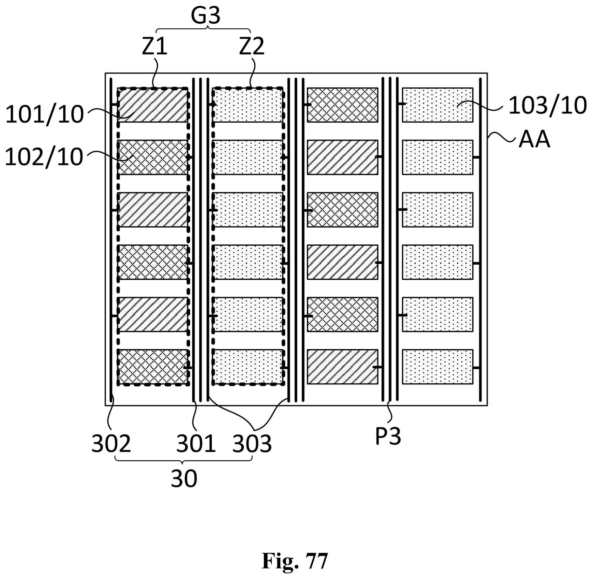

Fig. 77 is a schematic structural diagram of a display panel provided by another embodiment of the present disclosure. As shown in Fig. 77, in an embodiment, the display panel provided by the embodiments of the present disclosure further comprises a plurality of third power signal lines P3 extending along the column direction and arranged along the row direction. One first pixel circuit column Z1 corresponds to one third power signal line P3, and one second pixel circuit column Z2 corresponds to one third power signal line P3. Along the row direction, the third power signal line P3 is located between two data signal lines 30 between the adjacent first pixel circuit column Z1 and the second pixel circuit column Z2.

Specifically, as shown in Fig. 77, the third power signal line P3 extends along the column direction and is arranged along the row direction, and is configured to transmit a positive power voltage PVDD having a fixed voltage.

In this embodiment, as shown in Fig. 77, the third power signal line P3 is arranged between two data signal lines 30 between the adjacent first pixel circuit column Z1 and the second pixel circuit column Z2. The third power signal line P3 can provide a fixed positive power voltage PVDD, so that it can serve as a shielding layer to reduce signal interference between the data signal line 30 connected to the first pixel circuit column Z1 and the data signal line 30 connected to the second pixel circuit column Z2.

Continue referring to Figs. 69 to 71, in an embodiment, in the direction perpendicular to the plane where the display panel is located, the third power signal line P3 and the data signal line 30 are located in different layers, and the third power signal line P3 at least partially overlaps with the two data signal lines 30 between the adjacent first pixel circuit column Z1 and the second pixel circuit column Z2.

Specifically, as shown in Figs. 69 to 71, by arranging the third power signal line P3 and the data signal line 30 in different layers, it is beneficial to increase the space for arranging the third power signal line P3, thereby increasing the area for arranging the third power signal line P3, which is beneficial to reducing the line resistance, and further reducing the signal voltage drop on the third power signal line P3, thereby ensuring the stability of the positive power voltage PVDD.

For example, as shown in Figs. 69 to 71, the data signal line 30 may be located in the fifth metal layer SD2, and the third power signal line P3 may be located in the fourth metal layer SD1, which is not limited thereto.

Furthermore, as shown in Figs. 69 to 71, in the direction perpendicular to the plane where the display panel is located, the third power signal line P3 at least partially overlaps with the two data signal lines 30 between the adjacent first pixel circuit column Z1 and the second pixel circuit column Z2. The third power signal line P3 can provide a fixed positive power voltage PVDD, thereby serving as a shielding layer to reduce signal interference between the data signal line 30 connected to the first pixel circuit column Z1 and the data signal line 30 connected to the second pixel circuit column Z2, and further reduce signal interference between the data signal line 30 and other film layers.

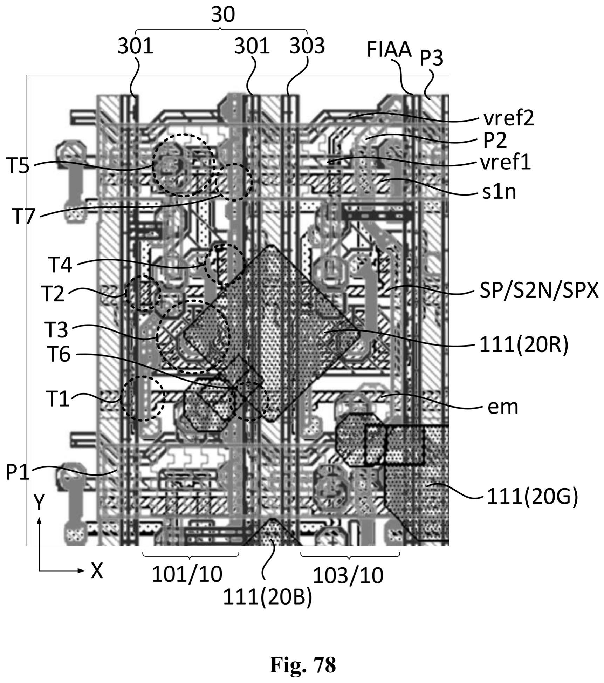

Fig. 78 is a schematic structural diagram of film layers of a pixel circuit provided in another embodiment of the present disclosure. As shown in Figs. 46 and 78, in an embodiment, the display region AA comprises a first display region AA1 and a second display region AA2, and along the row direction, the first display region AA1 is located at least on one side of the second display region AA2. The display panel further comprises a plurality of auxiliary signal lines FIAA extending along the column direction and arranged along the row direction. The auxiliary signal line FIAA is at least partially located in the second display region AA2 and electrically connected to the data signal line 30 in the first display region AA1.

The auxiliary signal line FIAA and the third power signal line P3 are located in different layers.

In the direction perpendicular to the plane where the display panel is located, the auxiliary signal line FIAA at least partially overlaps with the third power signal line P3.

The positional relationship between the first display region AA1 and the second display region AA2, and the connection structure of the auxiliary signal line FIAA may be referred to the above embodiments, which will not be repeated herein.

In this embodiment, as shown in Figs. 46 and 78, by providing the third power signal line P3 and the auxiliary signal line FIAA in different layers, it is beneficial to increase the space for arranging the third power signal line P3, thereby increasing the area for arranging the third power signal line P3, which is beneficial to reducing the line resistance, and further reducing the signal voltage drop on the third power signal line P3, thereby ensuring the stability of the positive power voltage PVDD.

Further, as shown in Figs. 46 and 78, in the direction perpendicular to the plane where the display panel is located, the auxiliary signal line FIAA at least partially overlaps with the third power signal line P3, and the third power signal line P3 can provide a fixed positive power voltage PVDD, thereby serving as a shielding layer to reduce signal interference between the auxiliary signal line FIAA and other film layers.

Continue referring to Figs. 69 to 71, in an embodiment, the light-emitting element 20 comprises a red light-emitting element 20R, a blue light-emitting element 20B and a green light-emitting element 20G. In the direction perpendicular to the plane where the display panel is located, the red light-emitting element 20R, the green light-emitting element 20G and the blue light-emitting element 20B all at least partially overlap with the third power signal line P3 between the adjacent first pixel circuit column Z1 and the second pixel circuit column Z2.

Specifically, the inventors have discovered through research that, in the direction perpendicular to the plane where the display panel is located, there are wirings with smaller line widths in the film layer below the light-emitting element 20, causing the anode 111 located above the wirings to bulge upward, affecting the flatness of the anode 111, and further causing the light-emitting layer 112 above the anode 111 to be uneven. As a result, when the display panel is viewed at the same inclination angle in different orientations, there are differences in the brightness of the light-emitting layer 112, resulting in inconsistent color deviation at the same inclination angle in different orientations, that is, there is a problem of inconsistent color deviation in different directions, which affects the display effect of the display panel.

In this embodiment, since the third power signal line P3 usually has a larger line width, the red light-emitting element 20R, the green light-emitting element 20G and the blue light-emitting element 20B all at least partially overlap with the third power signal line P3 between the adjacent first pixel circuit column Z1 and the second pixel circuit column Z2, which is beneficial to improving the flatness of the anode 111, and thereby reducing the brightness difference of the organic light-emitting layer when the display panel is viewed at the same inclination angle in different directions, reducing the color deviation difference at the same inclination viewing angle in different directions, alleviating the problem of inconsistent color deviation in different directions, and improving the display effect of the display panel.

Continue referring to Figs. 69 to 71, in an embodiment, the light-emitting element 20 comprises a red light-emitting element 20R, a blue light-emitting element 20B, and a green light-emitting element 20G. In the direction perpendicular to the plane where the display panel is located, the red light-emitting element 20R, the green light-emitting element 20G, and the blue light-emitting element 20B at least partially overlap with the data signal line 30 between the adjacent first pixel circuit column Z1 and the second pixel circuit column Z2.

Specifically, as shown in Figs. 69 to 71, in the direction perpendicular to the plane where the display panel is located, the red light-emitting element 20R, the green light-emitting element 20G and the blue light-emitting element 20B all at least partially overlap with the data signal line 30 between the adjacent first pixel circuit column Z1 and the second pixel circuit column Z2, which can reduce the overall shielding area of the data signal line 30 and the light-emitting element 20 in the thickness direction of the display panel, thereby helping to increase the light-transmitting area of the display panel.

Continue referring to Figs. 59 to 71, in an embodiment, the pixel circuit 10 further comprises a driving transistor T3, a threshold compensation transistor T4 and a shielding layer 80, the gate of the driving transistor T3 and the threshold compensation transistor T4 are connected to a first node N1. The shielding layer 80 is at least partially located between the first node N1 and the data signal line 30 in the direction parallel to the plane where the display panel is located.

The connection structure and function of the driving transistor T3 and the threshold compensation transistor T4 may be referred to the above embodiments, which are not specifically limited in the embodiments of the present disclosure.

It is understandable that the potential of the gate of the driving transistor T3 (i.e., the first node N1) determines the magnitude of the driving current formed by its turning on, and the magnitude of the driving current can determine the brightness of the light-emitting element 20. Therefore, the accuracy and stability of the potential of the first node N1 are crucial to the display effect of the display panel.

In this embodiment, the shielding layer 80 is arranged between the first node N1 and the data signal line 30 along the direction parallel to the plane where the display panel is located, so as to reduce the signal interference between the first node N1 and the data signal line 30 via the shielding layer 80, improve the accuracy and stability of the potential of the first node N1, and thus help to improve the display effect of the display panel.

The shape of the shielding layer 80 can be set according to actual needs, which are not specifically limited in the embodiments of the present disclosure.

Continue referring to Figs. 59-71, in an embodiment, in the direction perpendicular to the plane where the display panel is located, the shielding layer 80 is located between the active layer of the driving transistor T3 and the data signal line 30, and the shielding layer 80 at least partially overlaps with the data signal line 30.

Specifically, as shown in Figs. 59 to 71, in the direction perpendicular to the plane where the display panel is located, by providing a shielding layer 80 between the active layer of the driving transistor T3 and the data signal line 30 and at least partially overlapping with the data signal line 30. The shielding layer 80 can play a shielding role in the direction perpendicular to the plane where the display panel is located, thereby further reducing the signal interference between the first node N1 and the data signal line 30, improving the accuracy and stability of the potential of the first node N1, and further helping to improve the display effect of the display panel.

As shown in Figs. 59 to 71, the shielding layer 80 may be disposed on the second metal layer MC, which is not limited thereto.

In an embodiment, a fixed voltage is applied to the shielding layer 80.

By applying a fixed voltage on the shielding layer 80 so that the voltage on the shielding layer 80 is a constant voltage, the influence of the shielding layer 80 on the pixel circuit 10 can be reduced.

Meanwhile, the shielding layer 80 can also shield the signal lines and signal nodes that have overlapping areas with the shielding layer 80, thereby helping to reduce mutual interference between the signal lines and signal nodes in the pixel circuit 10 and improving the driving performance of the pixel circuit 10.

Continue referring to Figs. 59 to 71 and 78, in an embodiment, the display panel provided in the embodiments of the present disclosure further comprises a plurality of third power signal lines P3 extending along the second direction Y and arranged along the first direction X intersecting with the second direction Y, and the shielding layer 80 is electrically connected to the third power signal lines P3.

The third power signal line P3 is configured to provide a positive power voltage PVDD for the pixel circuit 10. The positive power voltage PVDD is a direct current signal, not an alternating current (AC) signal.

As shown in Figs. 59 to 71 and Fig. 78, in this embodiment, the shielding layer 80 is electrically connected to the third power signal line P3, and a constant voltage can be provided to the shielding layer 80 via the third power signal line P3, thereby reducing the number of signal lines and helping to increase the light transmittance area of the display panel.

Meanwhile, after the third power signal line P3 is electrically connected to the shielding layer 80, the wiring area of the third power signal line P3 is increased, thereby reducing the resistance of the third power signal line P3 and further reducing the voltage drop (IR drop) on the third power signal line P3, which helps to improve display uniformity.

It should be noted that the connection between the third power signal line P3 and the shielding layer 80 can be realized in the display region AA or in the non-display region NAA, or can be realized via other wirings, which are not specifically limited in the embodiments of the present disclosure.

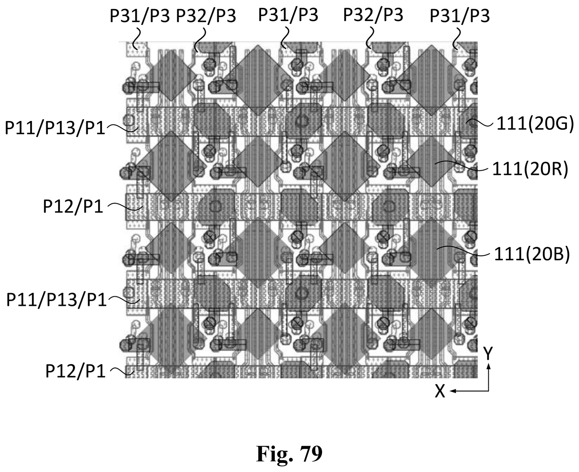

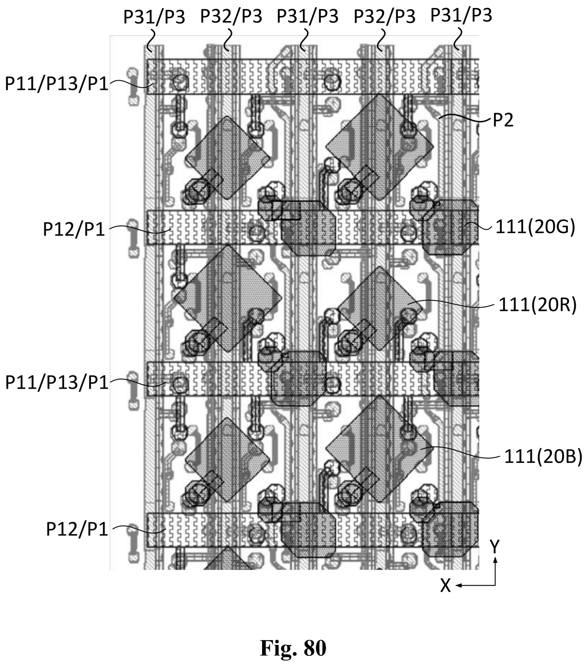

Fig. 79 is a schematic diagram of a stacked structure of a part of the film layers in the display panel shown in Fig. 24, specifically a schematic diagram of a stacked structure from the fifth metal layer to the anode layer; Fig. 80 is a schematic diagram of a stacked structure of a part of the film layers in the display panel shown in Fig. 61, specifically a schematic diagram of a stacked structure from the fourth metal layer to the anode layer; As shown in Figs. 24 to 36, 61 to 70, 79 and 80, in an embodiment, the display panel provided in the embodiments of the present disclosure further comprises a plurality of first power signal lines P1 extending along the first direction X and arranged along the second direction Y intersecting with the first direction X. The plurality of first power signal lines P1 comprise a first power voltage signal line P11, a second power voltage signal line P12 and a third power voltage signal line P13. The first power voltage signal line P11 is connected to the first pixel circuit 101, the second power voltage signal line P12 is connected to the second pixel circuit 102, and the third power voltage signal line P13 is connected to the third pixel circuit 103. The first power voltage signal line P11 is configured to transmit a first power voltage, the second power voltage signal line P12 is configured to transmit a second power voltage, and the third power voltage signal line P13 is configured to transmit a third power voltage. At least two of the first power voltage, the second power voltage and the third power voltage are different.

Specifically, as shown in Figs. 4, 24 to 36, 59, 61 to 70, 79 and 80, the first power signal line P1 is configured to provide a positive power voltage PVDD to the pixel circuit 10, the driving transistor T3 and the light-emitting element 20 in the pixel circuit 10 are connected in series between the first power signal line P1 and the second power signal line P2, the first power signal line P1 transmits the positive power voltage PVDD, and the second power signal line P2 is configured to transmit the negative power voltage PVEE, and the positive power voltage PVDD may be greater than the negative power voltage PVEE. A driving current is generated by the potential difference between the first power signal line P1 and the second power signal line P2, thereby driving the light-emitting element 20 to emit light.

The inventor has found through research that the different materials of the light-emitting layer 112 in the light-emitting element 20 that emits light of different colors will cause the pixel capacitors of the light-emitting elements 20 that emit light of different colors to have different capacitance values. In the light-emitting stage, the anode 111 and the cathode 113 of the light-emitting element 20 are connected, and the pixel capacitor of the light-emitting element 20 will be charged first. In this situation, the anode potential of the light-emitting element 20 gradually rises. When the pixel capacitor of the light-emitting element 20 is fully charged, the voltage across the light-emitting element 20 reaches a start-up voltage, and the light-emitting element 20 begins to emit light continuously. The smaller the pixel capacitance of the light-emitting element 20, the smaller the voltage difference between the anode and the cathode when the pixel capacitance is fully charged, and the smaller the start-up voltage; similarly, the larger the pixel capacitance of the light-emitting element 20, the greater the voltage difference between the anode and the cathode when the pixel capacitance is fully charged, and the greater the start-up voltage. It can be understood that the start-up voltage is the voltage across the light-emitting element when the pixel capacitance is fully charged, and the light-emitting element 20 starts to emit light when the voltage across the light-emitting element reaches the start-up voltage.

In order to ensure that the driving transistor T3 in all color sub-pixels can operate in a saturation region, that is, to ensure that all sub-pixels can reach sufficient power voltage to drive the sub-pixels to reach their maximum brightness, the voltage difference between the positive power voltage PVDD and the negative power voltage PVEE needs to be able to meet the requirement on the voltage across the light-emitting element 20 with the largest start-up voltage among all color sub-pixels. For the sub-pixels with a smaller start-up voltage of the light-emitting element 20, the voltage value of the positive power voltage PVDD may have a certain margin.

Among them, the power consumption power2 of the sub-pixel can satisfy the following formula:

$$power2=(PVDD-PVEE)\times I;$$

where I is the magnitude of the drive current.

It can be seen from the above formula that the greater the voltage difference between the positive power voltage PVDD and the negative power voltage PVEE, the higher the power consumption of the sub-pixel. Therefore, when there is margin in the voltage value of the positive power voltage PVDD, there will be unnecessary power consumption loss, thereby increasing the power consumption of the display panel.

Based on the above technical problems, in this embodiment, as shown in Figs. 4, 24 to 36, 59, 61 to 70, 79 and 80, a plurality of first power signal lines P1 are divided into a first power voltage signal line P11, a second power voltage signal line P12 and a third power voltage signal line P13, the first power voltage signal line P11 is connected to the first pixel circuit 101, the second power voltage signal line P12 is connected to the second pixel circuit 102, and the third power voltage signal line P13 is connected to the third pixel circuit 103, so as to separately set the first power signal lines P1 connecting sub-pixels of different colors.

The first power voltage signal line P11 is configured to transmit the first power voltage to the first pixel circuit 101, the second power voltage signal line P12 is configured to transmit the second power voltage to the second pixel circuit 102, and the third power voltage signal line P13 is configured to transmit the third power voltage to the third pixel circuit 103, and at least two of the first power voltage, the second power voltage and the third power voltage are different, so that the voltage amplitude of the positive power voltage PVDD received by the sub-pixels of different colors can be independently set according to the difference in the requirement on the voltage across the light-emitting element 20 in the sub-pixels of different colors, so that the positive power voltage PVDD received by the sub-pixels of different colors is closer to the requirement on the voltages across their light-emitting elements 20, thereby reducing the voltage margin of the positive power voltage PVDD and reducing the power consumption of the display panel.

Continue referring to Figs. 24 to 36, 61 to 70, 79 and 80, in an embodiment, the light-emitting element 20 comprises a red light-emitting element 20R, a blue light-emitting element 20B and a green light-emitting element 20G. The first pixel circuit 101 is connected to the red light-emitting element 20R, the second pixel circuit 102 is connected to the blue light-emitting element 20B, and the third pixel circuit 103 is connected to the green light-emitting element 20G.

The second power voltage VB is greater than the third power voltage VG, and the third power voltage VG is greater than or equal to the first power voltage VR.

Or, the second power voltage VB is greater than the first power voltage VR, and the first power voltage VR is greater than or equal to the third power voltage VG.

As shown in Figs. 24 to 36, Figs. 61 to 70, Fig. 79 and Fig. 80, the light-emitting element 20 may comprise a red light-emitting element 20R that emits red light, a blue light-emitting element 20B that emits blue light and a green light-emitting element 20G that emits green light, so as to realize color display, which is not limited thereto. In some embodiments, the light-emitting element 20 may further comprise a white light-emitting element that emits white light, which are not specifically limited in the embodiments of the present disclosure.

In this embodiment, the first pixel circuit 101 is connected to the red light-emitting element 20R, and the first pixel circuit 101 and the red light-emitting element 20R constitute a red sub-pixel, and the positive power voltage PVDD of the red sub-pixel is provided by the first power voltage signal line P11, which is the first power voltage VR.

The second pixel circuit 102 is connected to the blue light-emitting element 20B, and the second pixel circuit 102 and the blue light-emitting element 20B constitute a blue sub-pixel. The positive power voltage PVDD of the blue sub-pixel is provided by the second power voltage signal line P12, which is the second power voltage VB.

The third pixel circuit 103 is connected to the green light-emitting element 20G, and the third pixel circuit 103 and the green light-emitting element 20G constitute a green sub-pixel. The positive power voltage PVDD of the green sub-pixel is provided by the third power voltage signal line P13, which is the third power voltage VG.

The inventors further discovered that due to the different materials of the light-emitting layer 112 in the red sub-pixel 20R, the blue light-emitting element 20B and the green light-emitting element 20G, there will be differences in the start-up voltages of the red sub-pixel 20R, the blue light-emitting element 20B and the green light-emitting element 20G, and the requirements on the voltages across the red sub-pixel 20R, the blue light-emitting element 20B and the green light-emitting element 20G are different.

In some embodiments, the required voltage across the blue light-emitting element 20B is the largest, the required voltage across the red sub-pixel 20R is the smallest, and the required voltage across the green light-emitting element 20G is between the required voltage across the blue light-emitting element 20B and the required voltage across the red sub-pixel 20R. In this situation, the second power voltage VB can be set to be greater than the third power voltage VG, and the third power voltage VG can be greater than or equal to the first power voltage VR, that is, VB>VG≥VR, ensuring that the voltages across the red sub-pixel 20R, the blue light-emitting element 20B and the green light-emitting element 20G required for the normal operation are met, and the voltage margin of the positive power voltage PVDD can be reduced, thereby reducing the power consumption of the display panel.

In other embodiments, the required voltage across the blue light-emitting element 20B is the largest, the required voltage across the green light-emitting element 20G is the smallest, and the required voltage across the red sub-pixel 20R is between the required voltage across the blue light-emitting element 20B and the required voltage across the green light-emitting element 20G. In this situation, the second power voltage VB can be set to be greater than the first power voltage VR, and the first power voltage VR can be greater than or equal to the third power voltage VG, that is, VB>VR≥VG, ensuring that the voltages across the red sub-pixel 20R, the blue light-emitting element 20B and the green light-emitting element 20G required for the normal operation are met, and the voltage margin of the positive power voltage PVDD can be reduced, thereby reducing the power consumption of the display panel.

It should be noted that the magnitude relationship of the second power voltage VB, the third power voltage VG and the first power voltage VR can be adjusted according to the actual display panel structure and requirements, which are not specifically limited thereto in the embodiments of the present disclosure.

Continue referring to Figs. 24 to 36, 61 to 70, 79 and 80, in an embodiment, the light-emitting element 20 comprises a red light-emitting element 20R, a blue light-emitting element 20B and a green light-emitting element 20G. The first pixel circuit 101 is connected to the red light-emitting element 20R, the second pixel circuit 102 is connected to the blue light-emitting element 20B, and the third pixel circuit 103 is connected to the green light-emitting element 20G.

The first power voltage signal line P11 and the third power voltage signal line P13 are the same signal line.

The configuration of the light-emitting element 20 and the corresponding pixel circuit 10 may be referred to the above embodiments, which will not be repeated here.

In some display panels, the difference between the required voltages across the red light-emitting element 20R and the green light-emitting element 20G may not be that great, and the red light-emitting element 20R and the green light-emitting element 20G may use the same positive power voltage PVDD.

Specifically, as shown in Figs. 24 to 36, Figs. 61 to 70, Figs. 79 and 80, the positive power voltage PVDD of the red sub-pixel is provided by the first power voltage signal line P11, which is the first power voltage VR; the positive power voltage PVDD of the green sub-pixel is provided by the third power voltage signal line P13, which is the third power voltage VG. The first power voltage VR and the third power voltage VG can be the same. In this situation, the first power voltage signal line P11 and the third power voltage signal line P13 can be set as the same signal line, so that the red sub-pixel and the green sub-pixel share the same first power supply signal line P1, and the number of the first power supply signal lines P1 can be reduced while reducing power consumption, which is beneficial to improving the light transmittance of the display panel.

In an embodiment, the second power voltage VB is greater than the first power voltage VR, and the first power voltage VR is equal to the third power voltage VG.

It is set that VB>VG=VR, ensuring that required voltages across the red sub-pixel 20R, the blue light-emitting element 20B and the green light-emitting element 20G for normal operation are met and the power consumption of the display panel is reduced, and the first power voltage VR and the third power voltage VG use the same positive power voltage PVDD, which can reduce the number of positive power voltages PVDD with different voltage values, thereby simplifying the design of the driving circuit and reducing costs.

Continue referring to Figs. 24 to 36, 61 to 70, 79 and 80, in an embodiment, the first power voltage signal lines P11 and the second power voltage signal lines P12 are alternately arranged along the second direction Y.

Specifically, as shown in Figs. 24 to 36, Figs. 61 to 70, Figs. 79 and 80, by arranging the first power voltage signal line P11 and the second power voltage signal line P12 alternately along the second direction Y, the first power voltage signal line P11 and the second power voltage signal line P12 can be evenly distributed in the second direction, thereby facilitating electrical connection between the first power voltage signal line P11 and the second power voltage signal line P12 and the corresponding pixel circuit 10, ensuring that the pixel circuit 10 corresponding to each color sub-pixel can receive the required positive power voltage PVDD.

Continue referring to Figs. 24 to 36, 61 to 70, 79 and 80, in an embodiment, the display panel provided in the embodiments of the present disclosure further comprises a plurality of third power signal lines P3 extending along the second direction Y and arranged along the first direction X, and the third power signal lines P3 and the first power signal lines P1 are located in different layers. The plurality of third power signal lines P3 comprise a first power connecting signal line P31 and a second power connecting signal line P32, the first power connecting signal line P31 is electrically connected to at least two first power voltage signal lines P11, and the second power connecting signal line P32 is electrically connected to at least two second power voltage signal lines P12.

Specifically, as shown in Figs. 24 to 36, 61 to 70, 79 and 80, the plurality of third power signal lines P3 and the plurality of first power signal lines P1 are located in different layers and are cross-arranged.

Further, the plurality of third power signal lines P3 are divided into first power connecting signal lines P31 and second power connecting signal lines P32.

The first power connecting signal line P31 and at least two first power voltage signal lines P11 are electrically connected, so that the first power connecting signal line P31 and the first power voltage signal line P11 form a grid wiring structure, which is beneficial to reducing line resistance, thereby reducing the voltage drop of the first power voltage and ensuring the stability of the first power voltage.

Similarly, the second power connecting signal line P32 is electrically connected to at least two second power voltage signal lines P12, so that the second power connecting signal line P32 and the second power voltage signal line P12 form a grid wiring structure, which is beneficial to reducing line resistance, thereby reducing the voltage drop of the second power voltage and ensuring the stability of the first power voltage.

Continue referring to Figs. 24 to 36, 61 to 70, 79 and 80, in an embodiment, the first power connecting signal lines P31 and the second power connecting signal lines P32 are alternately arranged along the first direction X.

Specifically, as shown in Figs. 24 to 36, 61 to 70, 79 and 80, by arranging the first power connecting signal line P31 and the second power connecting signal line P32 alternately along the first direction X, the first power connecting signal line P31 and the second power connecting signal line P32 can be evenly distributed in the first direction X, thereby facilitating electrically connecting the first power connecting signal line P31 and the second power connecting signal line P32 to the corresponding first power voltage signal line P11 and the second power voltage signal line P12. Meanwhile, when the first power voltage signal line P11 and the second power voltage signal line P12 are alternately arranged along the second direction Y, the first power connecting signal line P31 and the second power connecting signal line P32 are alternately arranged along the first direction X, so that the via connection positions between the first power supply signal line P1 and the third power supply signal line P3 can be evenly distributed, thereby improving the morphology uniformity of the display panel, and thus improving the overall visual effect of the display panel.

Continue referring to Figs. 24 to 36, 61 to 70, 79 and 80, in an embodiment, in the direction perpendicular to the plane where the display panel is located, the third power signal line P3 at least partially overlaps with the green light-emitting element 20G.

Since the human eyes are most sensitive to green, by setting the third power signal line P3 to at least partially overlap with the green light-emitting element 20G in the direction perpendicular to the plane where the display panel is located, the larger line width of the third power signal line P3 can be used to improve the flatness of the anode 111 of the green light-emitting element 20G, and thus when the display panel is viewed at the same inclination angle in different directions, the brightness difference of the green light-emitting element 20G can be reduced, and the color deviation difference at the same inclination viewing angle in different directions can be reduced, thereby mitigating the color deviation at different viewing directions and improving the display effect of the display panel.

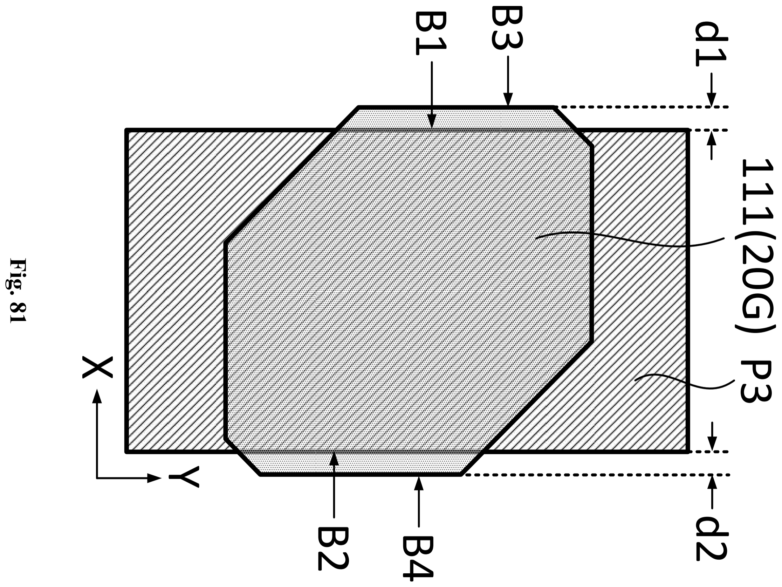

Fig. 81 is a schematic diagram of an overlapping relationship between a third power signal line and a green light-emitting element provided by an embodiment of the present disclosure. As shown in Fig. 81, in an embodiment, in the first direction X, the third power signal line P3 comprises a first boundary B1 and a second boundary B2 opposite to each other, and in the first direction X, the green light-emitting element 20G comprises a third boundary B3 and a fourth boundary B4 opposite to each other. Along the first direction X, the first boundary B1 and the second boundary B2 are both located between the third boundary B3 and the fourth boundary B4, and the first boundary B1 is located between the second boundary B2 and the third boundary B3. Along the first direction X, the distance between the first boundary B1 and the third boundary B3 is d1, and the distance between the second boundary B2 and the fourth boundary B4 is d2, where d1=d2.

Specifically, as shown in Fig. 81, when the line width of the third power signal line P3 is smaller than the length of the green light-emitting element 20G in the first direction X, the first boundary B1 and the second boundary B2 of the third power signal line P3 can be located between the third boundary B3 and the fourth boundary B4 of the green light-emitting element 20G; and in the first direction X, the distance d1 between the first boundary B1 and the third boundary B3 is equal to the distance d2 between the second boundary B2 and the fourth boundary B4. In this way, the central axis of the third power signal line P3 extending in the first direction X can be aligned with the central axis of the green light-emitting element 20G extending in the first direction X along the direction perpendicular to the plane where the display panel is located, thereby improving the positional symmetry of the third power signal line P3 and the green light-emitting element 20G, further reducing the color deviation difference at the same inclination viewing angle in different directions, alleviating the color deviation from different viewing directions, and making the color performance of the display panel at different angles more consistent.

It should be noted that in Fig. 81, the boundary of the anode 111 of the green light-emitting element 20G is used as the boundary of the green light-emitting element 20G, but it is not limited to this. In other embodiments, the boundary of the light-emitting area of the green light-emitting element 20G can also be used as the boundary of the green light-emitting element 20G, which are not specifically limited in the embodiments of the present disclosure.

Continue referring to Fig. 79, in an embodiment, in the direction perpendicular to the plane where the display panel is located, the third power signal line P3 covers the green light-emitting element 20G.

In the direction perpendicular to the plane where the display panel is located, by setting the third power signal line P3 to cover the green light-emitting element 20G, the flatness of the anode 111 of the green light-emitting element 20G can be further improved, thereby further alleviating the problem of inconsistent color deviation in different directions and improving the display effect of the display panel.

Continue referring to Fig. 24 to 36, 61 to 70, 79 and 80, in an embodiment, the light-emitting element 20 comprises a red light-emitting element 20R, a blue light-emitting element 20B and a green light-emitting element 20G. In the direction perpendicular to the plane where the display panel is located, the first power signal line P1 at least partially overlaps with the green light-emitting element 20G.

Since the human eyes are most sensitive to green, by setting the first power signal line P1 to at least partially overlap with the green light-emitting element 20G in the direction perpendicular to the plane where the display panel is located, the larger line width of the first power signal line P1 can be used to improve the flatness of the anode 111 of the green light-emitting element 20G, and thus when the display panel is viewed at the same inclination angle in different directions, the brightness difference of the green light-emitting element 20G can be reduced, and the color deviation difference at the same inclination viewing angle in different directions can be reduced, thereby mitigating the color deviation at different viewing directions and improving the display effect of the display panel.

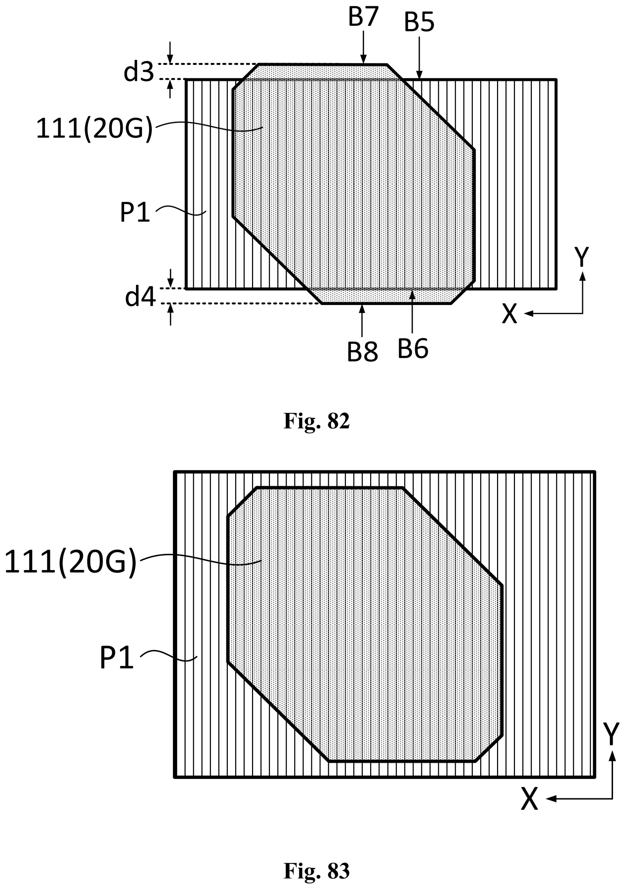

Fig. 82 is a schematic diagram of an overlapping relationship between a first power signal line and a green light-emitting element provided by an embodiment of the present disclosure. As shown in Fig. 82, in an embodiment, in the second direction Y, the first power signal line P1 comprises a fifth boundary B5 and a sixth boundary B6 opposite to each other. In the second direction Y, the green light-emitting element 20G comprises a seventh boundary B7 and an eighth boundary B8 opposite to each other. Along the second direction Y, the fifth boundary B5 and the sixth boundary B6 are both located between the seventh boundary B7 and the eighth boundary B8, and the fifth boundary B5 is located between the sixth boundary B6 and the seventh boundary B7. Along the second direction Y, the distance between the fifth boundary B5 and the seventh boundary B7 is d3, and the distance between the sixth boundary B6 and the eighth boundary B8 is d4, where d3=d4.

Specifically, as shown in Fig. 82, when the line width of the first power signal line P1 is smaller than the length of the green light-emitting element 20G in the second direction Y, the fifth boundary B5 and the sixth boundary B6 of the first power signal line P1 can be located between the seventh boundary B7 and the eighth boundary B8 of the green light-emitting element 20G, and in the second direction Y, the distance d3 between the fifth boundary B5 and the seventh boundary B7 is equal to the distance d4 between the sixth boundary B6 and the eighth boundary B8. In this way, along the direction perpendicular to the plane where the display panel is located, the central axis of the first power signal line P1 extending in the second direction Y can be aligned with the central axis of the green light-emitting element 20G extending in the second direction Y, thereby improving the positional symmetry of the first power signal line P1 and the green light-emitting element 20G, further reducing the color deviation difference under the same inclination viewing angle in different directions, mitigating the color deviation at different viewing directions, and making the color performance of the display panel at different angles more consistent.

It should be noted that in Fig. 82, the boundary of the anode 111 of the green light-emitting element 20G is used as the boundary of the green light-emitting element 20G, but it is not limited to this. In other embodiments, the boundary of the light-emitting area of the green light-emitting element 20G can also be used as the boundary of the green light-emitting element 20G, which are not specifically limited in the embodiments of the present disclosure.

Fig. 83 is a schematic diagram of an overlapping relationship between the first power signal line and the green light-emitting element provided in another embodiment of the present disclosure. As shown in Fig. 83, in an embodiment, the light-emitting element 20 comprises a red light-emitting element 20R, a blue light-emitting element 20B and a green light-emitting element 20G. In the direction perpendicular to the plane where the display panel is located, the first power signal line P1 covers the green light-emitting element 20G.

In the direction perpendicular to the plane where the display panel is located, by setting the first power signal line P1 to cover the green light-emitting element 20G, the flatness of the anode 111 of the green light-emitting element 20G can be further improved, thereby further alleviating the problem of inconsistent color deviation in different directions and improving the display effect of the display panel.

It should be noted that, in Figs. 24 to 36, Figs. 61 to 70, Figs. 79 and 80, the first direction X is the row direction and the second direction Y is the column direction for illustration, but it is not limited to this, which are not specifically limited in the embodiments of the present disclosure.

Continue referring to Figs. 33 and 68, in an embodiment, a plurality of red light-emitting elements 20R and blue light-emitting elements 20B constitute a first virtual quadrilateral Z1, the red light-emitting element 20R is at the first vertex of the first virtual quadrilateral Z1, the blue light-emitting element 20B is at the second vertex of the first virtual quadrilateral Z1, the first vertex and the second vertex are alternated and spaced apart, and the green light-emitting element 20G is inside the first virtual quadrilateral Z1; a plurality of green light-emitting elements 20G constitute a second virtual quadrilateral Z2, the plurality of green light-emitting elements 20G are respectively at the vertices of the second virtual quadrilateral Z2, and the red light-emitting element 20R or the blue light-emitting element 20B is inside the second virtual quadrilateral Z2.

Specifically, as shown in Figs. 33 and 68, a plurality of red light-emitting elements 20R and blue light-emitting elements 20B form a first virtual quadrilateral Z1, two red light-emitting elements 20R are located at opposite corners of the first virtual quadrilateral Z1, and two blue light-emitting elements 20B are located at the other two opposite corners of the first virtual quadrilateral Z1. In addition, the green light-emitting element 20G is disposed inside the first virtual quadrilateral Z1.

The plurality of green light-emitting elements 20G may further form a second virtual quadrilateral Z2. In the second virtual quadrilateral Z2, the red light-emitting element 20R may be located in the second virtual quadrilateral Z2, or the blue light-emitting element 20B may be located in the second virtual quadrilateral Z2.

By arranging the light-emitting elements as described above, it is possible to ensure a better rendering effect of the light-emitting elements, make the image edge clearer, and reduce the jaggedness, thereby further ensuring the color display effect of the display panel.

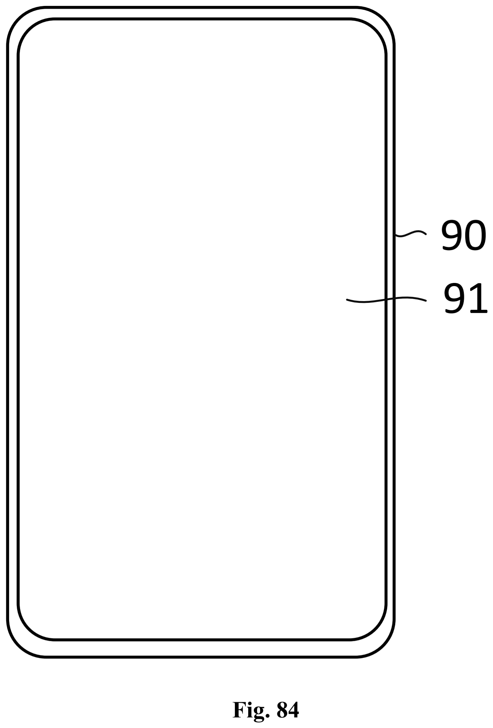

Based on the same inventive concept, embodiments of the present disclosure further provide a display device. Fig. 84 is a schematic structural diagram of a display device provided by an embodiment of the present disclosure. As shown in Fig. 84, the display device 90 comprises a display panel 91 described in any of the embodiments of the present disclosure. Therefore, the display device 90 provided by the embodiments of the present disclosure has the technical effect of the technical solution in any of the above embodiments. The structures that are the same or corresponding to the above embodiments and the explanation of terms are not repeated here.

The display device 90 provided in the embodiments of the present disclosure can be the mobile phone shown in Fig. 84, or it can be any electronic product with a display function, comprising but not limited to the following categories: televisions, laptops, desktop displays, tablet computers, digital cameras, smart bracelets, smart glasses, car displays, medical equipment, industrial control equipment, touch interactive terminals, etc., which are not specifically limited in the embodiments of the present disclosure.

It should be understood that the various forms of processes shown above can be configured to reorder, add or delete steps. For example, the steps described in the present disclosure can be executed in parallel, sequentially or in different orders, as long as the desired results of the technical solution of the present disclosure can be achieved, which is not limited thereto.

The above specific implementations do not constitute a limitation on the protection scope of the present disclosure. It should be understood by those skilled in the art that various modifications, combinations, sub-combinations and substitutions can be made according to design requirements and other factors. Any modification, equivalent substitution and improvement made within the spirit and principle of the present disclosure should be comprised in the protection scope of the present disclosure.

**Claims**

1. A display panel, comprising a display region, wherein the display region comprises a plurality of pixel circuits arranged in an array, the plurality of pixel circuits comprising a first pixel circuit, a second pixel circuit and a third pixel circuit;

   the first pixel circuit, the second pixel circuit and the third pixel circuit being respectively connected to light-emitting elements of different colors;
   the display panel further comprising a plurality of data signal lines, the plurality of data signal lines comprising a first data signal line, a second data signal line and a third data signal line;
   the first data signal line being electrically connected to the first pixel circuit, the second data signal line being electrically connected to the second pixel circuit, and the third data signal line being electrically connected to the third pixel circuit.

2. The display panel according to claim 1, wherein the plurality of pixel circuits form a plurality of first pixel circuit columns, the first pixel circuit column comprising the first pixel circuits and the second pixel circuits alternately arranged along a column direction;

   the plurality of pixel circuits form a plurality of second pixel circuit columns, the second pixel circuit column comprising the third pixel circuits arranged along the column direction;
   the first pixel circuit columns and the second pixel circuit columns are alternately arranged along a row direction;
   a plurality of the data signal lines extend along the column direction and are arranged along the row direction;
   the first data signal line is electrically connected to the first pixel circuits in a same first pixel circuit column, the second data signal line is electrically connected to the second pixel circuits in a same first pixel circuit column, and the third data signal line is electrically connected to the third pixel circuits in a same second pixel circuit column.

3. The display panel according to claim 2, wherein the plurality of first pixel circuit columns are divided into a plurality of first pixel circuit column groups, the first pixel circuit column group comprising two first pixel circuit columns which are respectively a first intra-group pixel circuit column and a second intra-group pixel circuit column;

   the first data signal line connected to the first pixel circuits in the first intra-group pixel circuit column is a first intra-group data signal line; the second data signal line connected to the second pixel circuits in the first intra-group pixel circuit column is a second intra-group data signal line; the first data signal line connected to the first pixel circuits in the second intra-group pixel circuit column is a third intra-group data signal line; the second data signal line connected to the second pixel circuits in the second intra-group pixel circuit column is a fourth intra-group data signal line;
   in the first pixel circuit column group, the first intra-group data signal line is electrically connected to the third intra-group data signal line, and the second intra-group data signal line is electrically connected to the fourth intra-group data signal line;
   the first pixel circuit connected to the first intra-group data signal line is located in different pixel circuit rows from the first pixel circuit connected to the third intra-group data signal line, and the second pixel circuit connected to the second intra-group data signal line is located in different pixel circuit rows from the second pixel circuit connected to the fourth intra-group data signal line.

4. The display panel according to claim 3, wherein the first pixel circuits and the second pixel circuits are arranged alternately at intervals along the row direction; the first pixel circuit column group comprises two adjacent first pixel circuit columns.

5. The display panel according to claim 3, further comprising a non-display region located at least on one side of the display region; wherein

in the first pixel circuit column group, the first intra-group data signal line is electrically connected to the third intra-group data signal line via a first data connecting line; the second intra-group data signal line is electrically connected to the fourth intra-group data signal line via a second data connecting line; and the first data connecting line and the second data connecting line are both located in the non-display region.

6. The display panel according to claim 3, wherein in the first pixel circuit column group, the first intra-group data signal line is electrically connected to the third intra-group data signal line via a first data connecting line; the second intra-group data signal line is electrically connected to the fourth intra-group data signal line via a second data connecting line; and the first data connecting line and the second data connecting line are both located in the display region.

7. The display panel according to claim 3, further comprising a plurality of data signal output lines and a plurality of gating circuits; wherein

the data signal output lines comprise a first data signal output line and a second data signal output line; the gating circuits comprise a first gating circuit and a second gating circuit; in the first pixel circuit column group, the first intra-group data signal line and the third intra-group data signal line are electrically connected to a same first data signal output line via the first gating circuit, the first gating circuit being configured to transmit a data signal output by the first data signal output line to the first intra-group data signal line and the third intra-group data signal line in a time-division manner; in the first pixel circuit column group, the second intra-group data signal line and the fourth intra-group data signal line are electrically connected to a same second data signal output line via the second gating circuit, the second gating circuit is configured to transmit a data signal output by the second data signal output line to the second intra-group data signal line and the fourth intra-group data signal line in a time-division manner.

8. The display panel according to claim 7, wherein the first gating circuit comprises a first switching transistor and a second switching transistor, the first switching transistor being connected between the first intra-group data signal line and the first data signal output line, and the second switching transistor being connected between the third intra-group data signal line and the first data signal output line;

the second gating circuit comprises a third switching transistor and a fourth switching transistor, the third switching transistor being connected between the second intra-group data signal line and the second data signal output line, and the fourth switching transistor being connected between the fourth intra-group data signal line and the second data signal output line; and a gate of the first switching transistor and a gate of the fourth switching transistor are configured to receive a first switching signal; a gate of the second switching transistor and a gate of the third switching transistor are configured to receive a second switching signal.

9. The display panel according to claim 2, wherein the plurality of first pixel circuit columns are divided into a plurality of first pixel circuit column groups, the first pixel circuit column group comprising two adjacent first pixel circuit columns which are respectively a first intra-group pixel circuit column and a second intra-group pixel circuit column;

the first data signal line connected to the first pixel circuits in the first intra-group pixel circuit column is a first intra-group data signal line; the second data signal line connected to the second pixel circuits in the first intra-group pixel circuit column is a second intra-group data signal line; the first data signal line connected to the first pixel circuits in the second intra-group pixel circuit column is a third intra-group data signal line; the first data signal line connected to the second pixel circuits in the second intra-group pixel circuit column is a fourth intra-group data signal line; in the row direction, the first intra-group data signal line and the second intra-group data signal line are located on different sides of the first intra-group pixel circuit column, and the third intra-group data signal line and the fourth intra-group data signal line are located on different sides of the second intra-group pixel circuit column.

10. The display panel according to claim 2, wherein the plurality of first pixel circuit columns are divided into a plurality of first pixel circuit column groups, the first pixel circuit column group comprising two first pixel circuit columns which are respectively a first intra-group pixel circuit column and a second intra-group pixel circuit column;

the first data signal line connected to the first pixel circuits in the first intra-group pixel circuit column is a first intra-group data signal line; the second data signal line connected to the second pixel circuits in the first intra-group pixel circuit column is a second intra-group data signal line; the first data signal line connected to the first pixel circuits in the second intra-group pixel circuit column is a third intra-group data signal line; the second data signal line connected to the second pixel circuits in the second intra-group pixel circuit column is a fourth intra-group data signal line;
in the first pixel circuit column group, the second intra-group data signal line and the fourth intra-group data signal line are located between the first intra-group data signal line and the third intra-group data signal line.

11. The display panel according to claim 10, further comprising a non-display region located at least on one side of the display region;

in the first pixel circuit column group, the first intra-group data signal line is electrically connected to the third intra-group data signal line via a first data connecting line; the second intra-group data signal line is electrically connected to the fourth intra-group data signal line via a second data connecting line;
the first data connecting line and the second data connecting line are both located in the non-display region; and the second data connecting line is located on a side of the first data connecting line close to the display region.

12. The display panel according to claim 11, further comprising a plurality of data signal output lines; wherein

the data signal output lines comprise a first data signal output line and a second data signal output line;
in the first pixel circuit column group, the first data connecting line is electrically connected to the first data signal output line, and the second data connecting line is electrically connected to the second data signal output line; and the first data connecting line and the second data signal output line are located in different layers.

13. The display panel according to claim 2, wherein the plurality of first pixel circuit columns are divided into a plurality of first pixel circuit column groups, the first pixel circuit column group comprising two first pixel circuit columns which are respectively a first intra-group pixel circuit column and a second intra-group pixel circuit column;

the first data signal line connected to the first pixel circuits in the first intra-group pixel circuit column is a first intra-group data signal line; the second data signal line connected to the second pixel circuits in the first intra-group pixel circuit column is a second intra-group data signal line; the first data signal line connected to the first pixel circuits in the second intra-group pixel circuit column is a third intra-group data signal line; the second data signal line connected to the second pixel circuits in the second intra-group pixel circuit column is a fourth intra-group data signal line;
in the first pixel circuit column group, the first intra-group data signal lines, the second intra-group data signal lines, the third intra-group data signal lines and the fourth intra-group data signal lines are sequentially arranged along the row direction.

14. The display panel according to claim 13, further comprising a non-display region located at least on one side of the display region; wherein

in the first pixel circuit column group, the first intra-group data signal line is electrically connected to the third intra-group data signal line via a first data connecting line; the second intra-group data signal line is electrically connected to the fourth intra-group data signal line via a second data connecting line;
the first data connecting line and the second data connecting line are both located in the non-display region;
the second data connecting line is located on a side of the first data connecting line close to the display region, and the second data connecting line and the third intra-group data signal line are located in different layers;
or the first data connecting line is located on a side of the second data connecting line close to the display region, and the first data connecting line and the second group of data signal lines are located in different layers.

15. The display panel according to claim 3, wherein in the first pixel circuit column group, the first intra-group data signal line is electrically connected to the third intra-group data signal line via a first data connecting line; the second intra-group data signal line is electrically connected to the fourth intra-group data signal line via a second data connecting line;

the first data connecting line and the second data connecting line are located in a same layer, or the first data connecting line and the second data connecting line are located in different layers.

16. The display panel according to claim 2, wherein the third data signal line comprises a first sub-data signal line and a second sub-data signal line;

in the row direction, the first sub-data signal line and the second sub-data signal line are located on different sides of the second pixel circuit column.

17. The display panel according to claim 2, wherein the third data signal line comprises a first sub-data signal line and a second sub-data signal line;

the first sub-data signal line is electrically connected to the third pixel circuits of odd-numbered rows in the second pixel circuit column; and
the second sub data signal line is electrically connected to the third pixel circuits of even-numbered rows in the second pixel circuit column.

18. The display panel according to claim 2, wherein the third data signal line comprises a first sub-data signal line and a second sub-data signal line;

the first sub-data signal line is electrically connected to all of the third pixel circuits in the second pixel circuit column; and
the second sub data signal line is electrically connected to all of the third pixel circuits in the second pixel circuit column.

19. The display panel according to claim 17 or 18, wherein the first sub-data signal line and the second sub-data signal line connected to a same second pixel circuit column are electrically connected to each other.

20. The display panel according to claim 19, further comprising a non-display region located at least on one side of the display region; wherein

the first sub-data signal line and the second sub-data signal line connected to the same second pixel circuit column are electrically connected to each other via a third data connecting line;
the third data connecting line is located in the non-display region.

21. The display panel according to claim 19, wherein the first sub-data signal line and the second sub-data signal line connected to the same second pixel circuit column are electrically connected to each other via a third data connecting line;
the third data connecting line is located in the display region.

22. The display panel according to claim 20, wherein the plurality of first pixel circuit columns are divided into a plurality of first pixel circuit column groups, the first pixel circuit column group comprises two first pixel circuit columns which are respectively a first intra-group pixel circuit column and a second intra-group pixel circuit column;

the first data signal line connected to the first pixel circuits in the first intra-group pixel circuit column is a first intra-group data signal line; the second data signal line connected to the second pixel circuits in the first intra-group pixel circuit column is a second intra-group data signal line; the first data signal line connected to the first pixel circuits in the second intra-group pixel circuit column is a third intra-group data signal line; the second data signal line connected to the second pixel circuits in the second intra-group pixel circuit column is a fourth intra-group data signal line;
in the first pixel circuit column group, the first intra-group data signal line is electrically connected to the third intra-group data signal line via a first data connecting line; the second intra-group data signal line is electrically connected to the fourth intra-group data signal line via a second data connecting line;
the first data connecting line and the second data connecting line are both located in the non-display region; and
the third data connecting line is located on a side of the first data connecting line close to the display region, and the second data connecting line is located between the third data connecting line and the first data connecting line.

23. The display panel according to claim 22, further comprising a plurality of data signal output lines; wherein

the data signal output lines comprise a first data signal output line, a second data signal output line and a third data signal output line;

in the first pixel circuit column group, the first data connecting line is electrically connected to the first data signal output line, and the second data connecting line is electrically connected to the second data signal output line; the third data connecting line is electrically connected to the third data signal output line; and

the third data signal output line and the first data connecting line are located in different layers, and the third data signal output line and the second data connecting line are located in different layers.

24. The display panel according to claim 16, further comprising a plurality of data signal output lines and a plurality of gating circuits; wherein

the data signal output lines comprise a third data signal output line;

the gating circuits comprise a third gating circuit;

in the first sub-data signal line and the second sub-data signal line connected to the same second pixel circuit column, the first sub-data signal line and the second sub-data signal line are electrically connected to a same third data signal output line via the third gating circuit, the third gating circuit being configured to transmit a data signal output by the third data signal output line to the first sub-data signal line and the second sub-data signal line in a time-division manner.

25. The display panel according to claim 24, wherein the third gating circuit comprises a fifth switching transistor and a sixth switching transistor, the fifth switching transistor being connected between the first sub-data signal line and the third data signal output line, and the sixth switching transistor being connected between the second sub-data signal line and the third data signal output line; and

a gate of the fifth switching transistor is configured to receive a third switching signal; and a gate of the sixth switching transistor is configured to receive a fourth switching signal.

26. The display panel according to claim 2, wherein the third pixel circuits in one of the second pixel circuit columns are electrically connected to only one third data signal line.

27. The display panel according to claim 26, wherein the plurality of second pixel circuit columns are divided into a plurality of second pixel circuit column groups, the second pixel circuit column group comprising two adjacent second pixel circuit columns which are respectively a third intra-group pixel circuit column and a fourth intra-group pixel circuit column;

the third data signal line connected to the third intra-group pixel circuit column is a fifth intra-group data signal line; the third data signal line connected to the fourth intra-group pixel circuit column is a sixth intra-group data signal line;

in the second pixel circuit column group, the fifth intra-group data signal line is located on a side of the third intra-group pixel circuit column away from the fourth intra-group pixel circuit column, and the sixth intra-group data signal line is located on a side of the fourth intra-group pixel circuit column away from the third intra-group pixel circuit column;

or

in the second pixel circuit column group, the fifth intra-group data signal line is located on the side of the third intra-group pixel circuit column close to the fourth intra-group pixel circuit column, and the sixth intra-group data signal line is located on the side of the fourth intra-group pixel circuit column close to the third intra-group pixel circuit column.

28. The display panel according to claim 26, wherein the plurality of second pixel circuit columns are divided into a plurality of second pixel circuit column groups, the second pixel circuit column group comprising two adjacent second pixel circuit columns which are respectively a third intra-group pixel circuit column and a fourth intra-group pixel circuit column;

the third data signal line connected to the third intra-group pixel circuit column is a fifth intra-group data signal line; the third data signal line connected to the fourth intra-group pixel circuit column is a sixth intra-group data signal line;

in the second pixel circuit column group, the fifth intra-group data signal line is located on a side of the third intra-group pixel circuit column away from the fourth intra-group pixel circuit column, and the sixth intra-group data signal line is located on a side of the fourth intra-group pixel circuit column close to the third intra-group pixel circuit column;

or

in the second pixel circuit column group, the fifth intra-group data signal line is located on the side of the third intra-group pixel circuit column close to the fourth intra-group pixel circuit column, and the sixth intra-group data signal line is located on the side of the fourth intra-group pixel circuit column away from the third intra-group pixel circuit column.

29. The display panel according to claim 2, wherein in a direction perpendicular to a plane where the display panel is located, the first data signal line and the second data signal line both overlap with the first pixel circuit column, and the third data signal line overlaps with the second pixel circuit column.

30. The display panel according to claim 2, wherein a plurality of the first pixel circuit columns and a plurality of the second pixel circuit columns are divided into a plurality of third pixel circuit column groups, the third pixel circuit column group comprising the first pixel circuit column and the second pixel circuit column that are adjacent to each other along the row direction, the first pixel circuit column and the second pixel circuit column that are adjacent to each other are arranged in a mirror-symmetrical pattern.

31. The display panel according to claim 30, wherein in the third pixel circuit column group, the first data signal line and the second data signal line connected to the first pixel circuit column and the third data signal line connected to the second pixel circuit column are both located between the first pixel circuit column and the second pixel circuit column.

32. The display panel according to claim 31, wherein in two adjacent third pixel circuit column groups, the first data signal lines and the second data signal lines in different third pixel circuit column groups are arranged in a same direction or in opposite directions.

33. The display panel according to claim 31, further comprising a plurality of third power signal lines extending along the column direction and arranged along the row direction; wherein

the plurality of third power signal lines comprise a first sub-power signal line, a second sub-power signal line and a third sub-power signal line that are arranged adjacent to each other sequentially along the row direction;

an arrangement direction of the first data signal line and the second data signal line between the first sub-power signal line and the second sub-power signal line is the same as or opposite to an arrangement direction of the first data signal line and the second data signal line between the second sub-power signal line and the third sub-power signal line.

34. The display panel according to claim 31, wherein the pixel circuit comprises a data writing transistor, an active layer of the data writing transistor comprising a first connecting end;

in the third pixel circuit column group, along the row direction, the first connecting end of the first pixel circuit is located on a side of the second data signal line close to the first data signal line, and the first data signal line is electrically connected to the first connecting end of the first pixel circuit;

in the third pixel circuit column group, along the row direction, the first connecting end of the second pixel circuit is located on a side of the first data signal line close to the second data signal line, and the second data signal line is electrically connected to the first connecting end of the second pixel circuit.

35. The display panel according to claim 31, wherein the display region comprises a first display region and a second display region;

along the row direction, the first display region is located at least on one side of the second display region; the display panel further comprising a plurality of auxiliary signal lines extending along the column direction and arranged along the row direction;

the auxiliary signal line is at least partially located in the second display region and electrically connected to the data signal line in the first display region;

in the third pixel circuit column group, the auxiliary signal line is located between the data signal line connected to the first pixel circuit column and the data signal line connected to the second pixel circuit column.

36. The display panel according to claim 35, wherein the number of the auxiliary signal lines correspondingly arranged in one of the third pixel circuit column groups is less than or equal to one.

37. The display panel according to claim 31, wherein the display region comprises a first display region and a second display region;

along the row direction, the first display region is located at least on one side of the second display region;
the display panel further comprising a plurality of auxiliary signal lines extending along the column direction and arranged along the row direction;
the auxiliary signal line is at least partially located in the second display region and electrically connected to the data signal line in the first display region;
the auxiliary signal line and the data signal line are located in different layers;
in a direction perpendicular to the plane where the display panel is located, the auxiliary signal line at least partially overlaps with the data signal line;
or in the direction perpendicular to the plane where the display panel is located, the auxiliary signal line does not overlap with the data signal line.

38. The display panel according to claim 37, wherein one of the first pixel circuit columns corresponds to one of the auxiliary signal lines, and one of the second pixel circuit columns corresponds to one of the auxiliary signal lines;

in the third pixel circuit column group, the auxiliary signal line corresponding to the first pixel circuit column is located between the first data signal line and the second data signal line corresponding to the first pixel circuit column, and the auxiliary signal line corresponding to the second pixel circuit column is located between two of the third data signal lines corresponding to the second pixel circuit column;
or, in the third pixel circuit column group, along the row direction, the auxiliary signal line corresponding to the first pixel circuit column is located on the same side of the first data signal line and the second data signal line corresponding to the first pixel circuit column, and the auxiliary signal line corresponding to the second pixel circuit column is located on the same side of two of the third data signal lines corresponding to the second pixel circuit column;
or, in a direction perpendicular to the plane of the display panel, the auxiliary signal line corresponding to the first pixel circuit column at least partially overlaps with the data signal line corresponding to the first pixel circuit column, and the auxiliary signal line corresponding to the second pixel circuit column at least partially overlaps with the data signal line corresponding to the second pixel circuit column.

39. The display panel according to claim 37, wherein the third pixel circuit column group corresponds to three of the auxiliary signal lines;
in the third pixel circuit column group, along the row direction, the three of the auxiliary signal lines are located between the first pixel circuit column and the second pixel circuit column, and the auxiliary signal line is located between two adjacent data signal lines.

40. The display panel according to claim 37, wherein one of the first pixel circuit columns corresponds to two of the auxiliary signal lines, and one of the second pixel circuit columns corresponds to two of the auxiliary signal lines;
in a direction perpendicular to the plane where the display panel is located, the auxiliary signal line at least partially overlap with the data signal line.

41. The display panel according to claim 35, wherein in the third pixel circuit column group, the first data signal line connected to the first pixel circuit column is located on a side of the second data signal line connected to the first pixel circuit column away from the first pixel circuit column, and a distance between the auxiliary signal line and the second data signal line is greater than a distance between the auxiliary signal line and the third data signal line;
or, in the third pixel circuit column group, the second data signal line connected to the first pixel circuit column is located on a side of the first data signal line connected to the first pixel circuit column away from the first pixel circuit column, and a distance between the auxiliary signal line and the first data signal line is greater than a distance between the auxiliary signal line and the third data signal line.

42. The display panel according to claim 35, wherein in the third pixel circuit column group, the number of the data signal lines connected to the first pixel circuit column is greater than the number of the data signal lines connected to the second pixel circuit column.

43. The display panel according to claim 30, wherein the display region comprises a first display region and a second display region;

along the row direction, the first display region is located at least on one side of the second display region;
the display panel further comprising a plurality of auxiliary signal lines extending along the column direction and arranged along the row direction;
the auxiliary signal line is at least partially located in the second display region and electrically connected to the data signal line in the first display region;
in the third pixel circuit column group, along the row direction, the numbers of the data signal lines on two sides of the auxiliary signal line are different.

44. The display panel according to claim 1, wherein the plurality of data signal lines are located in a same layer.

45. The display panel according to claim 1, wherein at least two of the data signal lines are located in different layers;
in a direction perpendicular to the plane where the display panel is located, the data signal lines located in different layers at least partially overlap with each other.

46. The display panel according to claim 1 or 2, wherein the light-emitting elements comprise a red light-emitting element, a blue light-emitting element and a green light-emitting element;

the first pixel circuit is connected to the red light-emitting element;
the second pixel circuit is connected to the blue light-emitting element; and
the third pixel circuit is connected to the green light-emitting element.

47. The display panel according to claim 1, further comprising a plurality of first power signal lines extending along a first direction and arranged along a second direction intersecting with the first direction; wherein

the plurality of first power signal lines comprise a first power voltage signal line, a second power voltage signal line and a third power voltage signal line;
the first power voltage signal line is connected to the first pixel circuit, the second power voltage signal line is connected to the second pixel circuit, and the third power voltage signal line is connected to the third pixel circuit;
the first power voltage signal line is configured to transmit a first power voltage, the second power voltage signal line is configured to transmit a second power voltage, and the third power voltage signal line is configured to transmit a third power voltage;
at least two of the first power voltage, the second power voltage, and the third power voltage are different.

48. The display panel according to claim 47, wherein the light-emitting elements comprise a red light-emitting element, a blue light-emitting element and a green light-emitting element;

the first pixel circuit is connected to the red light-emitting element, the second pixel circuit is connected to the blue light-emitting element, and the third pixel circuit is connected to the green light-emitting element;
the second power voltage is greater than the third power voltage, and the third power voltage is greater than or equal to the first power voltage;
or, the second power voltage is greater than the first power voltage, and the first power voltage is greater than or equal to the third power voltage.

49. The display panel according to claim 47, wherein the light-emitting elements comprise a red light-emitting element, a blue light-emitting element and a green light-emitting element;

the first pixel circuit is connected to the red light-emitting element, the second pixel circuit is connected to the blue light-emitting element, and the third pixel circuit is connected to the green light-emitting element;
the first power voltage signal line and the third power voltage signal line are a same signal line.

50. The display panel according to claim 49, wherein the second power voltage is greater than the first power voltage, and the first power voltage is equal to the third power voltage.

51. The display panel according to claim 49, wherein the first power voltage signal lines and the second power voltage signal lines are alternately arranged along the second direction.

52. The display panel according to claim 49, further comprising a plurality of third power signal lines extending along the second direction and arranged along the first direction;

   wherein the third power signal line and the first power signal line are located in different layers;
   the plurality of third power signal lines comprise a first power connecting signal line and a second power connecting signal line;
   the first power connecting signal line is electrically connected to at least two of the first power voltage signal lines, and the second power connecting signal line is electrically connected to at least two of the second power voltage signal lines.

53. The display panel according to claim 52, wherein the first power connecting signal lines and the second power connecting signal lines are alternately arranged along the first direction.

54. The display panel according to claim 52, wherein in a direction perpendicular to the plane where the display panel is located, the third power signal line at least partially overlaps with the green light-emitting element.

55. The display panel according to claim 54, wherein in the first direction, the third power signal line comprises a first boundary and a second boundary opposite to each other;

   in the first direction, the green light-emitting element comprises a third boundary and a fourth boundary opposite to each other;
   along the first direction, the first boundary and the second boundary are both located between the third boundary and the fourth boundary, and the first boundary is located between the second boundary and the third boundary; and
   along the first direction, a distance between the first boundary and the third boundary is d1, a distance between the second boundary and the fourth boundary is d2, where d1=d2.

56. The display panel according to claim 54, wherein in a direction perpendicular to the plane where the display panel is located, the third power signal line covers the green light-emitting element.

57. The display panel according to claim 47, wherein the light-emitting elements comprise a red light-emitting element, a blue light-emitting element and a green light-emitting element;
   in a direction perpendicular to the plane where the display panel is located, the first power signal line at least partially overlaps with the green light-emitting element.

58. The display panel according to claim 57, wherein in the second direction, the first power signal line comprises a fifth boundary and a sixth boundary opposite to each other;

   in the second direction, the green light-emitting element comprises a seventh boundary and an eighth boundary that are opposite to each other;
   along the second direction, the fifth boundary and the sixth boundary are both located between the seventh boundary and the eighth boundary, and the fifth boundary is located between the sixth boundary and the seventh boundary;
   along the second direction, a distance between the fifth boundary and the seventh boundary is d3, a distance between the sixth boundary and the eighth boundary is d4, where d3=d4.

59. The display panel according to claim 47, wherein the light-emitting elements comprise a red light-emitting element, a blue light-emitting element and a green light-emitting element;
   in a direction perpendicular to the plane where the display panel is located, the first power signal line covers the green light-emitting element.

60. The display panel according to claim 2, wherein the display region comprises a first display region and a second display region;

   along the row direction, the first display region is located at least on one side of the second display region;

the display panel further comprising a plurality of auxiliary signal lines extending along the column direction and arranged along the row direction;

the auxiliary signal line is at least partially located in the second display region and electrically connected to the data signal line in the first display region;

a plurality of the first pixel circuit columns and a plurality of the second pixel circuit columns are divided into a plurality of third pixel circuit column groups, the third pixel circuit column groups comprising the first pixel circuit columns and the second pixel circuit columns that are adjacent to each other along the row direction;

the third pixel circuit column group corresponds to one of the auxiliary signal lines, and the second pixel circuit column corresponds to one of the third data signal lines;

in the third pixel circuit column group, the first data signal line and the second data signal line connected to the first pixel circuit column are respectively located on different sides of the first pixel circuit column;

in at least one of the third pixel circuit column groups in the second display region, the auxiliary signal line and the third data signal line connected to the second pixel circuit column are respectively located on different sides of the second pixel circuit column.

61. The display panel according to claim 2, wherein in the row direction, the first data signal line connected to the first pixel circuit column and the second data signal line connected to the second pixel circuit column are respectively located on two opposite sides of the first pixel circuit column;

in the row direction, the two third data signal lines connected to the second pixel circuit column are respectively located on two opposite sides of the second pixel circuit column.

62. The display panel according to claim 61, wherein the display region comprises a first display region and a second display region;

along the row direction, the first display region is located on least on one side of the second display region;

the display panel further comprising a plurality of auxiliary signal lines extending along the column direction and arranged along the row direction;

the auxiliary signal line is at least partially located in the second display region and electrically connected to the data signal line in the first display region;

the auxiliary signal line and the data signal line are located in different layers;

or, the auxiliary signal line and the data signal line are located in a same layer.

63. The display panel according to claim 62, further comprising a plurality of third power signal lines extending along the column direction and arranged along the row direction; wherein

one of the first pixel circuit columns corresponds to one auxiliary signal line and one third power signal line, and the auxiliary signal line and the third power signal line are located between the first data signal line and the second data signal line connected to the first pixel circuit column;

one of the second pixel circuit columns corresponds to one auxiliary signal line and one third power signal line, and the auxiliary signal line and the third power signal line are located between two third data signal lines connected to the second pixel circuit column.

64. The display panel according to claim 62, wherein one of the first pixel circuit columns corresponds to one of the auxiliary signal lines, and one of the second pixel circuit columns corresponds to one of the auxiliary signal lines;

the auxiliary signal line is located between two of the data signal lines between the first pixel circuit column and the second pixel circuit column that are adjacent to each other.

65. The display panel according to claim 62, wherein a plurality of the first pixel circuit columns and a plurality of the second pixel circuit columns are divided into a plurality of third pixel circuit column groups, the third pixel circuit column group comprising the first pixel circuit column and the second pixel circuit column adjacent to each other along the row direction;

the third pixel circuit column group corresponds to three auxiliary signal lines; and

the auxiliary signal line is located between any two adjacent data signal lines.

66. The display panel according to claim 62, wherein one of the first pixel circuit columns corresponds to one or two of the auxiliary signal lines, and one of the second pixel circuit columns corresponds to one or two of the auxiliary signal lines; and

in a direction perpendicular to the plane where the display panel is located, the auxiliary signal line at least partially overlaps with the data signal line.

67. The display panel according to claim 2, wherein the display region comprises a first display region and a second display region;

along the row direction, the first display region is located at least on one side of the second display region;
the display panel further comprising a plurality of auxiliary signal lines extending along the column direction and arranged along the row direction;
the auxiliary signal line is at least partially located in the second display region and electrically connected to the data signal line in the first display region;
one of the first pixel circuit columns corresponds to at least two of the auxiliary signal lines, and one of the second pixel circuit columns corresponds to at least two of the auxiliary signal lines.

68. The display panel according to claim 67, wherein the number of the auxiliary signal lines corresponding to one of the first pixel circuit columns is less than or equal to 4, and the number of the auxiliary signal lines corresponding to one of the second pixel circuit columns is less than or equal to 4.

69. The display panel according to claim 61, further comprising a plurality of third power signal lines extending along the column direction and arranged along the row direction; wherein

one of the first pixel circuit columns corresponds to one of the third power signal lines, and one of the second pixel circuit columns corresponds to one of the third power signal lines; and
along the row direction, the third power signal line is located between two data signal lines between the first pixel circuit column and the second pixel circuit column that are adjacent to each other.

70. The display panel according to claim 69, wherein in a direction perpendicular to the plane of the display panel, the third power signal line and the data signal line are located in different layers, and the third power signal line at least partially overlaps with two data signal lines between the first pixel circuit column and the second pixel circuit column that are adjacent to each other.

71. The display panel according to claim 69, wherein the display region comprises a first display region and a second display region;

along the row direction, the first display region is located at least on one side of the second display region;
the display panel further comprising a plurality of auxiliary signal lines extending along the column direction and arranged along the row direction;
the auxiliary signal line is at least partially located in the second display region and electrically connected to the data signal line in the first display region;
the auxiliary signal line and the third power signal line are located in different layers; and
in a direction perpendicular to the plane where the display panel is located, the auxiliary signal line at least partially overlaps with the third power signal line.

72. The display panel according to claim 69, wherein the light-emitting elements comprise a red light-emitting element, a blue light-emitting element and a green light-emitting element;
in a direction perpendicular to the plane where the display panel is located, the red light-emitting element, the green light-emitting element and the blue light-emitting element each at least partially overlap with the third power signal line between the first pixel circuit column and the second pixel circuit column that are adjacent to each other.

73. The display panel according to claim 61, wherein the light-emitting elements comprise a red light-emitting element, a blue light-emitting element and a green light-emitting element;
in a direction perpendicular to the plane where the display panel is located, the red light-emitting element, the green light-emitting element and the blue light-emitting element each at least partially overlap with the data signal line between the first pixel circuit column and the second pixel circuit column that are adjacent to each other.

74. The display panel according to claim 1, wherein the pixel circuit further comprises a driving transistor, a threshold compensation transistor and a shielding layer, a gate of the driving transistor is connected to the threshold compensation transistor at a first node;

along a direction parallel to the plane where the display panel is located, at least a part of the shielding layer is located between the first node and the data signal line.

75. The display panel according to claim 74, wherein in a direction perpendicular to the plane where the display panel is located, the shielding layer is located between the active layer of the driving transistor and the data signal line, and the shielding layer at least partially overlaps with the data signal line.

76. The display panel according to claim 74, wherein a fixed voltage is applied to the shielding layer.

77. The display panel according to claim 76, further comprising a plurality of third power signal lines extending along the second direction and arranged along the first direction, the first direction intersecting with the second direction; wherein
the shielding layer is electrically connected to the third power signal line.

78. A display device comprising the display panel according to any one of claims 1-77.

R

B

S1    S2    S3    S4

**Fig. 1**

data

**Fig. 2**

**Fig. 3**

PVDD

DATA

EM

Cst

T1

T2

N2

SP

VREF1

T5

N1

T3

T4

N3

T8

DVH

S1N

SPX

T6

S2N

T7

VREF2

SPX

10
20

PVEE

**Fig. 4**

20  111  112  113

C2

10

C1

3

2

1   T

Cst

60

**Fig. 5**

data ————————————————

**Fig. 6**

**Fig. 7**

**Fig. 8**

**Fig. 9**

**Fig. 10**

**Fig. 11**

Fig. 12

**Fig. 13**

**Fig. 14**

**Fig. 15**

**Fig. 16**

**Fig. 17**

**Fig. 18**

**Fig. 19**

**Fig. 20**

**Fig. 21**

**Fig. 22**

**Fig. 23**

RE

70

SD3

70

SD2

70

SD1

70

MG

70

IGZO

70

MC

70

GAT

70

POLY

60

**Fig. 24**

**Fig. 25**

**Fig. 26**

**Fig. 27**

**Fig. 28**

**Fig. 29**

**Fig. 30**

**Fig. 31**

SD3

P11/P13/P1

P12/P1

P11/P13/P1

P12/P1

X

Y

**Fig. 32**

111(20G)

111(20R)

111(20B)

Z2

Z1

**Fig. 33**

**Fig. 34**

**Fig. 35**

**Fig. 36**

**Fig. 37**

**Fig. 38**

**Fig. 39**

**Fig. 40**

**Fig. 41**

**Fig. 42**

**Fig. 43**

**Fig. 44**

**Fig. 45**

**Fig. 46**

**Fig. 47**

**Fig. 48**

**Fig. 49**

**Fig. 50**

**Fig. 51**

**Fig. 52**

**Fig. 53**

**Fig. 54**

**Fig. 55**

**Fig. 56**

**Fig. 57**

**Fig. 58**

**Fig. 59**

**Fig. 60**

RE

70

SD3

70

SD2

70

SD1

70

MC

70

GAT

70

POLY

60

Fig. 61

**Fig. 62**

GAT

s1n

SP/S2N/SPX

2g/C1

em

**Fig. 63**

MC

vref2

vref1

80

C2

**Fig. 64**

**Fig. 65**

**Fig. 66**

P11/P13/P1

SD3

P12/P1

P11/P13/P1

P12/P1

Y

X

**Fig. 67**

RE

111(20R)

111(20G)

Z2

111(20B)

Z1

**Fig. 68**

**Fig. 69**

**Fig. 70**

**Fig. 71**

Fig. 72

**Fig. 73**

**Fig. 74**

**Fig. 75**

**Fig. 76**

**Fig. 77**

**Fig. 78**

P31/P3  P32/P3    P31/P3    P32/P3    P31/P3

P11/P13/P1

111(20G)

111(20R)

P12/P1

111(20B)

P11/P13/P1

P12/P1

Y

X

**Fig. 79**

**Fig. 80**

**Fig. 81**

B7    B5

d3

111(20G)

P1

Y

d4

X

B8  B6

**Fig. 82**

111(20G)

P1

Y

X

**Fig. 83**

**Fig. 84**

**TRANSLATION**

## INTERNATIONAL SEARCH REPORT

International application No.

**PCT/CN2024/120943**

| A. | CLASSIFICATION OF SUBJECT MATTER |
| --- | --- |

H10K59/12(2023.01)i

According to International Patent Classification (IPC) or to both national classification and IPC

| B. | FIELDS SEARCHED |
| --- | --- |

Minimum documentation searched (classification system followed by classification symbols)

IPC: G09G, H10K, H01L27, H01L51

Documentation searched other than minimum documentation to the extent that such documents are included in the fields searched

Electronic data base consulted during the international search (name of data base and, where practicable, search terms used)

CNTXT, ENTXT, ENTXTC, WPABS, DWPI, CNKI: 显示, 发光二极管, 像素, 子像素, 驱动, 信号, 数据, 频率, 辅助, 走线, display, OLED, pixel, sub, drive, signal, data, frequency, auxiliary, wiring

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 113823641 A (WUHAN TIANMA MICRO-ELECTRONICS CO., LTD. et al.) 21 December 2021 (2021-12-21) description, paragraphs 0055-0088, and figures 3-14 | 1-2, 9-14, 16-34, 44-59, 61, 69-77, 78 |
| Y | CN 113823641 A (WUHAN TIANMA MICRO-ELECTRONICS CO., LTD. et al.) 21 December 2021 (2021-12-21) description, paragraphs 0055-0088, and figures 3-14 | 3-8, 15, 35-43, 60, 62-68, 78 |
| Y | CN 116631338 A (WUHAN TIANMA MICRO-ELECTRONICS CO., LTD.) 22 August 2023 (2023-08-22) description, paragraphs 0024-0080, and figures 1-12 | 3-8, 15, 78 |
| Y | CN 118135921 A (GUANGDONG OPPO MOBILE TELECOMMUNICATIONS CORP., LTD.) 04 June 2024 (2024-06-04) description, paragraphs 0031-0085, and figures 1-14 | 35-43, 60, 62-68, 78 |
| A | JP 2004007471 A (SEIKO EPSON CORP.) 08 January 2004 (2004-01-08) entire document | 1-78 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **28 October 2024** | **26 December 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

TRANSLATION

**INTERNATIONAL SEARCH REPORT**
Information on patent family members

International application No.

**PCT/CN2024/120943**

| Patent document cited in search report | | | Publication date (day/month/year) | Patent family member(s) | | | Publication date (day/month/year) |
|---|---|---|---|---|---|---|---|
| CN | 113823641 | A | 21 December 2021 | CN | 113823641 | B | 29 March 2024 |
| CN | 116631338 | A | 22 August 2023 | US | 2024321222 | A1 | 26 September 2024 |
| CN | 118135921 | A | 04 June 2024 | | None | | |
| JP | 2004007471 | A | 08 January 2004 | JP | 3956875 | B2 | 08 August 2007 |

Form PCT/ISA/210 (patent family annex) (July 2022)

**EP 4 742 868 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202411259179